# EUROPEAN PATENT APPLICATION

(11) **EP 4 435 515 A1**
(43) Date of publication of application: **25.09.2024**
(21) Application number: 24160203.6
(22) Date of filing: 28.02.2024
(51) Int. Cl.: G03F 7/075

(54) **COMPOSITION FOR FORMING SILICON-CONTAINING RESIST UNDERLAYER FILM AND PATTERNING PROCESS**

(30) Priority: 07.03.2023 JP 2023034793
(71) Applicant: SHIN-ETSU CHEMICAL CO., LTD., Tokyo 1000005 (JP)
(72) Inventor: SATO, Takehiro, Niigata (JP); KIKUCHI, Shun, Niigata (JP); MITSUI, Ryo, Niigata (JP); TACHIBANA, Seiichiro, Niigata (JP)
(74) Representative: Sonnenhauser, Thomas Martin

(57) **Abstract**

The present invention is a composition for forming a silicon-containing resist underlayer film, containing a condensation reaction-type thermosetting silicon-containing material (Sx), being a polysiloxane resin, where the material has a non-condensation reactive organic group that reacts with a radical chemical species, the resin includes more than 0 and 70 mol% or less of one or more of a repeating unit represented by the following general formula (Sx-4) and a repeating unit represented by the general formula (Sx-5), and the organic group remains unreacted after a heat-curing reaction of the polysiloxane resin. This provides: a composition for forming a resist underlayer film containing a thermosetting silicon-containing material in photolithography using a high-energy beam, the material improving sensitivity, LWR, and resolution of an upper layer resist and further contributing to the prevention of pattern collapse; and a patterning process using the composition for forming a resist underlayer film.

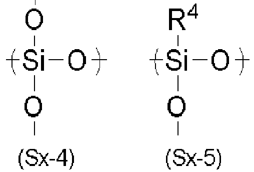

## Description

### TECHNICAL FIELD

The present invention relates to: a composition for forming a silicon-containing resist underlayer film; and a patterning process.

### BACKGROUND ART

While a higher integration density, higher operating speed and lower power consumption of LSIs are demanded to comply with the expanding IoT market, the effort to reduce the pattern rule is in rapid progress. In particular, logic devices drive forward the miniaturization technology. As the advanced miniaturization technology, devices of 10-nm node are manufactured in a mass scale by the double, triple or quadro-patterning version of the immersion ArF lithography. The experimental mass-scale manufacture of 7-nm node devices by the next generation extreme ultraviolet ray (EUV) lithography of wavelength 13.5 nm has started.

In the EUV lithography, chemically amplified resist compositions are applicable to form line patterns to a line width of 20 nm or less. However, when a polymeric resist composition commonly used in the ArF lithography is used in the EUV lithography, such problems as roughening of pattern surface and difficulty of pattern control arise because the base polymer in the composition has a large molecular size. To overcome the problems, a variety of low-molecular-weight materials are proposed.

Molecular resist compositions are based on low-molecular-weight compounds and free of base polymers commonly used in polymeric resist compositions. The molecular resist composition is expected as one of effective measures for forming small-size patterns. For example, a molecular resist composition containing a sulfonium salt has a high sensitivity and forms a resist film with improved resolution and LWR, so that the resist composition is quite useful for precise micropatterning (Patent Document 1). Since the molecular resist composition has a smaller molecular size than polymers, an improvement in roughness is expectable. However, in a molecular resist composition relying on the chemical amplification mechanism, it is difficult to control the diffusion of a reaction activated species, and therefore, no satisfactory performance has yet been established. In addition, the EUV resist composition needs to not only clear roughness, but also provide high sensitivity and high resolution at the same time, with further improvements being desired.

Meanwhile, one of the causes that retard the development of EUV lithography materials is the fact that fine processing has progressed and it is necessary to form line patterns having a very thin line width with precision. When the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse.

As a means to solve such problems, there is a technique of forming between a substrate and a photoresist film a silicon-containing resist underlayer film having excellent adhesiveness to the photoresist film (Patent Document 2). Although Patent Document 2 describes a multilayer resist method using the silicon-containing resist underlayer film, there is no mention whatever of molecular resists.

In addition, it is a known technology to cure a film with the aid of a crosslinkable organic group (Patent Documents 3 and 4). However, as a result of curing the film sufficiently by heating or the like, crosslinkable organic groups do not remain in the film.

### CITATION LIST

### PATENT LITERATURE

Patent Document 1: JP2022-055315A
Patent Document 2: JP2012-237975A
Patent Document 3: JP2017-97240A
Patent Document 4: WO2019/124514A1

### SUMMARY OF INVENTION

### TECHNICAL PROBLEM

The present invention has been made in view of the above-described circumstances. An object of the present invention is to provide: a composition for forming a resist underlayer film containing a thermosetting silicon-containing material in photolithography using a high-energy beam, the material improving sensitivity, LWR, and resolution of an upper layer resist and further contributing to the prevention of pattern collapse; and a patterning process using the composition for forming a resist underlayer film.

### SOLUTION TO PROBLEM

To achieve the object, the present invention provides a composition for forming a silicon-containing resist underlayer film, comprising a condensation reaction-type thermosetting silicon-containing material (Sx), being a polysiloxane resin, wherein the material (Sx) has a non-condensation reactive organic group that reacts with a radical chemical species generated by irradiation with a high-energy beam, the resin includes more than 0 and 70 mol% or less of one or more of a repeating unit represented by the following general formula (Sx-4) and a repeating unit represented by the following general formula (Sx-5), and the organic group remains unreacted after a heat-curing reaction of the polysiloxane resin, 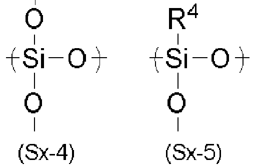 wherein R⁴ represents a hydrogen atom, a hydroxy group, or a nonaromatic substituent having 1 to 30 carbon atoms and optionally containing a monovalent heteroelement.

Such a composition for forming a silicon-containing resist underlayer film can improve the sensitivity, LWR, and resolution of an upper layer resist, and furthermore, can prevent pattern collapse of a line pattern etc.

In the present invention, the polysiloxane resin of the material (Sx) preferably contains one or more moieties of a repeating unit represented by the following general formula (Sx-1), a repeating unit represented by the following general formula (Sx-2), and a partial structure represented by the following general formula (Sx-3), the resin preferably contains 30 to 99 mol% of the moiety, the resin preferably contains 1 to 70 mol% of one or more of the repeating unit represented by the general formula (Sx-4) and the repeating unit represented by the general formula (Sx-5), and the composition preferably further comprises a crosslinking catalyst (Xc) for siloxane polymerization, an alcohol-based organic solvent, and water, 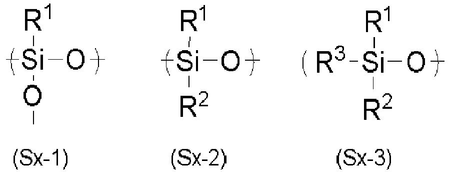 wherein R¹ represents a non-condensation reactive organic group having one or more polymerizable double bonds or a non-condensation reactive organic group that reacts with a radical chemical species generated by irradiation with a high-energy beam; R² and R³ are each independently identical to R¹ or each independently represent a hydrogen atom, a hydroxy group, or a nonaromatic substituent having 1 to 30 carbon atoms and optionally containing a monovalent heteroelement; and R⁴ is as defined above.

Such a composition for forming a silicon-containing resist underlayer film can improve the sensitivity, LWR, and resolution of an upper layer resist further, and can prevent pattern collapse.

The organic groups R¹, R², and R³ can each be an organic group represented by the following general formula R⁵ or R⁶, 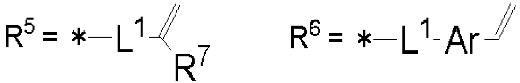 wherein L¹ represents a divalent organic group having 1 to 15 carbon atoms and optionally containing an oxygen atom; Ar represents an aromatic ring having 6 to 14 carbon atoms; "*" represents a linking point to a silicon atom; R⁷ represents a hydrogen atom or a monovalent organic group having 1 to 5 carbon atoms; and R¹, R², and R³ are identical to or different from each other.

When such a crosslinking group is combined with the thermosetting silicon-containing material of the present invention, it is possible to obtain a resist underlayer film that contributes more to the prevention of pattern collapse in an upper layer resist.

Furthermore, the organic group R⁵ can be an organic group represented by the following general formula R⁸ and the organic group R⁶ can be an organic group represented by the following general formula R⁹, 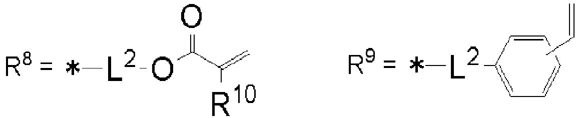 wherein L² represents a divalent organic group having 1 to 10 carbon atoms and optionally containing an oxygen atom; R¹⁰ represents a hydrogen atom or a monovalent organic group having 1 to 5 carbon atoms; and "*" represents a linking point to a silicon atom.

Such a crosslinking group makes it possible for the present invention to exhibit advantageous effects further.

The crosslinking catalyst for siloxane polymerization can be a sulfonium salt, an iodonium salt, a phosphonium salt, an ammonium salt, a polysiloxane having one of these salts as a part of a structure, or an alkaline metal salt.

When such a crosslinking catalyst is combined with the thermosetting silicon-containing material of the present invention, the crosslinking catalyst can promote the formation of siloxane bonds when the condensation reaction-type thermosetting polysiloxane cures. Therefore, it is possible to form a silicon-containing resist underlayer film densely crosslinked.

The inventive composition for forming a silicon-containing resist underlayer film is preferably to be used in a patterning process including the steps of:
forming a resist underlayer film by using the composition for forming a silicon-containing resist underlayer film; and
forming a resist upper layer film on the resist underlayer film by using a composition for a resist upper layer film containing a compound having a polymerizable functional group.

When the composition for forming a silicon-containing resist underlayer film is used together with a composition for a resist upper layer film containing a compound having a polymerizable functional group, the composition exhibits favorably the advantageous effect of suppressing pattern collapse.

The present invention also provides a patterning process comprising the steps of:
forming a resist underlayer film on a body to be processed or on a film formed on a body to be processed by using the above-described composition for forming a silicon-containing resist underlayer film;
forming a resist upper layer film on the resist underlayer film by using a composition for a resist upper layer film, containing a compound having a polymerizable functional group; and
forming a circuit pattern in the resist upper layer film, wherein
the resist underlayer film is formed by heat-curing the composition for forming a silicon-containing resist underlayer film and
the circuit pattern is formed and a crosslink between the resist underlayer film and the resist upper layer film is also formed by irradiation with a high-energy beam.

The present invention also provides a patterning process comprising the steps of:
forming an organic film on a body to be processed by using a coating-type organic film material;
forming a resist underlayer film on the organic film by using the above-described composition for forming a silicon-containing resist underlayer film;
forming a resist upper layer film on the resist underlayer film by using a composition for a resist upper layer film, containing a photoresist composition;
forming a circuit pattern in the resist upper layer film;
transferring the pattern to the resist underlayer film by etching while using the resist upper layer film having the formed circuit pattern as a mask;
transferring the pattern to the organic film by etching while using the resist underlayer film having the transferred pattern as a mask; and
transferring the pattern to the body to be processed by etching while using the organic film having the transferred pattern as a mask.

The present invention also provides a patterning process comprising the steps of:
forming an organic hard mask mainly containing carbon on a body to be processed by a CVD method;
forming a resist underlayer film on the organic hard mask by using the above-described composition for forming a silicon-containing resist underlayer film;
forming a resist upper layer film on the resist underlayer film by using a composition for a resist upper layer film, containing a photoresist composition;
forming a circuit pattern in the resist upper layer film;
transferring the pattern to the resist underlayer film by etching while using the resist upper layer film having the formed circuit pattern as a mask;
transferring the pattern to the organic hard mask by dry etching while using the resist underlayer film having the transferred pattern as a mask; and
transferring the pattern to the body to be processed by dry etching while using the organic hard mask having the transferred pattern as a mask.

The present invention also provides a patterning process comprising the steps of:
forming an organic film on a body to be processed by using a coating-type organic film material;
forming an inorganic hard mask middle layer film on the organic film by a CVD method or an ALD method;
forming a resist underlayer film on the inorganic middle layer film by using the above-described composition for forming a silicon-containing resist underlayer film;
forming a resist upper layer film on the resist underlayer film by using a composition for a resist upper layer film, containing a photoresist composition;
forming a circuit pattern in the resist upper layer film;
transferring the pattern to the resist underlayer film by etching while using the resist upper layer film having the formed circuit pattern as a mask;
transferring the pattern to the inorganic middle layer film by etching while using the resist underlayer film having the formed circuit pattern as a mask;
transferring the pattern to the organic film by etching while using the inorganic middle layer film having the transferred pattern as a mask; and
transferring the pattern to the body to be processed by etching while using the organic film having the transferred pattern as a mask.

The present invention also provides a patterning process comprising the steps of:
forming an organic hard mask mainly containing carbon on a body to be processed by a CVD method;
forming an inorganic hard mask middle layer film on the organic hard mask by a CVD method or an ALD method;
forming a resist underlayer film on the inorganic middle layer film by using the above-described composition for forming a silicon-containing resist underlayer film;
forming a resist upper layer film on the resist underlayer film by using a composition for a resist upper layer film, containing a photoresist composition;
forming a circuit pattern in the resist upper layer film;
transferring the pattern to the resist underlayer film by etching while using the resist upper layer film having the formed circuit pattern as a mask;
transferring the pattern to the inorganic middle layer film by etching while using the resist underlayer film having the formed circuit pattern as a mask;
transferring the pattern to the organic hard mask mainly containing carbon by etching while using the inorganic middle layer film having the transferred pattern as a mask; and
transferring the pattern to the body to be processed by etching while using the organic hard mask having the transferred pattern as a mask.

When the inventive composition for forming a silicon-containing resist underlayer film is used in the above-described multilayer resist methods, not only is it possible to form an upper layer resist pattern excellent in LWR and sensitivity, allowing strong adhesion between the silicon-containing resist underlayer film and the upper layer resist (photoresist film) by crosslinking in the above-described manner makes it possible to suppress pattern collapse and makes it possible to form on a substrate a pattern for a semiconductor device with good yield.

In the patterning processes, the pattern in the resist upper layer film can be formed by a photolithography with a wavelength of 10 nm or more and 300 nm or less, a direct drawing by electron beam, a nanoimprinting, or a combination thereof.

By performing such pattern formation under conditions in accordance with the photoresist film and then performing a treatment as necessary, it is possible to obtain a suitable negative or positive resist pattern.

In the patterning processes, the body to be processed can be a semiconductor device substrate, a metal film, a metal carbide film, a metal oxide film, a metal nitride film, a metal oxycarbide film, or a metal oxynitride film.

In the inventive patterning processes, a highly accurate pattern can be formed on the substrate (film) without causing a difference in size conversion when an organic underlayer film or an organic hard mask is formed on the body to be processed.

In the patterning processes, the metal of the body to be processed can be silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.

When a body to be processed including such a metal is used, it is possible to transfer with high precision a negative or positive pattern on the body to be processed by accurate etching.

### ADVANTAGEOUS EFFECTS OF INVENTION

The inventive composition for forming a silicon-containing resist underlayer film can improve the sensitivity, LWR, and resolution of an upper layer resist and also suppress pattern collapse in photolithography using a high-energy beam, in particular, electron beam (EB) lithography and EUV lithography. In addition, the inventive composition not only makes it possible to form a resist pattern of an upper layer excellent in LWR and prevention of pattern collapse, but also makes it possible to transfer the formed photoresist pattern to a silicon-containing resist underlayer film and to an organic underlayer film or a CVD organic hard mask in succession by a dry etching process, since a high etching selectivity can be achieved between the composition and organic materials (organic underlayer film and organic hard mask). Furthermore, the inventive composition allows the use of a molecular resist as an upper layer resist, and it is possible to improve the sensitivity, LWR, and resolution of the resist and also suppress pattern collapse in this case as well.

Meanwhile, in particular, a multiple exposure process is frequently used in recent semiconductor device manufacturing processes, in which miniaturization is progressing, and LWR and the prevention of pattern collapse in developed patterns have a great influence on device performance. Accordingly, improvement of LWR and the prevention of pattern collapse are important. When the inventive composition for forming a silicon-containing resist underlayer film is used, it is possible to form an upper layer resist pattern excellent in LWR and pattern collapse prevention. Furthermore, the inventive composition for forming a silicon-containing resist underlayer film has excellent dry etching selectivity, and therefore, even when the silicon-containing resist underlayer film is used as a dry etching mask, it is possible to suppress the deformation of the upper layer resist pattern during dry etching, and it is possible to transfer the pattern to the substrate with high precision while maintaining excellent LWR and CDU.

### BRIEF DESCRIPTION OF DRAWINGS

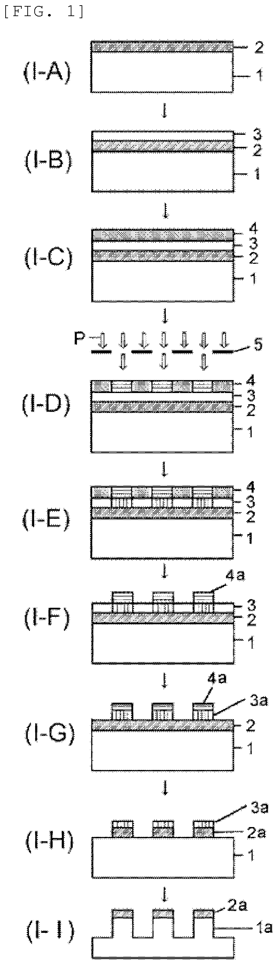

FIG. 1 is a flow diagram showing the inventive patterning process.

### DESCRIPTION OF EMBODIMENTS

As stated above, there have been demands for the development of a composition for forming a resist underlayer film that makes it possible to form an upper layer resist pattern excellent in LWR and pattern collapse prevention.

In response to the demands, the present inventors have focused on forming a crosslink between films by combining a photoresist film having a crosslinkable organic group and a silicon-containing resist underlayer film having a crosslinkable organic group, as a method of allowing a photoresist film and a silicon-containing resist underlayer film to adhere to each other.

The curing of a film with crosslinkable organic groups is a known technique, but in order to realize the above-described crosslinking technique between films (between layers), it is necessary for crosslinkable organic groups to remain in the silicon-containing resist underlayer film even after curing the silicon-containing resist underlayer film by heating or the like. Therefore, it has been difficult to achieve both sufficient curing of the films and the retention of crosslinkable organic groups according to conventional technology.

To achieve the above-described object, the present inventors have earnestly studied and found out that a composition for forming a resist underlayer film, containing a thermosetting silicon-containing material having a non-condensation reactive organic group that reacts with a radical chemical species generated by irradiation with a high-energy beam (such as an electron beam), can improve the sensitivity, LWR, and resolution of a resist film, also gives a resist film that can prevent line pattern collapse, and is extremely effective for accurate fine processing. Thus, the present invention has been completed.

That is, the present invention is a composition for forming a silicon-containing resist underlayer film, comprising a condensation reaction-type thermosetting silicon-containing material (Sx), being a polysiloxane resin, wherein the material (Sx) has a non-condensation reactive organic group that reacts with a radical chemical species generated by irradiation with a high-energy beam, the resin includes more than 0 and 70 mol% or less of one or more of a repeating unit represented by the following general formula (Sx-4) and a repeating unit represented by the following general formula (Sx-5), and the organic group remains unreacted after a heat-curing reaction of the polysiloxane resin, 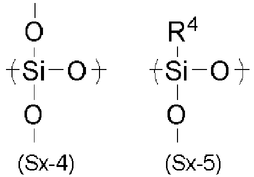 wherein R⁴ represents a hydrogen atom, a hydroxy group, or a nonaromatic substituent having 1 to 30 carbon atoms and optionally containing a monovalent heteroelement.

Hereinafter, the present invention will be described in detail, but the present invention is not limited thereto.

### [Composition for Forming Silicon-Containing Resist Underlayer Film]

The inventive composition for forming a silicon-containing resist underlayer film contains a condensation reaction-type thermosetting silicon-containing material (Sx), being a polysiloxane resin, where the material (Sx) has a non-condensation reactive organic group that reacts with a radical chemical species generated by irradiation with a high-energy beam, the resin includes more than 0 and 70 mol% or less of one or more of a repeating unit represented by the general formula (Sx-4) and a repeating unit represented by the general formula (Sx-5), and the organic group remains unreacted after a heat-curing reaction of the polysiloxane resin.

### [Condensation Reaction-Type Thermosetting Silicon-Containing Material]

The condensation reaction-type thermosetting silicon-containing material (Sx) of the present invention has a non-condensation reactive organic group that reacts with a radical chemical species generated by irradiation with a high-energy beam, the resin includes more than 0 and 70 mol% or less of one or more of a repeating unit represented by the following general formula (Sx-4) and a repeating unit represented by the following general formula (Sx-5), and the organic group remains unreacted after a heat-curing reaction of the polysiloxane resin.

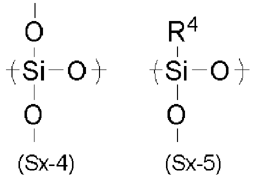

In the formula, R⁴ represents a hydrogen atom, a hydroxy group, or a nonaromatic substituent having 1 to 30 carbon atoms and optionally containing a monovalent heteroelement.

The condensation reaction-type thermosetting silicon-containing material of the present invention cures by the siloxane moiety of the repeating unit of the polysiloxane resin undergoing a condensation reaction.

The molecular chain of a polysiloxane resin is terminated at the molecular chain ends with a hydroxy group bonded to a silicon atom (silanol) and/or with a hydrolysable alkoxy group bonded to a silicon atom, the group originating from raw materials. A curing (crosslinking) reaction progresses by such molecular chain ends undergoing hydrolysis and condensation reactions due to heat or the like. The condensation reaction is promoted by a crosslinking catalyst described later or by heating.

Examples of condensation reactive functional groups include, besides hydroxy groups bonded to silicon atoms and hydrolysable alkoxy groups, ring-opening polymerizable functional groups such as epoxy groups and oxetanyl groups.

On the other hand, "non-condensation reactive" refers to a quality of not undergoing a condensation reaction even with a crosslinking catalyst or when heated. The material (Sx) in the present invention has a non-condensation reactive organic group that reacts with a radical chemical species, and has a characteristic that the organic group remains unreacted after a heat-curing reaction of the polysiloxane resin. Preferable non-condensation reactive organic groups include non-condensation reactive organic groups having one or more polymerizable double bonds and non-condensation reactive organic groups that react with a radical chemical species generated by irradiation with a high-energy beam. Specific examples include a vinyl group, an isopropenyl group, an allyl group, a (meth)acryloyl group, a 3,3,3-trifluoro-2-propenyl group, a 5-norbornen-2-yl group, etc. In particular, a (meth)acryloyl group is preferable.

In the present invention, "remain unreacted after a heat-curing reaction" refers to a state where the non-condensation reactive organic groups are present within the formed film even when a curing (crosslinking) reaction has progressed due to heating. It can be confirmed whether the non-condensation reactive organic groups are present in the formed film by measuring the organic groups by nuclear magnetic resonance, infrared spectroscopy, etc. for example.

In the present invention, the high-energy beam is not particularly limited as long as radical chemical species can be generated from an organic group or the like by the function of the beam, and can be a beam used for the exposure of resist films. Examples of the high-energy beam include ultraviolet ray, far-ultraviolet ray, electron beam (EB), extreme ultraviolet ray (EUV) having a wavelength of 3 to 15 nm, X-ray, soft X-ray, excimer laser beam, γ-ray, synchrotron radiation, etc.

R⁴ represents a hydrogen atom, a hydroxy group, or a nonaromatic substituent having 1 to 30 carbon atoms and optionally containing a monovalent heteroelement. Examples of R⁴ include linear, branched, or cyclic monovalent aliphatic hydrocarbon groups having 1 to 30 carbon atoms. In particular, linear alkyl groups having 1 to 5 carbon atoms are preferable, and a methyl group is particularly favorable.

In the present invention, the polysiloxane resin of the material (Sx) preferably contains one or more moieties of a repeating unit represented by the following general formula (Sx-1), a repeating unit represented by the following general formula (Sx-2), and a partial structure represented by the following general formula (Sx-3), the resin preferably contains 30 to 99 mol% of the moiety, and the resin preferably contains 1 to 70 mol% of one or more units of the repeating unit represented by the general formula (Sx-4) and/or the repeating unit represented by the general formula (Sx-5).

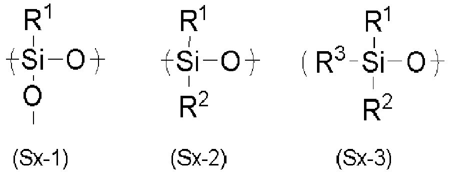

In the formulae, R¹ represents a non-condensation reactive organic group having one or more polymerizable double bonds or a non-condensation reactive organic group that reacts with a radical chemical species generated by irradiation with a high-energy beam; and R² and R³ are each independently identical to R¹ or each independently represent a hydrogen atom, a hydroxy group, or a nonaromatic substituent having 1 to 30 carbon atoms and optionally containing a monovalent heteroelement. R⁴ is as defined above.

In this case, the inventive composition for forming a silicon-containing resist underlayer film can further contain a crosslinking catalyst (Xc) for siloxane polymerization, an alcohol-based organic solvent, and water.

The organic groups R¹, R², and R³ can each be an organic group represented by the following general formula R⁵ or R⁶.

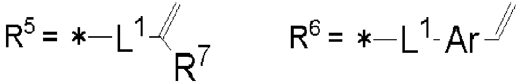

In the formulae, L¹ represents a divalent organic group having 1 to 15 carbon atoms and optionally containing an oxygen atom; Ar represents an aromatic ring having 6 to 14 carbon atoms; and "*" represents a linking point to a silicon atom. R⁷ represents a hydrogen atom or a monovalent organic group having 1 to 5 carbon atoms. R¹, R², and R³ are identical to or different from each other.

Furthermore, the organic group R⁵ is preferably an organic group represented by the following general formula R⁸ and the organic group R⁶ is preferably an organic group represented by the following general formula R⁹.

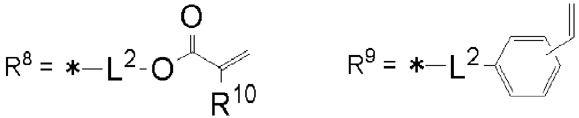

In the formulae, L² represents a divalent organic group having 1 to 10 carbon atoms and optionally containing an oxygen atom; and R¹⁰ represents a hydrogen atom or a monovalent organic group having 1 to 5 carbon atoms. "*" represents a linking point to a silicon atom.

By combining such a crosslinking group with the thermosetting silicon-containing material of the present invention, it is possible to obtain a resist underlayer film that contributes more to the prevention of pattern collapse in an upper layer resist.

The inventive composition for forming a silicon-containing resist underlayer film can contain one or more moieties of a repeating unit represented by the following general formula (Sx-1), a repeating unit represented by the following general formula (Sx-2), and a partial structure represented by the following general formula (Sx-3), and can contain in the resin 1 to 70 mol% of one or more of the repeating unit represented by the following general formula (Sx-4) and the repeating unit represented by the following general formula (Sx-5).

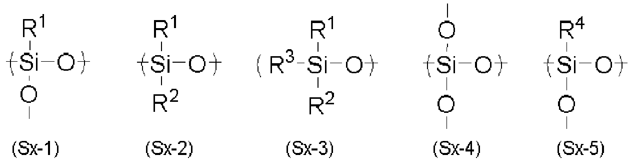

In the formulae, R¹, R², R³, and R⁴ are as defined above.

In the inventive composition for forming a silicon-containing resist underlayer film, the polysiloxane resin of the material (Sx) has a non-condensation reactive organic group that reacts with a radical chemical species generated by irradiation with a high-energy beam, the resin includes more than 0 and 70 mol% or less of one or more of a repeating unit represented by the general formula (Sx-4) and a repeating unit represented by the general formula (Sx-5), and the organic group remains unreacted after a heat-curing reaction of the polysiloxane resin. For this reason, when a resist composition containing a polymerizable functional group, for example, a molecular resist composition containing a sulfonium salt represented by the following formula (1A) or (2A) and an organic solvent and containing no base polymers, is used as a composition for a resist upper layer film to form a resist upper layer film on the silicon-containing resist underlayer film, the inventive composition exhibits the excellent effects that adhesiveness is improved by crosslink formation (radical polymerization) in an exposed portion between a silicon-containing resist underlayer film having a polymerizable group and a molecular resist film (resist upper layer film) having a polymerizable group, and that the molecular resist can be prevented from collapsing.

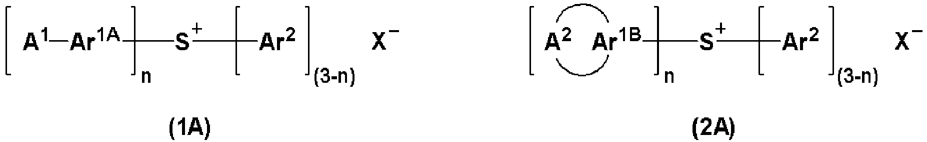

In the formulae, "n" represents an integer of 1 to 3.

A¹ represents a hydrocarbyl group having 2 to 20 carbon atoms and containing a polymerizable functional group, and the hydrocarbyl group may contain a heteroatom.

A² represents a group that contains a polymerizable functional group and forms an alicyclic ring having 4 to 20 carbon atoms together with two of the carbon atoms in Ar^{1B}, and the alicyclic ring may contain a heteroatom.

Ar^{1A} represents an arylene group having 6 to 20 carbon atoms, and part or all of the hydrogen atoms in the aromatic ring of the arylene group may be substituted with a halogen atom or a hydrocarbyl group having 1 to 20 carbon atoms and optionally containing a heteroatom. Ar^{1B} represents a trivalent aromatic hydrocarbon group having 6 to 20 carbon atoms, and part or all of the hydrogen atoms in the aromatic ring of the trivalent aromatic hydrocarbon group may be substituted with a halogen atom or a hydrocarbyl group having 1 to 20 carbon atoms and optionally containing a heteroatom. Ar² represents an aryl group having 6 to 20 carbon atoms, and part or all of the hydrogen atoms in the aromatic ring of the aryl group may be substituted with a halogen atom or a hydrocarbyl group having 1 to 20 carbon atoms and optionally containing a heteroatom. In addition, two Ar^{1A}s, two Ar^{1B}s, two Ar2s, Ar^{1A} and Ar², or Ar^{1B} and Ar² may be bonded to each other to form a ring together with the sulfur atom bonded thereto.

X⁻ represents a counter anion. Note that the above symbols apply only to the above formulae.

The inventive composition for forming a silicon-containing resist underlayer film contains the above-described non-condensation reactive organic group, which remains unreacted after heat-curing the polysiloxane resin, and therefore, the organic group functions as a crosslinking group. In this manner, the organic group crosslinks to the molecular resist etc. upon exposure to light, and thus, the above-described advantageous effects can be achieved.

The above R¹ is not particularly limited as long as it is a non-condensation reactive organic group that reacts with a radical chemical species generated by irradiation with a high-energy beam such as an electron beam.

Examples of such condensation reaction-type thermosetting silicon-containing materials (Sx) include the following. Note that, in the following formulae, (Si) shows an attachment point to Si (the same applies hereinafter).

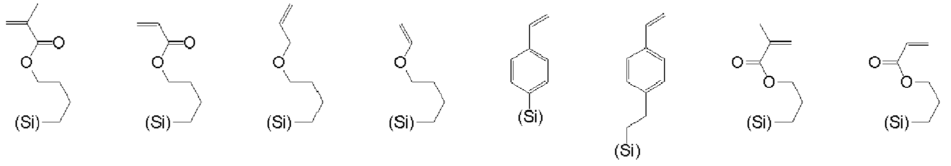

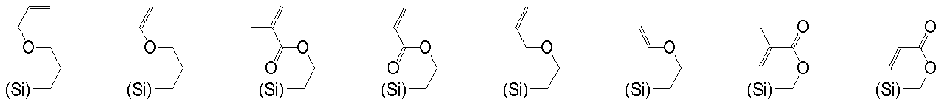

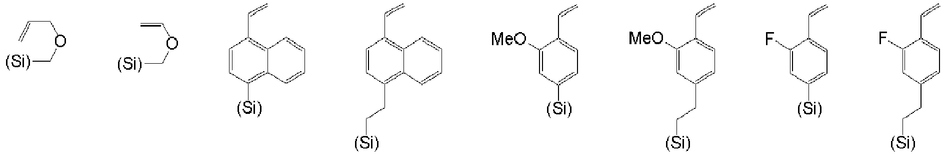

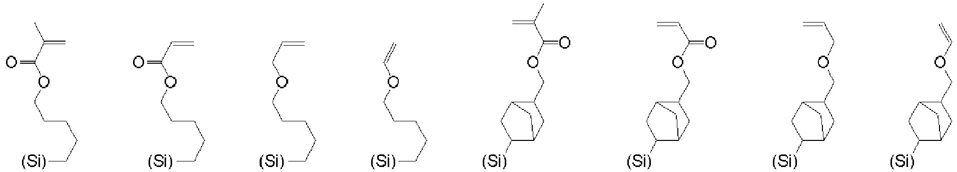

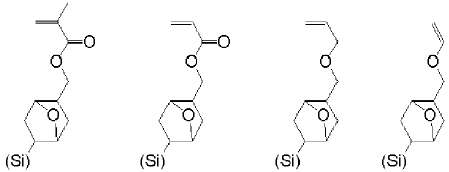

As a hydrolysable monomer (Sm) to be used as a starting material for forming the structure of the present invention, it is possible to use a monomer having a structure shown above on a silicon atom and containing, as a hydrolysable group, one, two, or three chlorine atoms, bromine atoms, iodine atoms, acetoxy groups, methoxy groups, ethoxy groups, propoxy groups, or butoxy groups, and if present, as R² and R³, a hydrogen atom or a monovalent organic group having 1 to 30 carbon atoms. One kind of the monomer may be used, or two or more kinds thereof may be used in combination.

The organic groups represented by R² and R³ may be identical to or different from each other, and examples of the organic groups include methyl, ethyl, vinyl, propyl, cyclopropyl, butyl, cyclobutyl, pentyl, cyclopentyl, hexyl, cyclohexyl, cyclohexenyl, cyclopentylmethyl, heptyl, cyclohexylmethyl, cyclohexenylmethyl, bicyclo[2,2,1]heptyl, octyl, cyclooctyl, cyclohexylethyl, decyl, adamantyl, dodecyl, etc.

Examples of other organic groups represented by the R² and R³ include organic groups having one or more carbon-oxygen single bonds or carbon-oxygen double bonds. Specific examples include organic groups having one or more moieties selected from the group consisting of an ether bond, an ester bond, an alkoxy group, and a hydroxy group. Examples of the organic groups include those represented by the following general formulae (Sm-R) .

### (P-Q₁-(S1)ᵥ₁-Q2-)ᵤ-(T)ᵥ₂-Q₃-(S₂)ᵥ₃-Q₄ (Sm-R)

In the general formula (Sm-R), P represents a hydrogen atom, a cyclic ether group, a hydroxyl group, an alkoxy group having 1 to 4 carbon atoms, an alkylcarbonyloxy group having 1 to 6 carbon atoms, or an alkylcarbonyl group having 1 to 6 carbon atoms; Q₁, Q₂, Q₃, and Q₄ each independently represent -C_{q}H_{(2q-p)}Pₚ-(where P is as described above, "p" represents an integer of 0 to 3, and "q" represents an integer of 0 to 10, provided that q=0 indicates a single bond); "u" represents an integer of 0 to 3; and S₁ and S₂ each independently represent -O-, -CO-, -OCO-, -COO-, or -OCOO-. "v1", "v2", and "v3" each independently represent 0 or 1. In addition, T represents a divalent group including a divalent atom other than a carbon atom and an alicyclic ring.

As T, examples of alicyclic rings optionally containing a heteroatom such as an oxygen atom are shown below. In T, positions bonded to Q₂ and Q₃ are not particularly limited, and can be selected appropriately in consideration of reactivity dependent on steric factors, availability of commercial reagents used in the reaction, and so on.

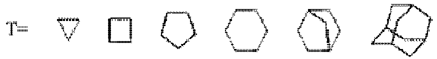

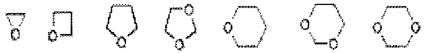

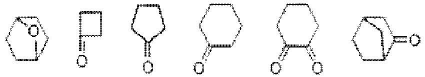

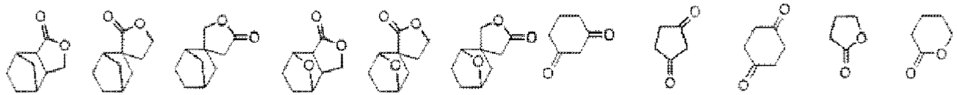

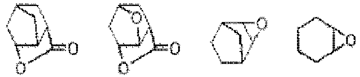

Favorable examples of the organic groups having one or more carbon-oxygen single bonds or carbon-oxygen double bonds in the general formula (Sm-R) include the following.

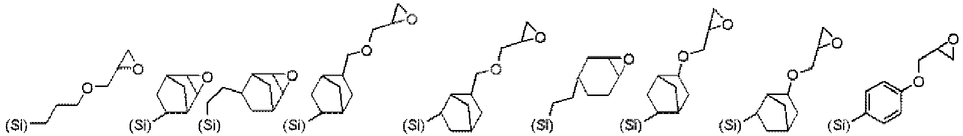

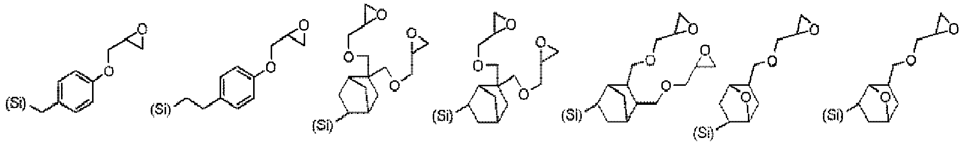

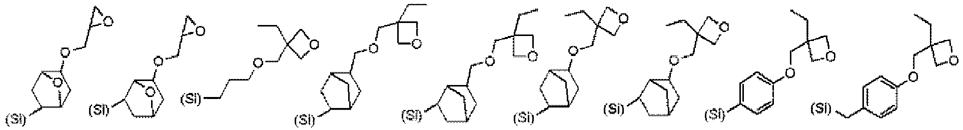

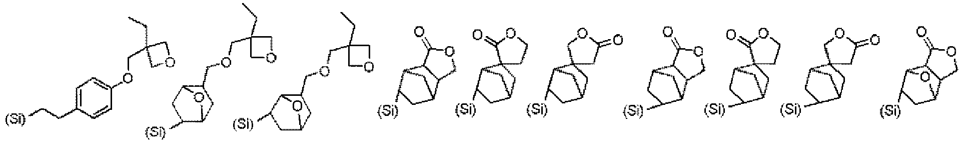

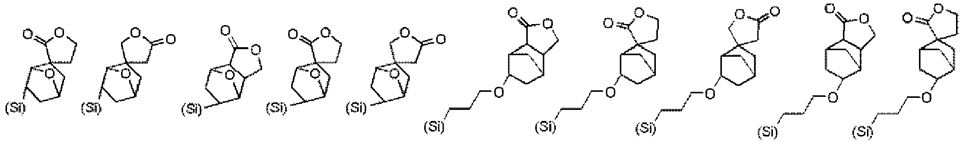

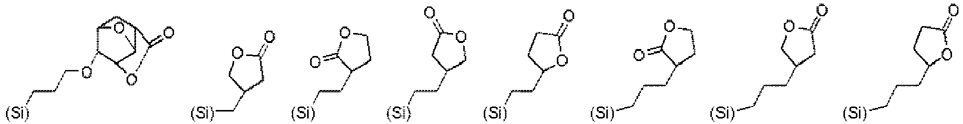

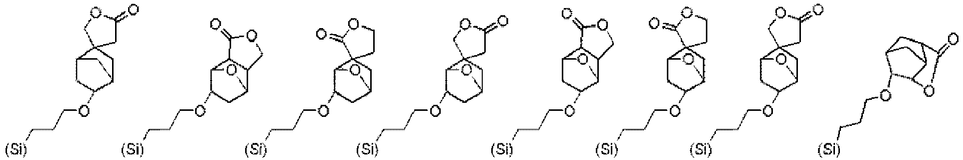

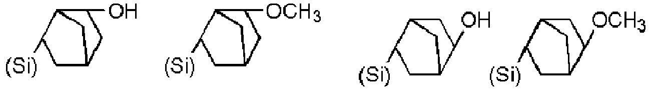

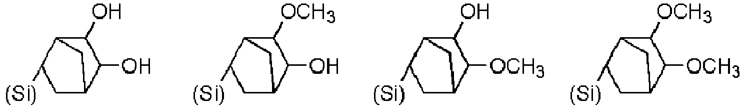

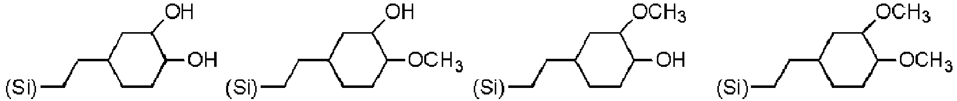

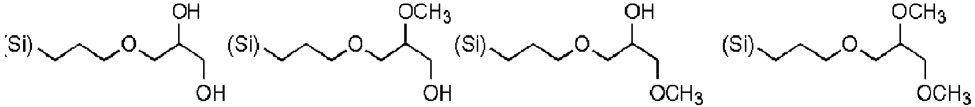

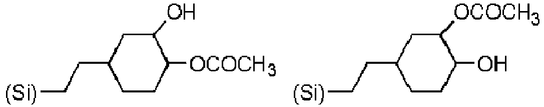

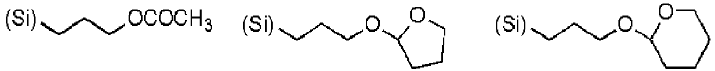

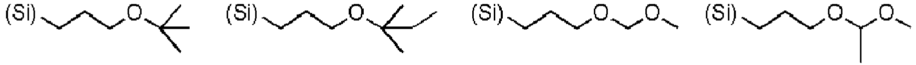

Moreover, as an example of the organic groups of R² and R³, an organic group containing a silicon-silicon bond can also be used. Specific examples thereof include the following.

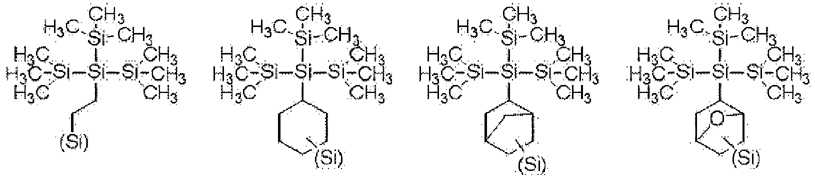

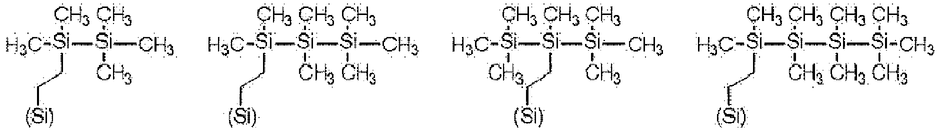

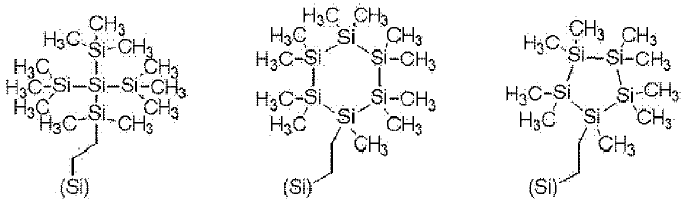

Furthermore, as the organic groups of R² and R³, organic groups having a fluorine atom can also be used, for example. Specific examples include organic groups that can be obtained from silicon compounds shown in paragraphs (0059) to (0065) of JP2012-53253A.

To the above-described hydrolysable monomer (Sm), one, two, or three chlorine atoms, bromine atoms, iodine atoms, acetoxy groups, methoxy groups, ethoxy groups, propoxy groups, butoxy groups or the like are bonded as hydrolysable groups on the silicon atom represented by (Si) in the partial structures shown above.

Furthermore, the silicon-containing material (Sx) of the present invention can be manufactured by subjecting a mixture containing a hydrolysable monomer (Sm) given below to hydrolysis condensation.

Specific examples of the hydrolysable monomer (Sm) include tetramethoxysilane, tetraethoxysilane, tetrapropoxysilane, tetraisopropoxysilane, trimethoxysilane, triethoxysilane, tripropoxysilane, triisopropoxysilane, methyltrimethoxysilane, methyltriethoxysilane, methyltripropoxysilane, methyltriisopropoxysilane, ethyltrimethoxysilane, ethyltriethoxysilane, ethyltripropoxysilane, ethyltriisopropoxysilane, vinyltrimethoxysilane, vinyltriethoxysilane, vinyltripropoxysilane, vinyltriisopropoxysilane, propyltrimethoxysilane, propyltriethoxysilane, propyltripropoxysilane, propyltriisopropoxysilane, isopropyltrimethoxysilane, isopropyltriethoxysilane, isopropyltripropoxysilane, isopropyltriisopropoxysilane, butyltrimethoxysilane, butyltriethoxysilane, butyltripropoxysilane, butyltriisopropoxysilane, sec-butyltrimethoxysilane, sec-butyltriethoxysilane, sec-butyltripropoxysilane, sec-butyltriisopropoxysilane, t-butyltrimethoxysilane, t-butyltriethoxysilane, t-butyltripropoxysilane, t-butyltriisopropoxysilane, cyclopropyltrimethoxysilane, cyclopropyltriethoxysilane, cyclopropyltripropoxysilane, cyclopropyltriisopropoxysilane, cyclobutyltrimethoxysilane, cyclobutyltriethoxysilane, cyclobutyltripropoxysilane, cyclobutyltriisopropoxysilane, cyclopentyltrimethoxysilane, cyclopentyltriethoxysilane, cyclopentyltripropoxysilane, cyclopentyltriisopropoxysilane, cyclohexyltrimethoxysilane, cyclohexyltriethoxysilane, cyclohexyltripropoxysilane, cyclohexyltriisopropoxysilane, cyclohexenyltrimethoxysilane, cyclohexenyltriethoxysilane, cyclohexenyltripropoxysilane, cyclohexenyltriisopropoxysilane, cyclohexenylethyltrimethoxysilane, cyclohexenylethyltriethoxysilane, cyclohexenylethyltripropoxysilane, cyclohexenylethyltriisopropoxysilane, cyclooctyltrimethoxysilane, cyclooctyltriethoxysilane, cyclooctyltripropoxysilane, cyclooctyltriisopropoxysilane, cyclopentadienylpropyltrimethoxysilane, cyclopentadienylpropyltriethoxysilane, cyclopentadienylpropyltripropoxysilane, cyclopentadienylpropyltriisopropoxysilane, bicycloheptenyltrimethoxysilane, bicycloheptenyltriethoxysilane, bicycloheptenyltripropoxysilane, bicycloheptenyltriisopropoxysilane, bicycloheptyltrimethoxysilane, bicycloheptyltriethoxysilane, bicycloheptyltripropoxysilane, bicycloheptyltriisopropoxysilane, adamantyltrimethoxysilane, adamantyltriethoxysilane, adamantyltripropoxysilane, adamantyltriisopropoxysilane, dimethyldimethoxysilane, dimethyldiethoxysilane, methylethyldimethoxysilane, methylethyldiethoxysilane, dimethyldipropoxysilane, dimethyldiisopropoxysilane, diethyldimethoxysilane, diethyldiethoxysilane, diethyldipropoxysilane, diethyldiisopropoxysilane, dipropyldimethoxysilane, dipropyldiethoxysilane, dipropyldipropoxysilane, dipropyldiisopropoxysilane, diisopropyldimethoxysilane, diisopropyldiethoxysilane, diisopropyldipropoxysilane, diisopropyldiisopropoxysilane, dibutyldimethoxysilane, dibutyldiethoxysilane, dibutyldipropoxysilane, dibutyldiisopropoxysilane, di-sec-butyldimethoxysilane, di-sec-butyldiethoxysilane, di-sec-butyldipropoxysilane, di-sec-butyldiisopropoxysilane, di-t-butyldimethoxysilane, di-t-butyldiethoxysilane, di-t-butyldipropoxysilane, di-t-butyldiisopropoxysilane, dicyclopropyldimethoxysilane, dicyclopropyldiethoxysilane, dicyclopropyldipropoxysilane, dicyclopropyldiisopropoxysilane, dicyclobutyldimethoxysilane, dicyclobutyldiethoxysilane, dicyclobutyldipropoxysilane, dicyclobutyldiisopropoxysilane, dicyclopentyldimethoxysilane, dicyclopentyldiethoxysilane, dicyclopentyldipropoxysilane, dicyclopentyldiisopropoxysilane, dicyclohexyldimethoxysilane, dicyclohexyldiethoxysilane, dicyclohexyldipropoxysilane, dicyclohexyldiisopropoxysilane, dicyclohexenyldimethoxysilane, dicyclohexenyldiethoxysilane, dicyclohexenyldipropoxysilane, dicyclohexenyldiisopropoxysilane, dicyclohexenylethyldimethoxysilane, dicyclohexenylethyldiethoxysilane, dicyclohexenylethyldipropoxysilane, dicyclohexenylethyldiisopropoxysilane, dicyclooctyldimethoxysilane, dicyclooctyldiethoxysilane, dicyclooctyldipropoxysilane, dicyclooctyldiisopropoxysilane, dicyclopentadienylpropyldimethoxysilane, dicyclopentadienylpropyldiethoxysilane, dicyclopentadienylpropyldipropoxysilane, dicyclopentadienylpropyldiisopropoxysilane, bis(bicycloheptenyl)dimethoxysilane, bis(bicycloheptenyl)diethoxysilane, bis(bicycloheptenyl)dipropoxysilane, bis(bicycloheptenyl)diisopropoxysilane, bis(bicycloheptyl)dimethoxysilane, bis(bicycloheptyl)diethoxysilane, bis(bicycloheptyl)dipropoxysilane, bis(bicycloheptyl)diisopropoxysilane, diadamantyldimethoxysilane, diadamantyldiethoxysilane, diadamantyldipropoxysilane, diadamantyldiisopropoxysilane, trimethylmethoxysilane, trimethylethoxysilane, dimethylethylmethoxysilane, dimethylethylethoxysilane, and the like.

Preferable examples of the above-mentioned compounds include tetramethoxysilane, tetraethoxysilane, methyltrimethoxysilane, methyltriethoxysilane, ethyltrimethoxysilane, ethyltriethoxysilane, vinyltrimethoxysilane, vinyltriethoxysilane, propyltrimethoxysilane, propyltriethoxysilane, isopropyltrimethoxysilane, isopropyltriethoxysilane, butyltrimethoxysilane, butyltriethoxysilane, isobutyltrimethoxysilane, isobutyltriethoxysilane, allyltrimethoxysilane, allyltriethoxysilane, cyclopentyltrimethoxysilane, cyclopentyltriethoxysilane, cyclohexyltrimethoxysilane, cyclohexyltriethoxysilane, cyclohexenyltrimethoxysilane, cyclohexenyltriethoxysilane, dimethyldimethoxysilane, dimethyldiethoxysilane, diethyldimethoxysilane, diethyldiethoxysilane, methylethyldimethoxysilane, methylethyldiethoxysilane, dipropyldimethoxysilane, dibutyldimethoxysilane, trimethylmethoxysilane, dimethylethylmethoxysilane, and the like.

### [Method for Synthesizing Thermosetting Silicon-Containing Material (Sx)]

### (Synthesis Method 1: Acid Catalyst)

The thermosetting silicon-containing material (Sx: hereinafter, also referred to as thermosetting polysiloxane) of the present invention can be produced by hydrolysis condensation of one kind of the hydrolysable monomer (Sm) or a mixture of two or more kinds (hereinafter, also referred to simply as "monomer") in the presence of an acid catalyst.

Examples of the acid catalyst used in this event include organic acids such as formic acid, acetic acid, oxalic acid, maleic acid, methanesulfonic acid, benzenesulfonic acid, and toluenesulfonic acid; and inorganic acids such as hydrofluoric acid, hydrochloric acid, hydrobromic acid, sulfuric acid, nitric acid, perchloric acid, and phosphoric acid. The catalyst can be used in an amount of 1×10-⁶ to 10 mol, preferably 1×10⁻⁵ to 5 mol, more preferably 1×10⁻⁴ to 1 mol, relative to 1 mol of the monomer.

When the thermosetting polysiloxane is obtained from these monomers by the hydrolysis condensation, water is preferably added in an amount of 0.01 to 100 mol, more preferably 0.05 to 50 mol, further preferably 0.1 to 30 mol, per mol of the hydrolysable substituent bonded to the monomer. When the amount is 100 mol or less, a reaction device can be made small and economical.

As the operation method, the monomer is added to an aqueous catalyst solution to initiate the hydrolysis condensation reaction. In this event, an organic solvent may be added to the aqueous catalyst solution, or the monomer may be diluted with an organic solvent, or both of these operations may be performed. The reaction temperature may be 0 to 100°C, preferably 5 to 80°C. As a preferable method, when the monomer is added dropwise, the temperature is maintained at 5 to 80°C, and then the mixture is aged at 20 to 80°C.

The organic solvent which can be added to the aqueous catalyst solution or with which the monomer can be diluted is preferably methanol, ethanol, 1-propanol, 2-propanol, 1-butanol, 2-butanol, 2-methyl-1-propanol, acetone, acetonitrile, tetrahydrofuran, toluene, hexane, ethyl acetate, methyl ethyl ketone, methyl isobutyl ketone, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, t-butyl propionate, propylene glycol mono-t-butyl ether acetate, γ-butyrolactone, acetonitrile, tetrahydrofuran, mixtures thereof, and the like.

Among these solvents, water-soluble solvents are preferable. Examples thereof include alcohols such as methanol, ethanol, 1-propanol, and 2-propanol; polyhydric alcohols such as ethylene glycol and propylene glycol; polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, and ethylene glycol monopropyl ether; acetone, acetonitrile, tetrahydrofuran, and the like. Among these, particularly preferable is one having a boiling point of 100°C or lower.

Note that the organic solvent is used in an amount of preferably 0 to 1,000 ml, particularly preferably 0 to 500 ml, relative to 1 mol of the monomer. When the organic solvent is used in a small amount, only a small reaction vessel is required, and this is economical.

Then, if necessary, neutralization reaction of the catalyst is carried out to obtain an aqueous reaction mixture solution. In this event, the amount of an alkaline substance usable for the neutralization is preferably 0.1 to 2 equivalents relative to the acid used as the catalyst. This alkaline substance may be any substance as long as it shows alkalinity in water.

Subsequently, by-products such as alcohol produced by the hydrolysis condensation reaction are preferably removed from the reaction mixture by a procedure such as removal under reduced pressure. In this event, the reaction mixture is heated at a temperature of preferably 0 to 100°C, more preferably 10 to 90°C, further preferably 15 to 80°C, although the temperature depends on the kinds of the added organic solvent, the alcohol produced in the reaction, and so forth. Additionally, in this event, the degree of vacuum is preferably atmospheric pressure or less, more preferably 80 kPa or less in absolute pressure, further preferably 50 kPa or less in absolute pressure, although the degree of vacuum varies depending on the kinds of the organic solvent, alcohol, etc. to be removed, as well as exhausting equipment, condensation equipment, and heating temperature. In this case, it is difficult to know accurately the amount of alcohol to be removed, but it is desirable to remove about 80 mass% or more of the produced alcohol, etc.

Next, the acid catalyst used in the hydrolysis condensation may be removed from the reaction mixture. As a method for removing the acid catalyst, the thermosetting polysiloxane solution is mixed with water, and the thermosetting polysiloxane is extracted with an organic solvent. Preferably, the organic solvent used in this event is capable of dissolving the thermosetting polysiloxane, and achieves two-layer separation when mixed with water. Examples of the organic solvent include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, mixtures thereof, and the like.

Further, it is also possible to use a mixture of a water-soluble organic solvent and a slightly-water-soluble organic solvent. Preferable examples of the mixture include methanol-ethyl acetate mixture, ethanol-ethyl acetate mixture, 1-propanol-ethyl acetate mixture, 2-propanol-ethyl acetate mixture, butanediol monomethyl ether-ethyl acetate mixture, propylene glycol monomethyl ether-ethyl acetate mixture, ethylene glycol monomethyl ether-ethyl acetate mixture, butanediol monoethyl ether-ethyl acetate mixture, propylene glycol monoethyl ether-ethyl acetate mixture, ethylene glycol monoethyl ether-ethyl acetate mixture, butanediol monopropyl ether-ethyl acetate mixture, propylene glycol monopropyl ether-ethyl acetate mixture, ethylene glycol monopropyl ether-ethyl acetate mixture, methanol-methyl isobutyl ketone mixture, ethanol-methyl isobutyl ketone mixture, 1-propanol-methyl isobutyl ketone mixture, 2-propanol-methyl isobutyl ketone mixture, propylene glycol monomethyl ether-methyl isobutyl ketone mixture, ethylene glycol monomethyl ether-methyl isobutyl ketone mixture, propylene glycol monoethyl ether-methyl isobutyl ketone mixture, ethylene glycol monoethyl ether-methyl isobutyl ketone mixture, propylene glycol monopropyl ether-methyl isobutyl ketone mixture, ethylene glycol monopropyl ether-methyl isobutyl ketone mixture, methanol-cyclopentyl methyl ether mixture, ethanol-cyclopentyl methyl ether mixture, 1-propanol-cyclopentyl methyl ether mixture, 2-propanol-cyclopentyl methyl ether mixture, propylene glycol monomethyl ether-cyclopentyl methyl ether mixture, ethylene glycol monomethyl ether-cyclopentyl methyl ether mixture, propylene glycol monoethyl ether-cyclopentyl methyl ether mixture, ethylene glycol monoethyl ether-cyclopentyl methyl ether mixture, propylene glycol monopropyl ether-cyclopentyl methyl ether mixture, ethylene glycol monopropyl ether-cyclopentyl methyl ether mixture, methanol-propylene glycol methyl ether acetate mixture, ethanol-propylene glycol methyl ether acetate mixture, 1-propanol-propylene glycol methyl ether acetate mixture, 2-propanol-propylene glycol methyl ether acetate mixture, propylene glycol monomethyl ether-propylene glycol methyl ether acetate mixture, ethylene glycol monomethyl ether-propylene glycol methyl ether acetate mixture, propylene glycol monoethyl ether-propylene glycol methyl ether acetate mixture, ethylene glycol monoethyl ether-propylene glycol methyl ether acetate mixture, propylene glycol monopropyl ether-propylene glycol methyl ether acetate mixture, ethylene glycol monopropyl ether-propylene glycol methyl ether acetate mixture, and the like. However, the combination is not limited thereto.

Although the mixing ratio of the water-soluble organic solvent and the slightly-water-soluble organic solvent is appropriately selected, the amount of the water-soluble organic solvent may be 0.1 to 1,000 parts by mass, preferably 1 to 500 parts by mass, further preferably 2 to 100 parts by mass, based on 100 parts by mass of the slightly-water-soluble organic solvent.

Subsequently, the thermosetting polysiloxane solution may be washed with neutral water. As the water, what is commonly called deionized water or ultrapure water may be used. The amount of the water may be 0.01 to 100 L, preferably 0.05 to 50 L, more preferably 0.1 to 5 L, relative to 1 L of the thermosetting polysiloxane solution. This washing procedure may be performed by putting both the thermosetting polysiloxane solution and neutral water into the same container, followed by stirring and then leaving to stand to separate the aqueous layer. The washing may be performed once or more, preferably approximately once to five times, because washing ten times or more does not always produce the full washing effects thereof.

Other methods for removing the acid catalyst include a method using an ion-exchange resin and a method in which the acid catalyst is removed after neutralization with an epoxy compound such as ethylene oxide and propylene oxide. These methods can be appropriately selected in accordance with the acid catalyst used in the reaction.

In this water-washing operation, a part of the thermosetting polysiloxane escapes into the aqueous layer, so that substantially the same effect as fractionation operation is obtained in some cases. Hence, the number of water-washing operations and the amount of washing water may be appropriately selected in view of the catalyst removal effect and the fractionation effect.

In this event, the thermosetting polysiloxane may become unstable by the solvent exchange. This occurs due to incompatibility of the thermosetting polysiloxane with the final solvent. Thus, in order to prevent this phenomenon, a monohydric, dihydric, or polyhydric alcohol having cyclic ether as a substituent as shown in paragraphs (0181) and (0182) of JP 2009-126940 A may be added as a stabilizer. The alcohol may be added in an amount of 0 to 25 parts by mass, preferably 0 to 15 parts by mass, more preferably 0 to 5 parts by mass, based on 100 parts by mass of the thermosetting polysiloxane in the solution before the solvent exchange. When the alcohol is added, the amount is preferably 0.5 parts by mass or more. If necessary, the monohydric, dihydric, or polyhydric alcohol having cyclic ether as a substituent may be added to the solution before the solvent exchange, and then the solvent exchange operation may be performed.

If the thermosetting polysiloxane is concentrated above a certain concentration, the condensation reaction may further progress, so that the thermosetting polysiloxane becomes no longer soluble in an organic solvent. Therefore, it is preferable to maintain the solution state with a proper concentration. Meanwhile, if the concentration is too low, the amount of solvent is excessive. Hence, the solution state with a proper concentration is economical and preferable. The concentration in this state is preferably 0.1 to 20 mass%.

The final solvent added to the thermosetting polysiloxane solution is preferably an alcohol-based organic solvent. Particularly preferable examples include monoalkyl ether derivatives such as ethylene glycol, diethylene glycol, triethylene glycol, propylene glycol, dipropylene glycol, butanediol, and the like. Specifically, preferable examples include butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, diacetone alcohol, and the like.

When these solvents are used as the main component, a non-alcohol-based organic solvent can also be added as an adjuvant solvent. Examples of the adjuvant solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, and the like.

As an alternative reaction operation using an acid catalyst, water or a water-containing organic solvent is added to the monomer or an organic solution of the monomer to initiate the hydrolysis reaction. In this event, the catalyst may be added to the monomer or the organic solution of the monomer, or may be added to the water or the water-containing organic solvent. The reaction temperature may be 0 to 100°C, preferably 10 to 80°C. As a preferable method, when the water is added dropwise, the mixture is heated to 10 to 50°C, and then further heated to 20 to 80°C for aging.

When the organic solvent is used, a water-soluble solvent is preferable. Examples thereof include methanol, ethanol, 1-propanol, 2-propanol, 1-butanol, 2-butanol, and 2-methyl-1-propanol, acetone, tetrahydrofuran, acetonitrile, polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether acetate; mixtures thereof, and the like.

The organic solvent is used in an amount of preferably 0 to 1,000 ml, particularly preferably 0 to 500 ml, relative to 1 mol of the monomer. When the organic solvent is used in a small amount, only a small reaction vessel is required, and this is economical. The obtained reaction mixture may be subjected to posttreatment by the same procedure as described above to obtain a thermosetting polysiloxane.

### (Synthesis Method 2: Alkali Catalyst)

Alternatively, the thermosetting silicon-containing material (Sx: thermosetting polysiloxane) can be produced by hydrolysis condensation of a mixture of one or more hydrolysable monomers (Sm) in the presence of an alkali catalyst. Examples of the alkali catalyst used in this event include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethyl monoethanolamine, monomethyl diethanolamine, triethanolamine, diazabicyclooctane, diazabicyclocyclononene, diazabicycloundecene, hexamethylenetetramine, aniline, N,N-dimethylaniline, pyridine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, calcium hydroxide, and the like. The catalyst can be used in an amount of 1×10⁻⁶ mol to 10 mol, preferably 1×10⁻⁵ mol to 5 mol, more preferably 1×10⁻⁴ mol to 1 mol, relative to 1 mol of the silicon monomer.

When the thermosetting polysiloxane is obtained from the monomer by the hydrolysis condensation, water is preferably added in an amount of 0.1 to 50 mol per mol of the hydrolysable substituent bonded to the monomer. When the amount is 50 mol or less, a device used for the reaction can be made small and economical.

As the operation method, the monomer is added to an aqueous catalyst solution to initiate the hydrolysis condensation reaction. In this event, an organic solvent may be added to the aqueous catalyst solution, or the monomer may be diluted with an organic solvent, or both of these operations may be performed. The reaction temperature may be 0 to 100°C, preferably 5 to 80°C. As a preferable method, when the monomer is added dropwise, the temperature is maintained at 5 to 80°C, and then the mixture is aged at 20 to 80°C.

As the organic solvent which can be added to the aqueous alkali catalyst solution or with which the monomer can be diluted, the same organic solvents as those exemplified as the organic solvents which can be added to the aqueous acid catalyst solution are preferably used. Note that the organic solvent is used in an amount of preferably 0 to 1,000 ml relative to 1 mol of the monomer because the reaction can be performed economically.

Then, if necessary, neutralization reaction of the catalyst is carried out to obtain an aqueous reaction mixture solution. In this event, the amount of an acidic substance usable for the neutralization is preferably 0.1 to 2 equivalents relative to the alkaline substance used as the catalyst. This acidic substance may be any substance as long as it shows acidity in water.

Subsequently, by-products such as alcohol produced by the hydrolysis condensation reaction are preferably removed from the reaction mixture by a procedure such as removal under reduced pressure. In this event, the reaction mixture is heated at a temperature of preferably 0 to 100°C, more preferably 10 to 90°C, further preferably 15 to 80°C, although the temperature depends on the kinds of the added organic solvent and alcohol produced in the reaction. Moreover, the degree of vacuum in this event is preferably atmospheric pressure or less, more preferably 80 kPa or less in absolute pressure, further preferably 50 kPa or less in absolute pressure, although the degree of vacuum varies depending on the kinds of the organic solvent and alcohol to be removed, as well as exhausting equipment, condensation equipment, and heating temperature. In this case, it is difficult to accurately know the amount of alcohol to be removed, but it is desirable to remove about 80 mass% or more of the produced alcohol.

Next, to remove the catalyst used in the hydrolysis condensation, the thermosetting polysiloxane is extracted with an organic solvent. Preferably, the organic solvent used in this event is capable of dissolving the thermosetting polysiloxane, and achieves two-layer separation when mixed with water. Examples of the organic solvent include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, and the like, and mixtures thereof.

Next, to remove the alkali catalyst used in the hydrolysis condensation, the thermosetting polysiloxane is extracted with an organic solvent. Preferably, the organic solvent used in this event is capable of dissolving the thermosetting polysiloxane, and achieves two-layer separation when mixed with water. Further, it is also possible to use a mixture of a water-soluble organic solvent and a slightly-water-soluble organic solvent.

As concrete examples of the organic solvent used for removing the alkali catalyst, it is possible to use the aforementioned organic solvents specifically exemplified for the acid catalyst removal or the same mixture as the mixture of the water-soluble organic solvent and the slightly-water-soluble organic solvent.

Although the mixing ratio of the water-soluble organic solvent and the slightly-water-soluble organic solvent is appropriately selected, the amount of the water-soluble organic solvent may be 0.1 to 1,000 parts by mass, preferably 1 to 500 parts by mass, further preferably 2 to 100 parts by mass, based on 100 parts by mass of the slightly-water-soluble organic solvent.

Subsequently, the thermosetting polysiloxane solution may be washed with neutral water. As the water, what is commonly called deionized water or ultrapure water may be used. The amount of the water may be 0.01 to 100 L, preferably 0.05 to 50 L, more preferably 0.1 to 5 L, relative to 1 L of the thermosetting polysiloxane solution. This washing procedure may be performed by putting both the thermosetting polysiloxane solution and neutral water into the same container, followed by stirring and then leaving to stand to separate the aqueous layer. The washing may be performed once or more, preferably approximately once to five times, because washing ten times or more does not always produce the full washing effects thereof.

To the washed thermosetting polysiloxane solution, a final solvent may be added for solvent exchange under reduced pressure to obtain a desired thermosetting polysiloxane solution. In this event, the temperature during the solvent exchange is preferably 0 to 100°C, more preferably 10 to 90°C, further preferably 15 to 80°C, depending on the kinds of the extraction solvent to be removed. Moreover, the degree of vacuum in this event is preferably atmospheric pressure or less, more preferably 80 kPa or less in absolute pressure, further preferably 50 kPa or less in absolute pressure, although the degree of vacuum varies depending on the kinds of the extraction solvent to be removed, exhausting equipment, condensation equipment, and heating temperature.

The final solvent added to the thermosetting polysiloxane solution is preferably an alcohol-based solvent, particularly preferably a monoalkyl ether, such as ethylene glycol, diethylene glycol, triethylene glycol, etc., or a monoalkyl ether, such as propylene glycol, dipropylene glycol, etc. Specifically, preferable examples of monoalkyl ether include propylene glycol monomethyl ether, ethylene glycol monomethyl ether, propylene glycol monoethyl ether, ethylene glycol monoethyl ether, propylene glycol monopropyl ether, ethylene glycol monopropyl ether, diacetone alcohol, and the like.

The organic solvent usable for the organic solution of the monomer or the water-containing organic solvent is preferably a water-soluble solvent. Examples thereof include methanol, ethanol, 1-propanol, 2-propanol, 1-butanol, 2-butanol, and 2-methyl-1-propanol, acetone, tetrahydrofuran, acetonitrile, polyhydric alcohol condensate derivatives such as propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether acetate; mixtures thereof, and the like.

The molecular weight of the thermosetting polysiloxane obtained by the above synthesis method 1 or 2 can be adjusted not only through the selection of the monomers, but also through reaction condition control during the polymerization, and it is preferable to use the thermosetting polysiloxane having a weight-average molecular weight (Mw) of 100,000 or less, more preferably 200 to 50,000, further preferably 300 to 30,000. When the weight-average molecular weight is 100,000 or less, the generation of foreign matters or coating spots does not occur.

Regarding data on the weight-average molecular weight, the molecular weight is expressed in terms of polystyrene and is obtained by gel permeation chromatography (GPC) using a refractive index (RI) detector, tetrahydrofuran as an eluent, and polystyrene as a reference substance.

The physical properties of the thermosetting polysiloxane used in the present invention vary depending on the kind of acid or alkali catalyst and reaction conditions adopted in the hydrolysis condensation. Therefore, the thermosetting polysiloxane can be selected appropriately in accordance with the target performance of the resist underlayer film.

The thermosetting silicon-containing material (Sx) can be produced from the hydrolysable monomer under conditions using the acid or alkali catalyst. Furthermore, it is possible to use, as a component of a resist underlayer film composition, a polysiloxane derivative produced from a mixture of this monomer with a hydrolysable metal compound shown by the following general formula (Mm) under the conditions using the acid or alkali catalyst.

U(OR⁷)ₘ₇(OR⁸)ₘ₈ (Mm)

In the formula, R⁷ and R⁸ each represent an organic group having 1 to 30 carbon atoms; m7+m8 represents the same number as a valence determined by the kind of U; m7 and m8 each represent an integer of 0 or more; and U represents an element belonging to the group III, IV, or V in the periodic table, except for carbon and silicon.

Examples of the hydrolysable metal compound (Mm) used in this event include the following.

When U is boron, examples of the compound shown by the general formula (Mm) include, as monomers, boron methoxide, boron ethoxide, boron propoxide, boron butoxide, boron amyloxide, boron hexyloxide, boron cyclopentoxide, boron cyclohexyloxide, boron allyloxide, boron phenoxide, boron methoxyethoxide, boric acid, boron oxide, and the like.

When U is aluminum, examples of the compound shown by the general formula (Mm) include, as monomers, aluminum methoxide, aluminum ethoxide, aluminum propoxide, aluminum butoxide, aluminum amyloxide, aluminum hexyloxide, aluminum cyclopentoxide, aluminum cyclohexyloxide, aluminum allyloxide, aluminum phenoxide, aluminum methoxyethoxide, aluminum ethoxyethoxide, aluminum dipropoxy(ethyl acetoacetate), aluminum dibutoxy(ethyl acetoacetate), aluminum propoxy bis(ethyl acetoacetate), aluminum butoxy bis(ethyl acetoacetate), aluminum 2,4-pentanedionate, aluminum 2,2,6,6-tetramethyl-3,5-heptanedionate, and the like.

When U is gallium, examples of the compound shown by the general formula (Mm) include, as monomers, gallium methoxide, gallium ethoxide, gallium propoxide, gallium butoxide, gallium amyloxide, gallium hexyloxide, gallium cyclopentoxide, gallium cyclohexyloxide, gallium allyloxide, gallium phenoxide, gallium methoxyethoxide, gallium ethoxyethoxide, gallium dipropoxy(ethyl acetoacetate), gallium dibutoxy(ethyl acetoacetate), gallium propoxy bis(ethyl acetoacetate), gallium butoxy bis(ethyl acetoacetate), gallium 2,4-pentanedionate, gallium 2,2,6,6-tetramethyl-3,5-heptanedionate, and the like.

When U is yttrium, examples of the compound shown by the general formula (Mm) include, as monomers, yttrium methoxide, yttrium ethoxide, yttrium propoxide, yttrium butoxide, yttrium amyloxide, yttrium hexyloxide, yttrium cyclopentoxide, yttrium cyclohexyloxide, yttrium allyloxide, yttrium phenoxide, yttrium methoxyethoxide, yttrium ethoxyethoxide, yttrium dipropoxy(ethyl acetoacetate), yttrium dibutoxy(ethyl acetoacetate), yttrium propoxy bis(ethyl acetoacetate), yttrium butoxy bis(ethyl acetoacetate), yttrium 2,4-pentanedionate, yttrium 2,2,6,6-tetramethyl-3,5-heptanedionate, and the like.

When U is germanium, examples of the compound shown by the general formula (Mm) include, as monomers, germanium methoxide, germanium ethoxide, germanium propoxide, germanium butoxide, germanium amyloxide, germanium hexyloxide, germanium cyclopentoxide, germanium cyclohexyloxide, germanium allyloxide, germanium phenoxide, germanium methoxyethoxide, germanium ethoxyethoxide, and the like.

When U is titanium, examples of the compound shown by the general formula (Mm) include, as monomers, titanium methoxide, titanium ethoxide, titanium propoxide, titanium butoxide, titanium amyloxide, titanium hexyloxide, titanium cyclopentoxide, titanium cyclohexyloxide, titanium allyloxide, titanium phenoxide, titanium methoxyethoxide, titanium ethoxyethoxide, titanium dipropoxy bis(ethyl acetoacetate), titanium dibutoxy bis(ethyl acetoacetate), titanium dipropoxy bis(2,4-pentanedionate), titanium dibutoxy bis(2,4-pentanedionate), and the like.

When U is hafnium, examples of the compound shown by the general formula (Mm) include, as monomers, hafnium methoxide, hafnium ethoxide, hafnium propoxide, hafnium butoxide, hafnium amyloxide, hafnium hexyloxide, hafnium cyclopentoxide, hafnium cyclohexyloxide, hafnium allyloxide, hafnium phenoxide, hafnium methoxyethoxide, hafnium ethoxyethoxide, hafnium dipropoxy bis(ethyl acetoacetate), hafnium dibutoxy bis(ethyl acetoacetate), hafnium dipropoxy bis(2,4-pentanedionate), hafnium dibutoxy bis(2,4-pentanedionate), and the like.

When U is tin, examples of the compound shown by the general formula (Mm) include, as monomers, methoxy tin, ethoxy tin, propoxy tin, butoxy tin, phenoxy tin, methoxyethoxy tin, ethoxyethoxy tin, tin 2,4-pentanedionate, tin 2,2,6,6-tetramethyl-3,5-heptanedionate, and the like.

When U is arsenic, examples of the compound shown by the general formula (Mm) include, as monomers, methoxy arsenic, ethoxy arsenic, propoxy arsenic, butoxy arsenic, phenoxy arsenic, and the like.

When U is antimony, examples of the compound shown by the general formula (Mm) include, as monomers, methoxy antimony, ethoxy antimony, propoxy antimony, butoxy antimony, phenoxy antimony, antimony acetate, antimony propionate, and the like.

When U is niobium, examples of the compound shown by the general formula (Mm) include, as monomers, methoxy niobium, ethoxy niobium, propoxy niobium, butoxy niobium, phenoxy niobium, and the like.

When U is tantalum, examples of the compound shown by the general formula (Mm) include, as monomers, methoxy tantalum, ethoxy tantalum, propoxy tantalum, butoxy tantalum, phenoxy tantalum, and the like.

When U is bismuth, examples of the compound shown by the general formula (Mm) include, as monomers, methoxy bismuth, ethoxy bismuth, propoxy bismuth, butoxy bismuth, phenoxy bismuth, and the like.

When U is phosphorus, examples of the compound shown by the general formula (Mm) include, as monomers, trimethyl phosphate, triethyl phosphate, tripropyl phosphate, trimethyl phosphite, triethyl phosphite, tripropyl phosphite, diphosphorous pentaoxide, and the like.

When U is vanadium, examples of the compound shown by the general formula (Mm) include, as monomers, vanadium oxide bis(2,4-pentanedionate), vanadium 2,4-pentanedionate, vanadium tributoxide oxide, vanadium tripropoxide oxide, and the like.

When U is zirconium, examples of the compound shown by the general formula (Mm) include, as monomers, methoxy zirconium, ethoxy zirconium, propoxy zirconium, butoxy zirconium, phenoxy zirconium, zirconium dibutoxide bis(2,4-pentanedionate), zirconium dipropoxide bis(2,2,6,6-tetramethyl-3,5-heptanedionate), and the like.

### [Crosslinking Catalyst for Siloxane Polymerization]

The inventive composition for forming a silicon-containing resist underlayer film may contain, in addition to the condensation reaction-type thermosetting silicon-containing material (Sx), a compound represented by the following general formula (Xc). Hereinafter, the compound is also referred to as a crosslinking catalyst for siloxane polymerization or simply as a crosslinking catalyst.

In the present invention, the crosslinking catalyst for siloxane polymerization can be a sulfonium salt, an iodonium salt, a phosphonium salt, an ammonium salt, a polysiloxane having one of these salts as a part of a structure, or an alkaline metal salt.

Examples of the crosslinking catalyst (Xc) for siloxane polymerization include compounds represented by the following general formula (Xc0).

LₐH_{b}A (Xc0)

In the formula, L represents lithium, sodium, potassium, rubidium, cesium, sulfonium, iodonium, phosphonium, or ammonium; A represents a non-nucleophilic counter ion; "a" represents an integer of 1 or more; "b" represents 0 or an integer of 1 or more; and a+b is a valence of the non-nucleophilic counter ion.

Specific examples of (Xc0) include a sulfonium salt of the following general formula (Xc-1), an iodonium salt of the following general formula (Xc-2), a phosphonium salt of the following general formula (Xc-3), an ammonium salt of the following general formula (Xc-4), an alkaline metal salt, and the like.

Examples of the sulfonium salt (Xc-1), the iodonium salt (Xc-2), and the phosphonium salt (Xc-3) include the following.

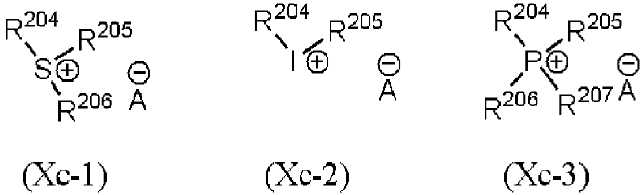

Meanwhile, an example of the ammonium salt (Xc-4) includes the following.

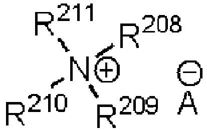

In the formulae, R²⁰⁴, R²⁰⁵, R²⁰⁶, and R²⁰⁷ each represent a linear, branched, or cyclic alkyl group, alkenyl group, oxoalkyl group, or oxoalkenyl group having 1 to 12 carbon atoms, a substituted or unsubstituted aryl group having 6 to 20 carbon atoms, or an aralkyl group or aryloxoalkyl group having 7 to 12 carbon atoms; some or all of the hydrogen atoms of these groups are optionally substituted with an alkoxy group or the like. Additionally, R²⁰⁵ and R²⁰⁶ may form a ring; when a ring is formed, R²⁰⁵ and R²⁰⁶ each represent an alkylene group having 1 to 6 carbon atoms. A⁻ represents a non-nucleophilic counter ion. R²⁰⁸, R²⁰⁹, R²¹⁰, and R²¹¹ are the same as R²⁰⁴, R²⁰⁵, R²⁰⁶, and R²⁰⁷, or may be each a hydrogen atom. R²⁰⁸ and R²⁰⁹, or R²⁰⁸, R²⁰⁹ and R²¹⁰, may form a ring; when a ring is formed, R²⁰⁸ and R²⁰⁹, or R²⁰⁸, R²⁰⁹ and R²¹⁰, represent an alkylene group having 3 to 10 carbon atoms.

R²⁰⁴, R²⁰⁵, R²⁰⁶, R²⁰⁷, R²⁰⁸, R²⁰⁹, R²¹⁰, and R²¹¹ may be identical to or different from one another. Specifically, examples of the alkyl group include a methyl group, an ethyl group, a propyl group, an isopropyl group, an n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methylcyclohexyl group, a cyclohexylmethyl group, a norbornyl group, an adamantyl group, and the like. Examples of the alkenyl group include a vinyl group, an allyl group, a propenyl group, a butenyl group, a hexenyl group, a cyclohexenyl group, and the like. Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, a 2-(4-methylcyclohexyl)-2-oxoethyl group, and the like. Examples of the aryl group include a phenyl group, a naphthyl group, and the like; alkoxyphenyl groups, such as a p-methoxyphenyl group, an m-methoxyphenyl group, an o-methoxyphenyl group, an ethoxyphenyl group, a p-tert-butoxyphenyl group, and an m-tert-butoxyphenyl group; alkylphenyl groups, such as a 2-methylphenyl group, a 3-methylphenyl group, a 4-methylphenyl group, an ethylphenyl group, a 4-tert-butylphenyl group, a 4-butylphenyl group, and a dimethylphenyl group; alkylnaphthyl groups, such as a methylnaphthyl group and an ethylnaphthyl group; alkoxynaphthyl groups, such as a methoxynaphthyl group and an ethoxynaphthyl group; dialkylnaphthyl groups, such as a dimethylnaphthyl group and a diethylnaphthyl group; dialkoxynaphthyl groups, such as a dimethoxynaphthyl group and a diethoxynaphthyl group; and the like. Examples of the aralkyl group include a benzyl group, a phenylethyl group, a phenethyl group, and the like. Examples of the aryloxoalkyl group include 2-aryl-2-oxoethyl groups such as a 2-phenyl-2-oxoethyl group, a 2-(1-naphthyl)-2-oxoethyl group, and a 2-(2-naphthyl)-2-oxoethyl group; and the like.

Examples of the non-nucleophilic counter ion A⁻ include monovalent ions, such as hydroxide ion, formate ion, acetate ion, propionate ion, butanoate ion, pentanoate ion, hexanoate ion, heptanoate ion, octanoate ion, nonanoate ion, decanoate ion, oleate ion, stearate ion, linoleate ion, linolenate ion, benzoate ion, phthalate ion, isophthalate ion, terephthalate ion, salicylate ion, trifluoroacetate ion, monochloroacetate ion, dichloroacetate ion, trichloroacetate ion, fluoride ion, chloride ion, bromide ion, iodide ion, nitrate ion, nitrite ion, chlorate ion, bromate ion, methanesulfonate ion, paratoluenesulfonate ion, and monomethylsulfate ion; monovalent or divalent ions such as oxalate ion, malonate ion, methylmalonate ion, ethylmalonate ion, propylmalonate ion, butylmalonate ion, dimethylmalonate ion, diethylmalonate ion, succinate ion, methylsuccinate ion, glutarate ion, adipate ion, itaconate ion, maleate ion, fumarate ion, citraconate ion, citrate ion, carbonate ion, sulfate ion, and the like.

Examples of the alkaline metal salt include salts of lithium, sodium, potassium, and cesium; monovalent salts, such as hydroxide, formate, acetate, propionate, butanoate, pentanoate, hexanoate, heptanoate, octanoate, nonanoate, decanoate, oleate, stearate, linoleate, linolenate, benzoate, phthalate, isophthalate, terephthalate, salicylate, trifluoroacetate, monochloroacetate, dichloroacetate, and trichloroacetate; monovalent or divalent salts, such as oxalate, malonate, methylmalonate, ethylmalonate, propylmalonate, butylmalonate, dimethylmalonate, diethylmalonate, succinate, methylsuccinate, glutarate, adipate, itaconate, maleate, fumarate, citraconate, citrate, carbonate, and the like.

Specific examples of the sulfonium salt (Xc-1) include triphenylsulfonium formate, triphenylsulfonium acetate, triphenylsulfonium propionate, triphenylsulfonium butanoate, triphenylsulfonium benzoate, triphenylsulfonium phthalate, triphenylsulfonium isophthalate, triphenylsulfonium terephthalate, triphenylsulfonium salicylate, triphenylsulfonium trifluoromethanesulfonate, triphenylsulfonium trifluoroacetate, triphenylsulfonium monochloroacetate, triphenylsulfonium dichloroacetate, triphenylsulfonium trichloroacetate, triphenylsulfonium hydroxide, triphenylsulfonium nitrate, triphenylsulfonium chloride, triphenylsulfonium bromide, triphenylsulfonium oxalate, triphenylsulfonium malonate, triphenylsulfonium methylmalonate, triphenylsulfonium ethylmalonate, triphenylsulfonium propylmalonate, triphenylsulfonium butylmalonate, triphenylsulfonium dimethylmalonate, triphenylsulfonium diethylmalonate, triphenylsulfonium succinate, triphenylsulfonium methylsuccinate, triphenylsulfonium glutarate, triphenylsulfonium adipate, triphenylsulfonium itaconate, triphenylsulfonium maleate, triphenylsulfonium fumarate, triphenylsulfonium citraconate, triphenylsulfonium citrate, triphenylsulfonium carbonate, bistriphenylsulfonium oxalate, bistriphenylsulfonium maleate, bistriphenylsulfonium fumarate, bistriphenylsulfonium citraconate, bistriphenylsulfonium citrate, bistriphenylsulfonium carbonate, and the like.

Specific examples of the iodonium salt (Xc-2) include diphenyliodonium formate, diphenyliodonium acetate, diphenyliodonium propionate, diphenyliodonium butanoate, diphenyliodonium benzoate, diphenyliodonium phthalate, diphenyliodonium isophthalate, diphenyliodonium terephthalate, diphenyliodonium salicylate, diphenyliodonium trifluoromethanesulfonate, diphenyliodonium trifluoroacetate, diphenyliodonium monochloroacetate, diphenyliodonium dichloroacetate, diphenyliodonium trichloroacetate, diphenyliodonium hydroxide, diphenyliodonium nitrate, diphenyliodonium chloride, diphenyliodonium bromide, diphenyliodonium iodide, diphenyliodonium oxalate, diphenyliodonium maleate, diphenyliodonium fumarate, diphenyliodonium citraconate, diphenyliodonium citrate, diphenyliodonium carbonate, bisdiphenyliodonium oxalate, bisdiphenyliodonium maleate, bisdiphenyliodonium fumarate, bisdiphenyliodonium citraconate, bisdiphenyliodonium citrate, bisdiphenyliodonium carbonate, and the like.

Specific examples of the phosphonium salt (Xc-3) include tetraethylphosphonium formate, tetraethylphosphonium acetate, tetraethylphosphonium propionate, tetraethylphosphonium butanoate, tetraethylphosphonium benzoate, tetraethylphosphonium phthalate, tetraethylphosphonium isophthalate, tetraethylphosphonium terephthalate, tetraethylphosphonium salicylate, tetraethylphosphonium trifluoromethanesulfonate, tetraethylphosphonium trifluoroacetate, tetraethylphosphonium monochloroacetate, tetraethylphosphonium dichloroacetate, tetraethylphosphonium trichloroacetate, tetraethylphosphonium hydroxide, tetraethylphosphonium nitrate, tetraethylphosphonium chloride, tetraethylphosphonium bromide, tetraethylphosphonium iodide, tetraethylphosphonium oxalate, tetraethylphosphonium maleate, tetraethylphosphonium fumarate, tetraethylphosphonium citraconate, tetraethylphosphonium citrate, tetraethylphosphonium carbonate, bistetraethylphosphonium oxalate, bistetraethylphosphonium maleate, bistetraethylphosphonium fumarate, bistetraethylphosphonium citraconate, bistetraethylphosphonium citrate, bistetraethylphosphonium carbonate, tetraphenylphosphonium formate, tetraphenylphosphonium acetate, tetraphenylphosphonium propionate, tetraphenylphosphonium butanoate, tetraphenylphosphonium benzoate, tetraphenylphosphonium phthalate, tetraphenylphosphonium isophthalate, tetraphenylphosphonium terephthalate, tetraphenylphosphonium salicylate, tetraphenylphosphonium trifluoromethanesulfonate, tetraphenylphosphonium trifluoroacetate, tetraphenylphosphonium monochloroacetate, tetraphenylphosphonium dichloroacetate, tetraphenylphosphonium trichloroacetate, tetraphenylphosphonium hydroxide, tetraphenylphosphonium nitrate, tetraphenylphosphonium chloride, tetraphenylphosphonium bromide, tetraphenylphosphonium iodide, tetraphenylphosphonium oxalate, tetraphenylphosphonium maleate, tetraphenylphosphonium fumarate, tetraphenylphosphonium citraconate, tetraphenylphosphonium citrate, tetraphenylphosphonium carbonate, bistetraphenylphosphonium oxalate, bistetraphenylphosphonium maleate, bistetraphenylphosphonium fumarate, bistetraphenylphosphonium citraconate, bistetraphenylphosphonium citrate, bistetraphenylphosphonium carbonate, and the like.

Specific examples of the ammonium salt (Xc-4) include tetramethylammonium formate, tetramethylammonium acetate, tetramethylammonium propionate, tetramethylammonium butanoate, tetramethylammonium benzoate, tetramethylammonium phthalate, tetramethylammonium isophthalate, tetramethylammonium terephthalate, tetramethylammonium salicylate, tetramethylammonium trifluoromethanesulfonate, tetramethylammonium trifluoroacetate, tetramethylammonium monochloroacetate, tetramethylammonium dichloroacetate, tetramethylammonium trichloroacetate, tetramethylammonium hydroxide, tetramethylammonium nitrate, tetramethylammonium chloride, tetramethylammonium bromide, tetramethylammonium iodide, tetramethylammonium monomethylsulfate, tetramethylammonium oxalate, tetramethylammonium malonate, tetramethylammonium maleate, tetramethylammonium fumarate, tetramethylammonium citraconate, tetramethylammonium citrate, tetramethylammonium carbonate, bistetramethylammonium oxalate, bistetramethylammonium malonate, bistetramethylammonium maleate, bistetramethylammonium fumarate, bistetramethylammonium citraconate, bistetramethylammonium citrate, bistetramethylammonium carbonate, tetraethylammonium formate, tetraethylammonium acetate, tetraethylammonium propionate, tetraethylammonium butanoate, tetraethylammonium benzoate, tetraethylammonium phthalate, tetraethylammonium isophthalate, tetraethylammonium terephthalate, tetraethylammonium salicylate, tetraethylammonium trifluoromethanesulfonate, tetraethylammonium trifluoroacetate, tetraethylammonium monochloroacetate, tetraethylammonium dichloroacetate, tetraethylammonium trichloroacetate, tetraethylammonium hydroxide, tetraethylammonium nitrate, tetraethylammonium chloride, tetraethylammonium bromide, tetraethylammonium iodide, tetraethylammonium monomethylsulfate, tetraethylammonium oxalate, tetraethylammonium malonate, tetraethylammonium maleate, tetraethylammonium fumarate, tetraethylammonium citraconate, tetraethylammonium citrate, tetraethylammonium carbonate, bistetraethylammonium oxalate, bistetraethylammonium malonate, bistetraethylammonium maleate, bistetraethylammonium fumarate, bistetraethylammonium citraconate, bistetraethylammonium citrate, bistetraethylammonium carbonate, tetrapropylammonium formate, tetrapropylammonium acetate, tetrapropylammonium propionate, tetrapropylammonium butanoate, tetrapropylammonium benzoate, tetrapropylammonium phthalate, tetrapropylammonium isophthalate, tetrapropylammonium terephthalate, tetrapropylammonium salicylate, tetrapropylammonium trifluoromethanesulfonate, tetrapropylammonium trifluoroacetate, tetrapropylammonium monochloroacetate, tetrapropylammonium dichloroacetate, tetrapropylammonium trichloroacetate, tetrapropylammonium hydroxide, tetrapropylammonium nitrate, tetrapropylammonium chloride, tetrapropylammonium bromide, tetrapropylammonium iodide, tetrapropylammonium monomethylsulfate, tetrapropylammonium oxalate, tetrapropylammonium malonate, tetrapropylammonium maleate, tetrapropylammonium fumarate, tetrapropylammonium citraconate, tetrapropylammonium citrate, tetrapropylammonium carbonate, bistetrapropylammonium oxalate, bistetrapropylammonium malonate, bistetrapropylammonium maleate, bistetrapropylammonium fumarate, bistetrapropylammonium citraconate, bistetrapropylammonium citrate, bistetrapropylammonium carbonate, tetrabutylammonium formate, tetrabutylammonium acetate, tetrabutylammonium propionate, tetrabutylammonium butanoate, tetrabutylammonium benzoate, tetrabutylammonium phthalate, tetrabutylammonium isophthalate, tetrabutylammonium terephthalate, tetrabutylammonium salicylate, tetrabutylammonium trifluoromethanesulfonate, tetrabutylammonium trifluoroacetate, tetrabutylammonium monochloroacetate, tetrabutylammonium dichloroacetate, tetrabutylammonium trichloroacetate, tetrabutylammonium hydroxide, tetrabutylammonium nitrate, tetrabutylammonium chloride, tetrabutylammonium bromide, tetrabutylammonium iodide, tetrabutylammonium methanesulfonate, tetrabutylammonium monomethylsulfate, tetrabutylammonium oxalate, tetrabutylammonium malonate, tetrabutylammonium maleate, tetrabutylammonium fumarate, tetrabutylammonium citraconate, tetrabutylammonium citrate, tetrabutylammonium carbonate, bistetrabutylammonium oxalate, bistetrabutylammonium malonate, bistetrabutylammonium maleate, bistetrabutylammonium fumarate, bistetrabutylammonium citraconate, bistetrabutylammonium citrate, bistetrabutylammonium carbonate, trimethylphenylammonium formate, trimethylphenylammonium acetate, trimethylphenylammonium propionate, trimethylphenylammonium butanoate, trimethylphenylammonium benzoate, trimethylphenylammonium phthalate, trimethylphenylammonium isophthalate, trimethylphenylammonium terephthalate, trimethylphenylammonium salicylate, trimethylphenylammonium trifluoromethanesulfonate, trimethylphenylammonium trifluoroacetate, trimethylphenylammonium monochloroacetate, trimethylphenylammonium dichloroacetate, trimethylphenylammonium trichloroacetate, trimethylphenylammonium hydroxide, trimethylphenylammonium nitrate, trimethylphenylammonium chloride, trimethylphenylammonium bromide, trimethylphenylammonium iodide, trimethylphenylammonium methanesulfonate, trimethylphenylammonium monomethylsulfate, trimethylphenylammonium oxalate, trimethylphenylammonium malonate, trimethylphenylammonium maleate, trimethylphenylammonium fumarate, trimethylphenylammonium citraconate, trimethylphenylammonium citrate, trimethylphenylammonium carbonate, bistrimethylphenylammonium oxalate, bistrimethylphenylammonium malonate, bistrimethylphenylammonium maleate, bistrimethylphenylammonium fumarate, bistrimethylphenylammonium citraconate, bistrimethylphenylammonium citrate, bistrimethylphenylammonium carbonate, triethylphenylammonium formate, triethylphenylammonium acetate, triethylphenylammonium propionate, triethylphenylammonium butanoate, triethylphenylammonium benzoate, triethylphenylammonium phthalate, triethylphenylammonium isophthalate, triethylphenylammonium terephthalate, triethylphenylammonium salicylate, triethylphenylammonium trifluoromethanesulfonate, triethylphenylammonium trifluoroacetate, triethylphenylammonium monochloroacetate, triethylphenylammonium dichloroacetate, triethylphenylammonium trichloroacetate, triethylphenylammonium hydroxide, triethylphenylammonium nitrate, triethylphenylammonium chloride, triethylphenylammonium bromide, triethylphenylammonium iodide, triethylphenylammonium methanesulfonate, triethylphenylammonium monomethylsulfate, triethylphenylammonium oxalate, triethylphenylammonium malonate, triethylphenylammonium maleate, triethylphenylammonium fumarate, triethylphenylammonium citraconate, triethylphenylammonium citrate, triethylphenylammonium carbonate, bistriethylphenylammonium oxalate, bistriethylphenylammonium malonate, bistriethylphenylammonium maleate, bistriethylphenylammonium fumarate, bistriethylphenylammonium citraconate, bistriethylphenylammonium citrate, bistriethylphenylammonium carbonate, benzyldimethylphenylammonium formate, benzyldimethylphenylammonium acetate, benzyldimethylphenylammonium propionate, benzyldimethylphenylammonium butanoate, benzyldimethylphenylammonium benzoate, benzyldimethylphenylammonium phthalate, benzyldimethylphenylammonium isophthalate, benzyldimethylphenylammonium terephthalate, benzyldimethylphenylammonium salicylate, benzyldimethylphenylammonium trifluoromethanesulfonate, benzyldimethylphenylammonium trifluoroacetate, benzyldimethylphenylammonium monochloroacetate, benzyldimethylphenylammonium dichloroacetate, benzyldimethylphenylammonium trichloroacetate, benzyldimethylphenylammonium hydroxide, benzyldimethylphenylammonium nitrate, benzyldimethylphenylammonium chloride, benzyldimethylphenylammonium bromide, benzyldimethylphenylammonium iodide, benzyldimethylphenylammonium methanesulfonate, benzyldimethylphenylammonium monomethylsulfate, benzyldimethylphenylammonium oxalate, benzyldimethylphenylammonium malonate, benzyldimethylphenylammonium maleate, benzyldimethylphenylammonium fumarate, benzyldimethylphenylammonium citraconate, benzyldimethylphenylammonium citrate, benzyldimethylphenylammonium carbonate, bisbenzyldimethylphenylammonium oxalate, bisbenzyldimethylphenylammonium malonate, bisbenzyldimethylphenylammonium maleate, bisbenzyldimethylphenylammonium fumarate, bisbenzyldimethylphenylammonium citraconate, bisbenzyldimethylphenylammonium citrate, bisbenzyldimethylphenylammonium carbonate, and the like.

Examples of the alkaline metal salt include lithium formate, lithium acetate, lithium propionate, lithium butanoate, lithium benzoate, lithium phthalate, lithium isophthalate, lithium terephthalate, lithium salicylate, lithium trifluoromethanesulfonate, lithium trifluoroacetate, lithium monochloroacetate, lithium dichloroacetate, lithium trichloroacetate, lithium hydroxide, lithium nitrate, lithium chloride, lithium bromide, lithium iodide, lithium methanesulfonate, lithium hydrogen oxalate, lithium hydrogen malonate, lithium hydrogen maleate, lithium hydrogen fumarate, lithium hydrogen citraconate, lithium hydrogen citrate, lithium hydrogen carbonate, lithium oxalate, lithium malonate, lithium maleate, lithium fumarate, lithium citraconate, lithium citrate, lithium carbonate, sodium formate, sodium acetate, sodium propionate, sodium butanoate, sodium benzoate, sodium phthalate, sodium isophthalate, sodium terephthalate, sodium salicylate, sodium trifluoromethanesulfonate, sodium trifluoroacetate, sodium monochloroacetate, sodium dichloroacetate, sodium trichloroacetate, sodium hydroxide, sodium nitrate, sodium chloride, sodium bromide, sodium iodide, sodium methanesulfonate, sodium hydrogen oxalate, sodium hydrogen malonate, sodium hydrogen maleate, sodium hydrogen fumarate, sodium hydrogen citraconate, sodium hydrogen citrate, sodium hydrogen carbonate, sodium oxalate, sodium malonate, sodium maleate, sodium fumarate, sodium citraconate, sodium citrate, sodium carbonate, potassium formate, potassium acetate, potassium propionate, potassium butanoate, potassium benzoate, potassium phthalate, potassium isophthalate, potassium terephthalate, potassium salicylate, potassium trifluoromethanesulfonate, potassium trifluoroacetate, potassium monochloroacetate, potassium dichloroacetate, potassium trichloroacetate, potassium hydroxide, potassium nitrate, potassium chloride, potassium bromide, potassium iodide, potassium methanesulfonate, potassium hydrogen oxalate, potassium hydrogen malonate, potassium hydrogen maleate, potassium hydrogen fumarate, potassium hydrogen citraconate, potassium hydrogen citrate, potassium hydrogen carbonate, potassium oxalate, potassium malonate, potassium maleate, potassium fumarate, potassium citraconate, potassium citrate, potassium carbonate, and the like.

In the present invention, examples of the curing catalyst (Xc) include thermosetting polysiloxanes (Xc-10) having an ammonium salt, a sulfonium salt, a phosphonium salt, or an iodonium salt as part of the structure.

As a raw material for producing (Xc-10) used here, it is possible to employ a compound represented by the following general formula (Xm):

R^{1A}_{A1}R^{2A}_{A2}^{R3}_{AA3}Si(OR^{0A})_{(4-A1-A2-A3)} (Xm)

In the formula, R^{0A} represents a hydrocarbon group having 1 to 6 carbon atoms; at least one of R^{1A}, R^{2A}, and R^{3A} represents an organic group having the ammonium salt, the sulfonium salt, the phosphonium salt, or the iodonium salt; the other(s) of R^{1A}, R^{2A}, and R^{3A} represent a hydrogen atom or a monovalent organic group having 1 to 30 carbon atoms; and A1, A2, and A3 each represent 0 or 1, given that 1 ≤ A1 + A2 + A3 ≤ 3.

Here, examples of R^{0A} include a methyl group, an ethyl group, an n-propyl group, an iso-propyl group, an n-butyl group, an iso-butyl group, a sec-butyl group, a tert-butyl group, an n-pentyl group, a cyclopentyl group, an n-hexyl group, a cyclohexyl group, and a phenyl group.

An example of Xm includes the following general formula (Xm-1), which shows a hydrolysable silicon compound having a structure partially containing a sulfonium salt:

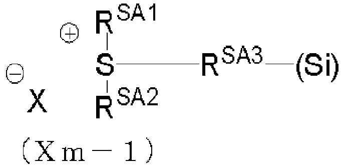

In the formula, R^{SA1} and R^{SA2} each represent a linear, branched, or cyclic alkyl group, alkenyl group, oxoalkyl group, or oxoalkenyl group having 1 to 20 carbon atoms, a substituted or unsubstituted aryl group having 6 to 20 carbon atoms, or an aralkyl group or aryloxyalkyl group having 7 to 20 carbon atoms; and some or all of the hydrogen atoms of these groups are optionally substituted with an alkoxy group, an amino group, an alkylamino group, a halogen atom, or the like. Moreover, R^{SA1} and R^{SA2} may form a ring together with a sulfur atom bonded to R^{SA1} and R^{SA2}; and when a ring is formed, R^{SA1} and R^{SA2} each represent an alkylene group having 1 to 6 carbon atoms. R^{SA3} represents a linear, branched, or cyclic alkylene group or alkenylene group having 1 to 20 carbon atoms, or a substituted or unsubstituted arylene group or aralkylene group having 6 to 20 carbon atoms; and some or all of the hydrogen atoms of these groups are optionally substituted with an alkoxy group, an amino group, an alkylamino group, or the like. R^{SA1}, R^{SA2}, and R^{SA3} may have an oxygen atom or a nitrogen atom in the chain or ring thereof.

In the general formula (Xm-1), (Si) shows an attachment point to Si.

Examples of X⁻ include hydroxide ion, formate ion, acetate ion, propionate ion, butanoate ion, pentanoate ion, hexanoate ion, heptanoate ion, octanoate ion, nonanoate ion, decanoate ion, oleate ion, stearate ion, linoleate ion, linolenate ion, benzoate ion, p-methylbenzoate ion, p-t-butylbenzoate ion, phthalate ion, isophthalate ion, terephthalate ion, salicylate ion, trifluoroacetate ion, monochloroacetate ion, dichloroacetate ion, trichloroacetate ion, nitrate ion, chlorate ion, perchlorate ion, bromate ion, iodate ion, oxalate ion, malonate ion, methylmalonate ion, ethylmalonate ion, propylmalonate ion, butylmalonate ion, dimethylmalonate ion, diethylmalonate ion, succinate ion, methylsuccinate ion, glutarate ion, adipate ion, itaconate ion, maleate ion, fumarate ion, citraconate ion, citrate ion, carbonate ion, and the like.

Specific examples of the cation moiety of the compound represented by the general formula (Xm-1) include the following ions. X⁻ is as defined above.

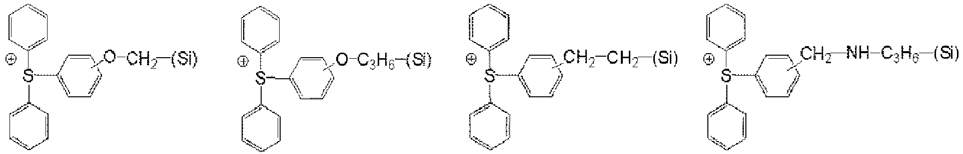

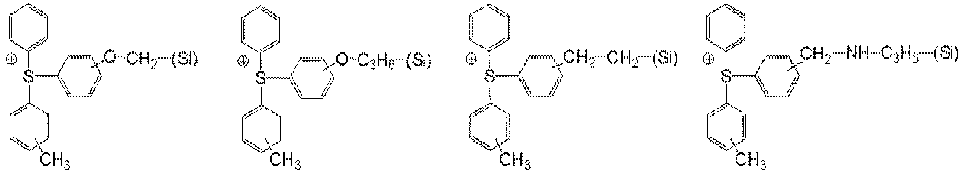

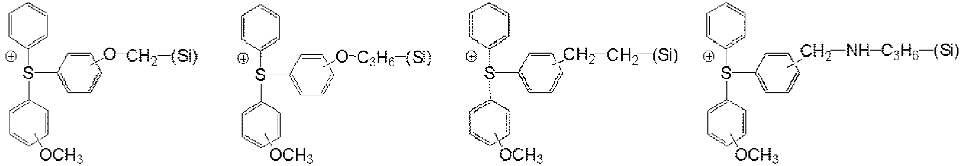

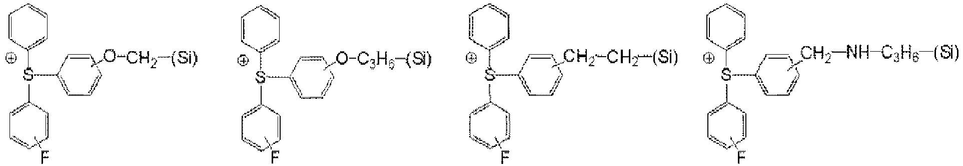

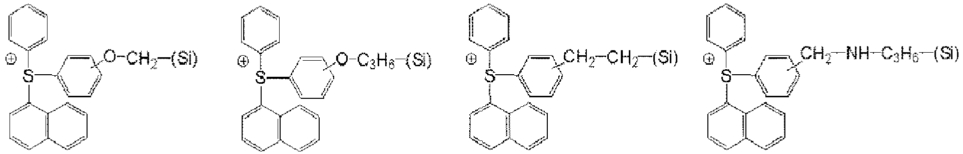

For example, a hydrolysable silicon compound having a structure partially containing an iodonium salt can be shown by the following general formula (Xm-2):

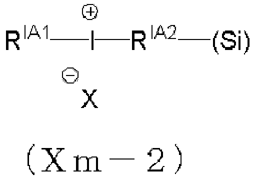

In the formula, R^{IA1} represents a linear, branched, or cyclic alkyl group, alkenyl group, oxoalkyl group, or oxoalkenyl group having 1 to 20 carbon atoms, a substituted or unsubstituted aryl group having 6 to 20 carbon atoms, or an aralkyl group or an aryloxoalkyl group having 7 to 20 carbon atoms; some or all of the hydrogen atoms of this group are optionally substituted with an alkoxy group, an amino group, an alkylamino group, a halogen atom, or the like. Moreover, R^{IA1} and R^{IA2} may form a ring together with an iodine atom bonded to R^{IA1} and R^{IA2}; and when a ring is formed, R^{IA1} and R^{IA2} each represent an alkylene group having 1 to 6 carbon atoms. R^{IA2} represents a linear, branched, or cyclic alkylene group or alkenylene group having 1 to 20 carbon atoms, or a substituted or unsubstituted arylene group or aralkylene group having 6 to 20 carbon atoms; and some or all of the hydrogen atoms of these groups are optionally substituted with an alkoxy group, an amino group, an alkylamino group, or the like. R^{IA1} and R^{IA2} may have an oxygen atom or nitrogen atom in the chain or ring thereof.

Note that in the general formula (Xm-2), (Si) shows an attachment point to Si. X⁻ is as defined above.

Specific examples of the cation moiety of the compound represented by the general formula (Xm-2) include the following ions. X⁻ is as defined above.

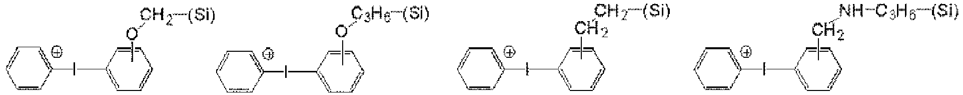

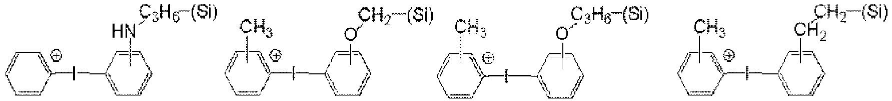

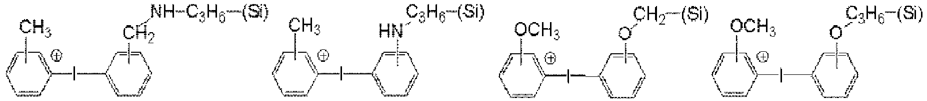

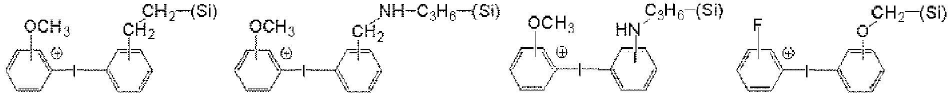

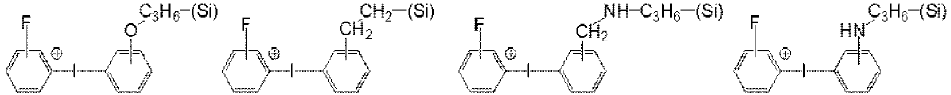

For example, a hydrolysable silicon compound having a structure partially containing a phosphonium salt can be shown by the following general formula (Xm-3):

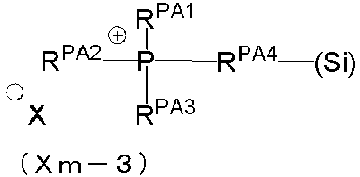

In the formula, R^{PA1}, R^{PA2}, and R^{PA3} each represent a linear, branched, or cyclic alkyl group, alkenyl group, oxoalkyl group, or oxoalkenyl group having 1 to 20 carbon atoms, a substituted or unsubstituted aryl group having 6 to 20 carbon atoms, or an aralkyl group or an aryloxoalkyl group having 7 to 20 carbon atoms; and part or all of the hydrogen atoms of these groups are optionally substituted with an alkoxy group, an amino group, an alkylamino group, a halogen atom, or the like. Moreover, R^{PA1} and R^{PA2} may form a ring together with a phosphorus atom bonded to R^{PA1} and R^{PA2}; and when a ring is formed, R^{PA1} and R^{PA2} each represent an alkylene group having 1 to 6 carbon atoms. R^{PA4} represents a linear, branched, or cyclic alkylene group or alkenylene group having 1 to 20 carbon atoms, or a substituted or unsubstituted arylene group or aralkylene group having 6 to 20 carbon atoms; and part or all of the hydrogen atoms of these groups are optionally substituted with an alkoxy group, an amino group, an alkylamino group, or the like. R^{PA1} to R^{PA4} may have an oxygen atom or nitrogen atom in the chain or ring thereof.

Note that in the general formula (Xm-3), (Si) shows an attachment point to Si. X⁻ is as defined above.

Specific examples of the cation moiety of the compound represented by the general formula (Xm-3) include the following ions. X⁻ is as defined above.

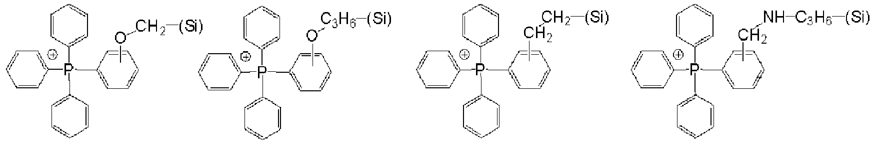

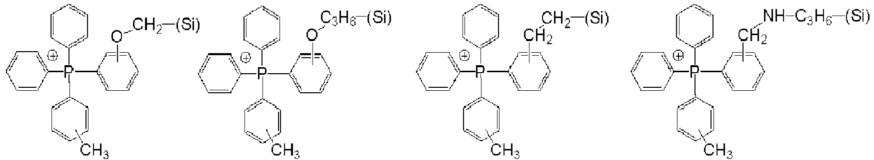

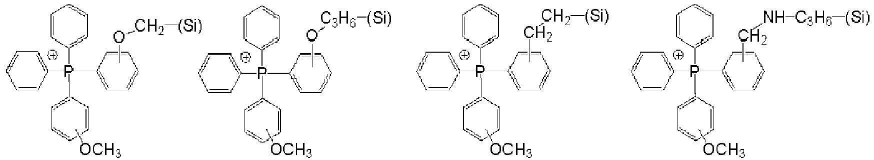

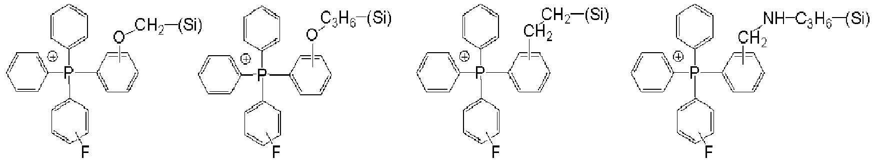

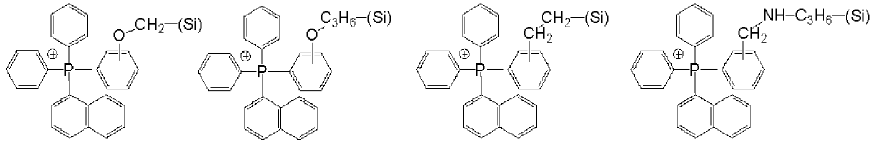

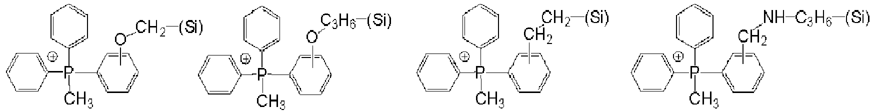

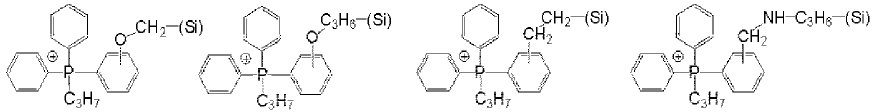

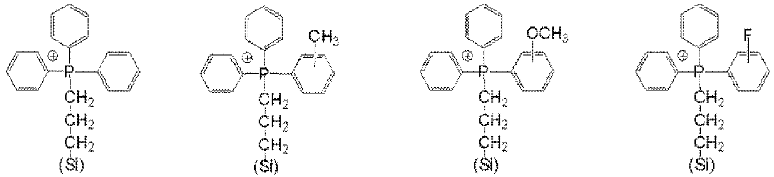

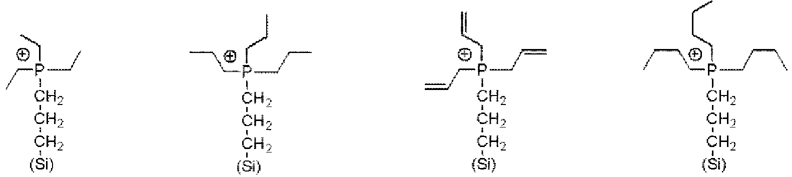

For example, a hydrolysable silicon compound having a structure partially containing an ammonium salt can be shown by the following general formula (Xm-4):

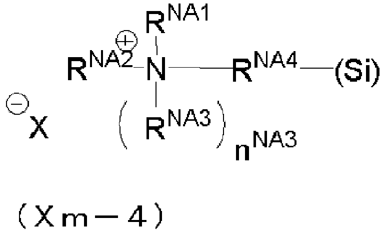

In the formula, R^{NA1}, R^{NA2}, and R^{NA3} each represent a hydrogen atom or a monovalent organic group, such as a linear, branched, or cyclic alkyl group, alkenyl group, oxoalkyl group, or oxoalkenyl group having 1 to 20 carbon atoms, a substituted or unsubstituted aryl group having 6 to 20 carbon atoms, or an aralkyl group or aryloxyalkyl group having 7 to 20 carbon atoms; and some or all of the hydrogen atoms of these groups are optionally substituted with an alkoxy group, an amino group, an alkylamino group, or the like. Moreover, R^{NA1} and R^{NA2} may form a ring together with a nitrogen atom bonded to R^{NA1} and R^{NA2}; and when a ring is formed, R^{NA1} and R^{NA2} each represent an alkylene group having 1 to 6 carbon atoms or a cyclic heterocyclic ring or heteroaromatic ring containing nitrogen. R^{NA4} represents a divalent organic group, such as a linear, branched, or cyclic alkylene group or alkenylene group having 1 to 23 carbon atoms, or a substituted or unsubstituted arylene group having 6 to 29 carbon atoms; and some or all of the hydrogen atoms of these groups are optionally substituted with an alkoxy group, an amino group, an alkylamino group, or the like. In the case where R^{NA1} and R^{NA2}, or R^{NA1} and R^{NA4}, form a cyclic structure which further contains unsaturated nitrogen, n^{NA3}=0; in the other cases, n^{NA3}=1.

Note that in the general formula (Xm-4), (Si) shows an attachment point to Si. X⁻ is as defined above.

Specific examples of the cation moiety of the compound represented by the general formula (Xm-4) include the following ions. X⁻ is as defined above.

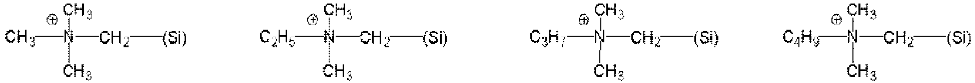

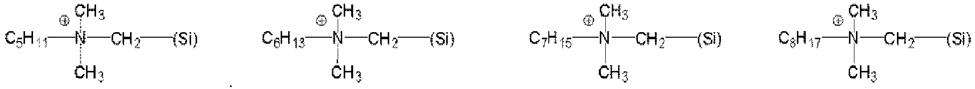

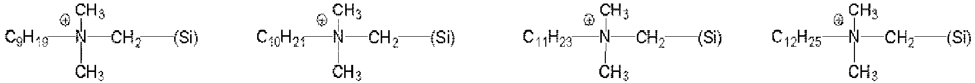

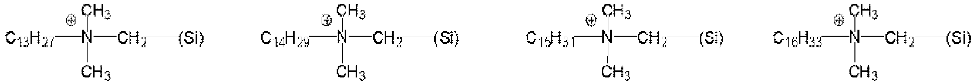

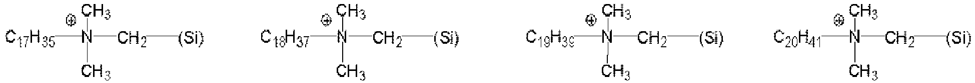

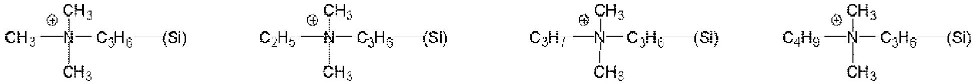

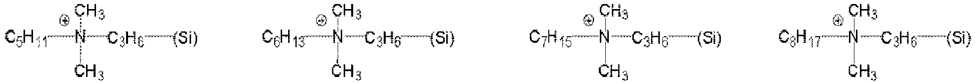

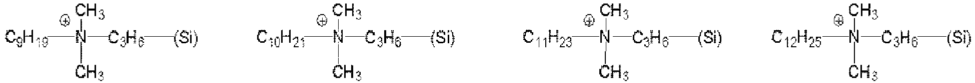

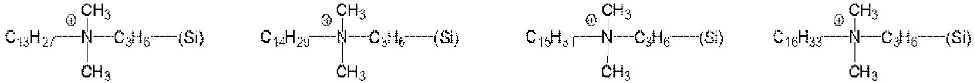

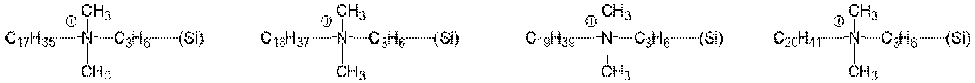

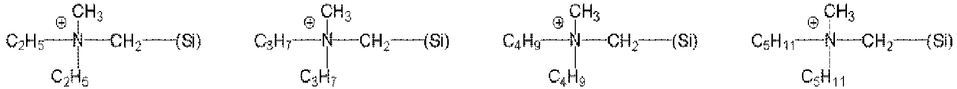

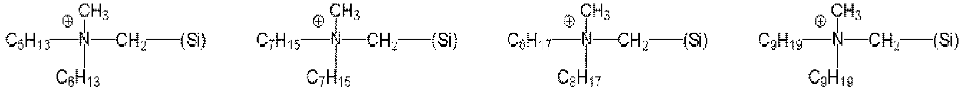

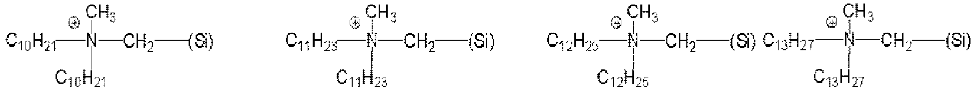

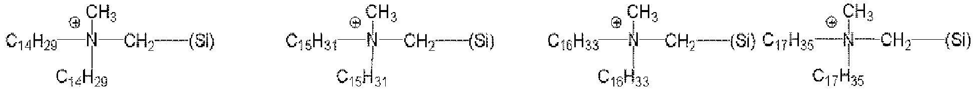

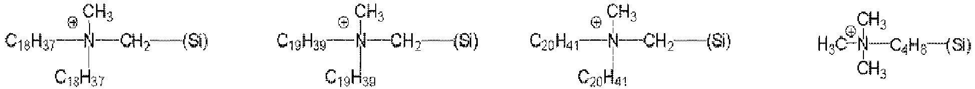

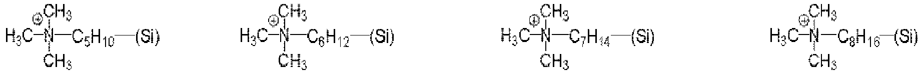

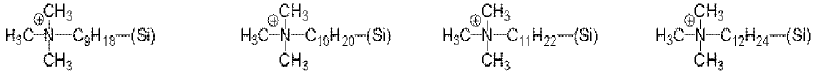

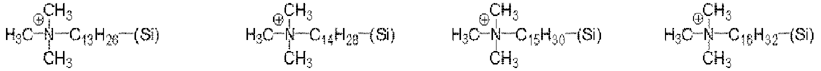

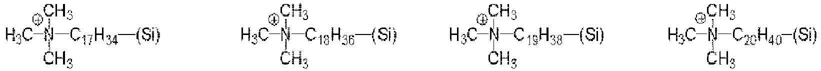

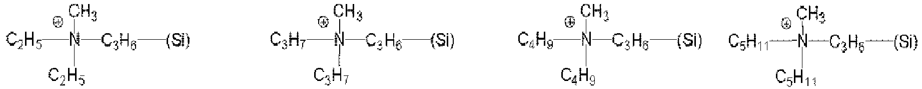

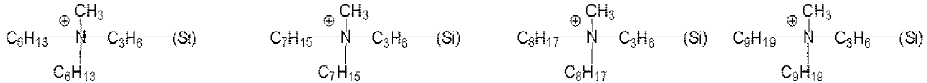

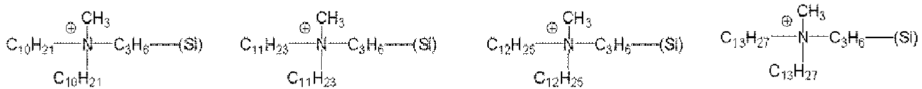

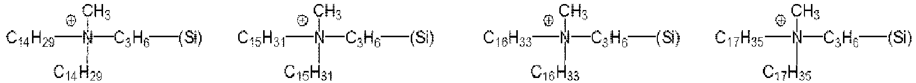

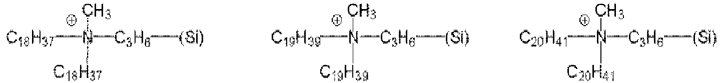

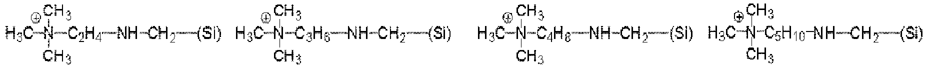

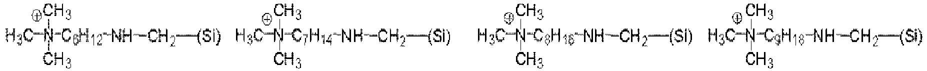

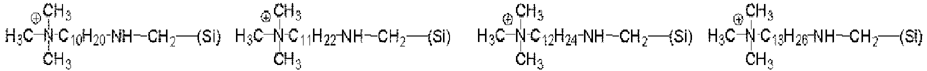

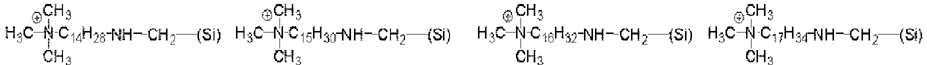

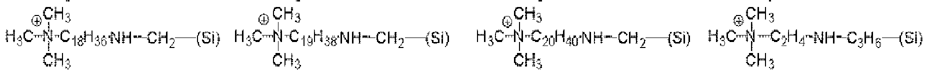

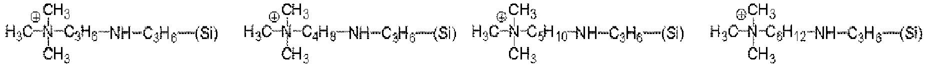

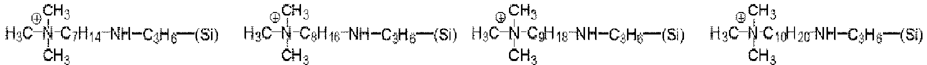

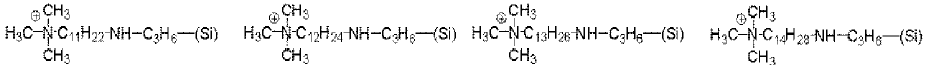

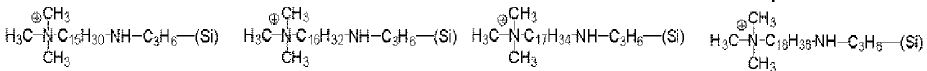

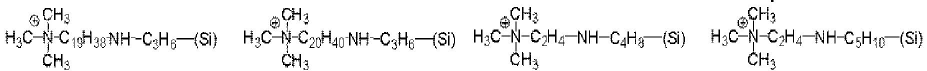

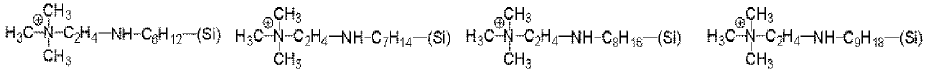

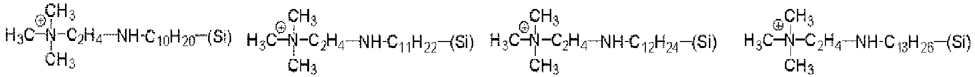

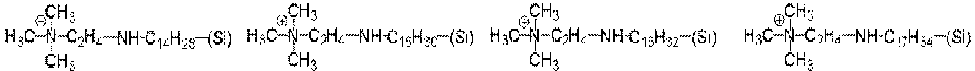

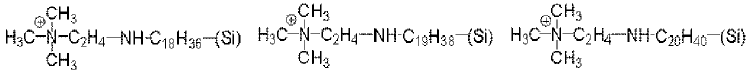

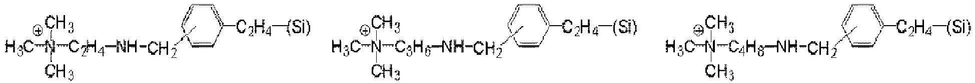

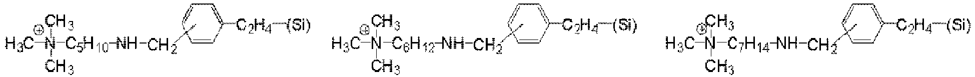

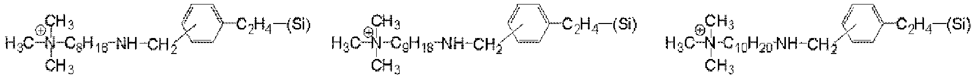

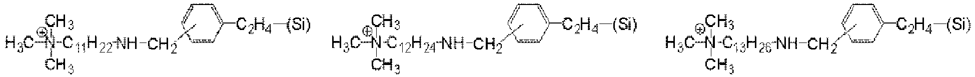

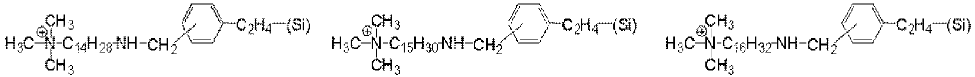

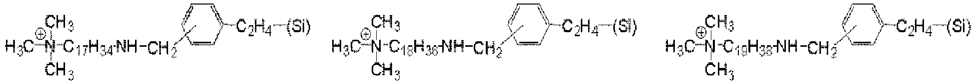

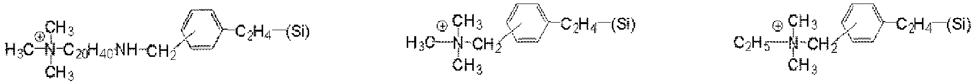

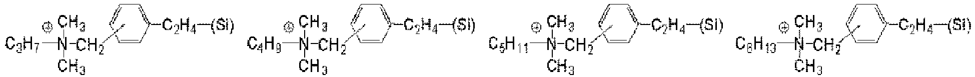

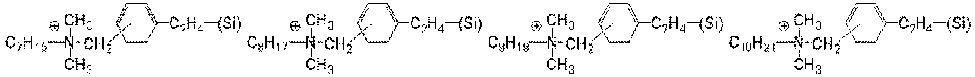

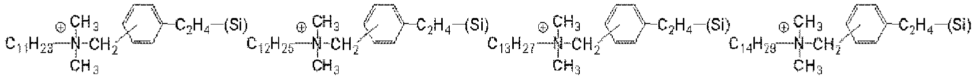

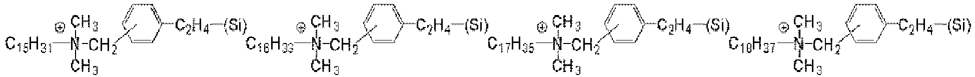

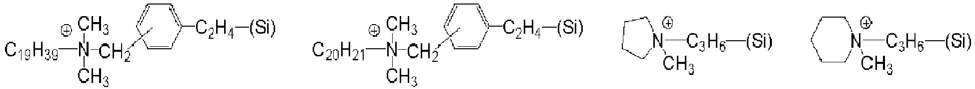

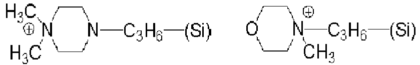

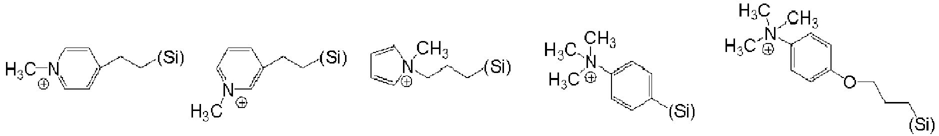

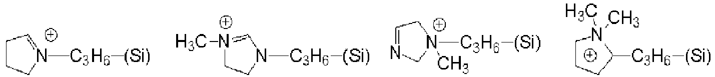

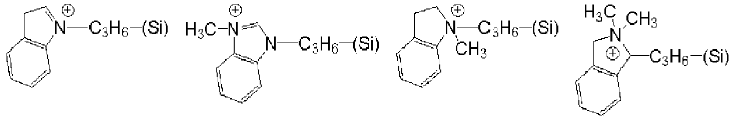

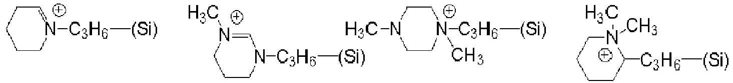

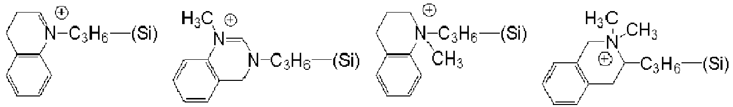

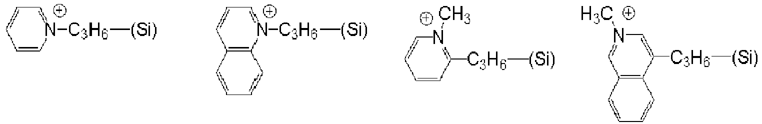

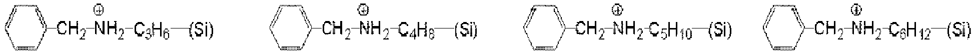

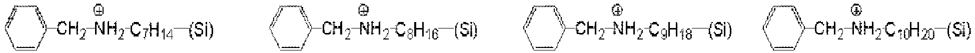

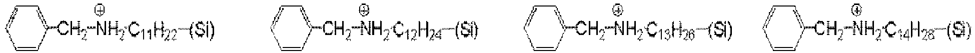

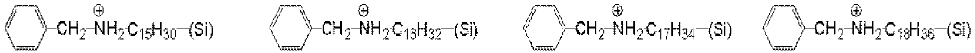

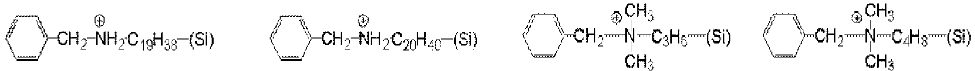

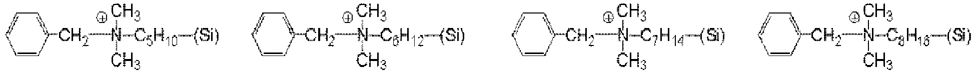

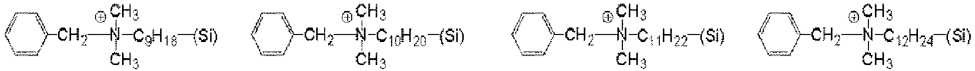

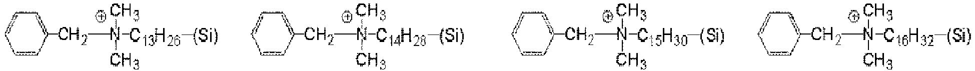

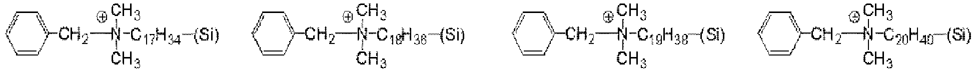

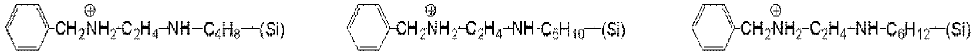

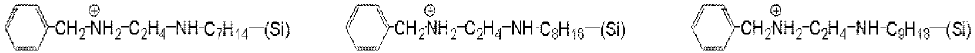

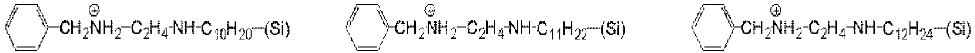

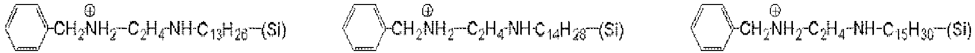

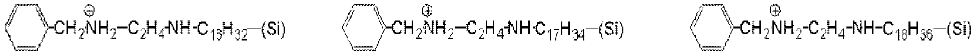

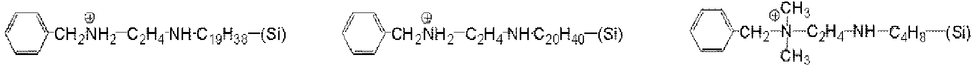

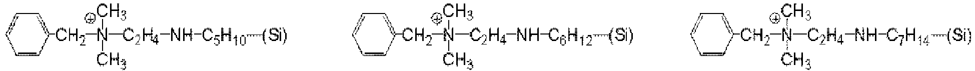

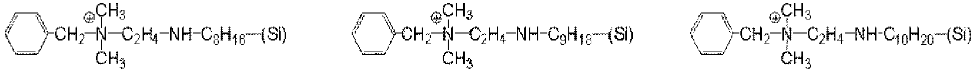

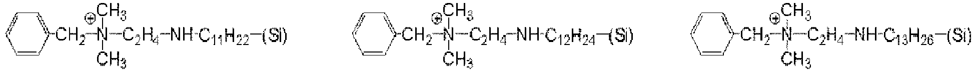

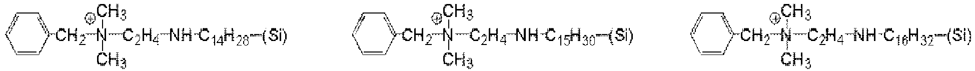

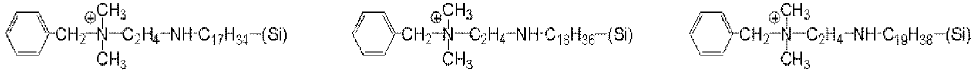

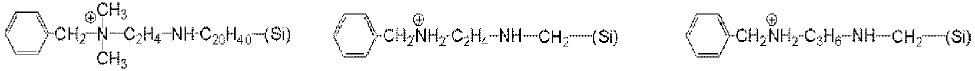

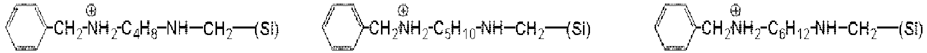

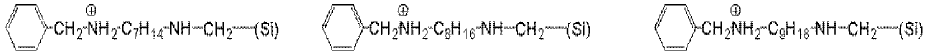

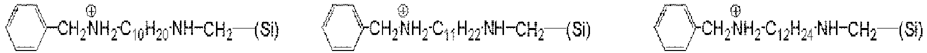

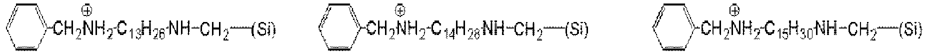

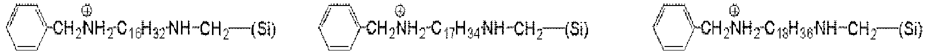

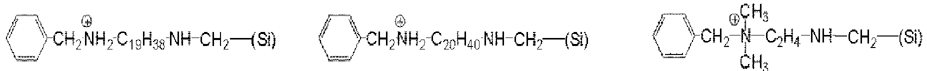

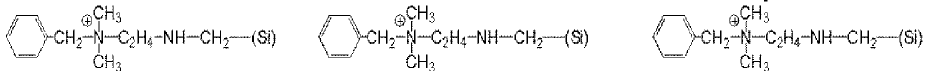

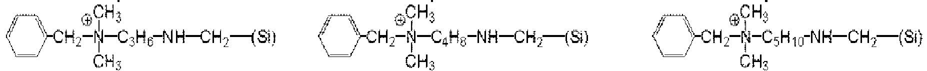

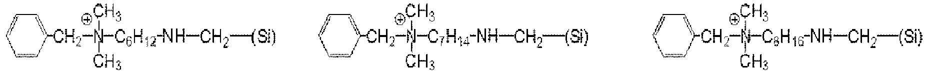

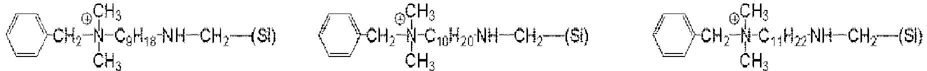

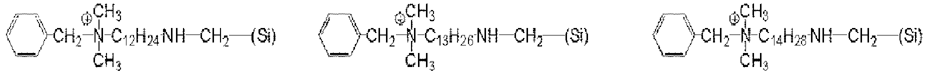

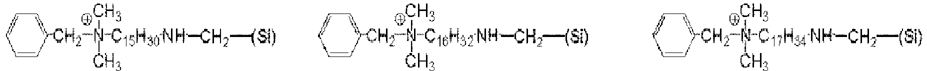

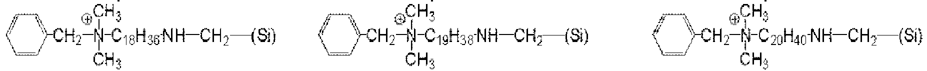

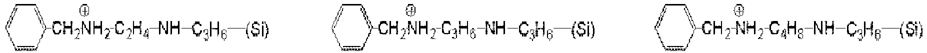

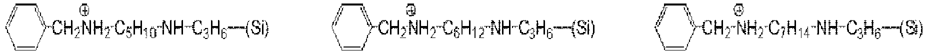

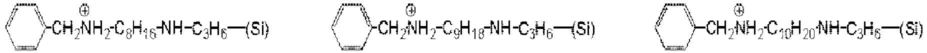

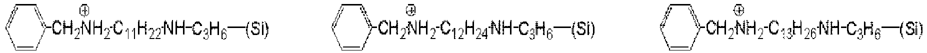

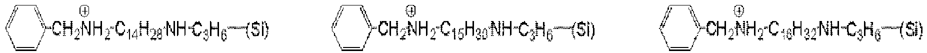

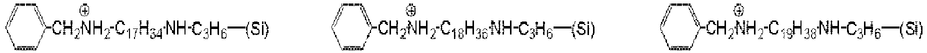

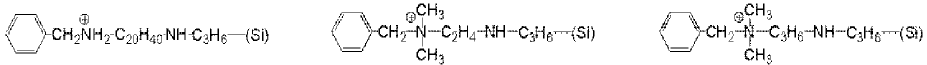

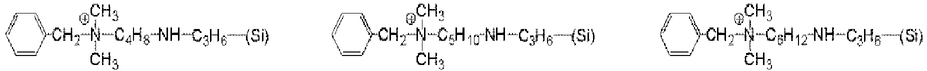

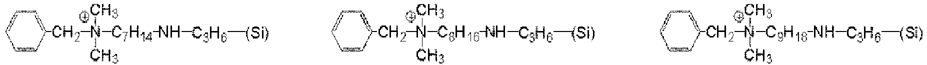

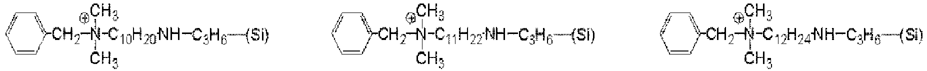

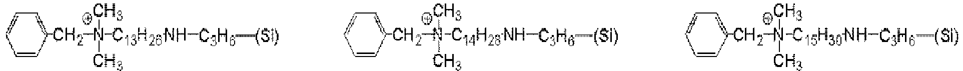

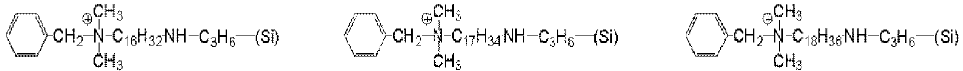

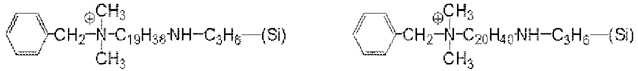

### (Organic Solvent)

The inventive composition for forming a silicon-containing resist underlayer film can contain a solvent. An alcohol-based organic solvent is desirable as the solvent, and preferable solvents include monoalkyl ether derivatives such as ethylene glycol, diethylene glycol, triethylene glycol, propylene glycol, dipropylene glycol, butanediol, and the like. Specifically, preferable solvents include butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, and the like.

When these solvents are used as the main component, a non-alcohol-based organic solvent can also be added as an adjuvant solvent. Examples of the adjuvant solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, and the like.

### (Water)

Water may be contained in the inventive composition for forming a silicon-containing resist underlayer film. When water is contained, the polysiloxane compound in the composition is hydrated, so that the lithography performance is improved. The water content in the solvent component of the inventive composition for forming a silicon-containing resist underlayer film is preferably more than 0 mass% and less than 50 mass%, more preferably 0.3 to 30 mass%, and further preferably 0.5 to 20 mass%. When the water content is less than 50 mass%, the silicon-containing resist underlayer film can achieve favorable uniformity, and repellence can be suppressed.

### (High-Boiling-Point Solvent)

Furthermore, a high-boiling-point solvent having a boiling point of 180°C or higher can also be contained in the inventive composition for forming a silicon-containing resist underlayer film as necessary. Examples of the high-boiling-point solvent include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, gamma-butyrolactone, tripropylene glycol monomethyl ether, diacetone alcohol, n-nonyl acetate, ethylene glycol monoethyl ether acetate, 1,2-diacetoxyethane, 1-acetoxy-2-methoxyethane, 1,2-diacetoxypropane, diethylene glycol monomethyl ether acetate, diethylene glycol monoethyl ether acetate, diethylene glycol mono-n-butyl ether acetate, propylene glycol monomethyl ether acetate, propylene glycol monopropyl ether acetate, propylene glycol monobutyl ether acetate, dipropylene glycol monomethyl ether acetate, dipropylene glycol monoethyl ether acetate, and the like.

The solvent including water is used in a total amount of preferably 100 to 100,000 parts by mass, particularly preferably 200 to 50,000 parts by mass, based on 100 parts by mass of the polysiloxane compound, which is the base polymer.

### [Other Components]

### (Organic Acid)

To improve the stability of the inventive composition for forming a silicon-containing resist underlayer film, it is preferable to add a monovalent, divalent, or more polyvalent organic acid having 1 to 30 carbon atoms. Examples of the acid added in this event include formic acid, acetic acid, propionic acid, butanoic acid, pentanoic acid, hexanoic acid, heptanoic acid, octanoic acid, nonanoic acid, decanoic acid, oleic acid, stearic acid, linoleic acid, linolenic acid, benzoic acid, phthalic acid, isophthalic acid, terephthalic acid, salicylic acid, trifluoroacetic acid, monochloroacetic acid, dichloroacetic acid, trichloroacetic acid, oxalic acid, malonic acid, methylmalonic acid, ethylmalonic acid, propylmalonic acid, butylmalonic acid, dimethylmalonic acid, diethylmalonic acid, succinic acid, methylsuccinic acid, glutaric acid, adipic acid, itaconic acid, maleic acid, fumaric acid, citraconic acid, citric acid, and the like. Particularly, oxalic acid, maleic acid, formic acid, acetic acid, propionic acid, citric acid, and the like are preferable. Moreover, a mixture of two or more acids may be used to keep the stability. The amount of the acid to be added may be 0.001 to 25 parts by mass, preferably 0.01 to 15 parts by mass, more preferably 0.1 to 5 parts by mass, based on 100 parts by mass of the silicon contained in the composition.

### (Photo-Acid Generator)

In the present invention, a photo-acid generator may be added to the composition. As the photo-acid generator used in the present invention, it is possible to add, specifically, the materials described in paragraphs (0160) to (0179) of JP 2009-126940 A.

Besides, the present invention composition may contain one or more compounds (photo-acid generators), each of which has an anion moiety and a cation moiety in one molecule, shown by the following general formula (P-0) :

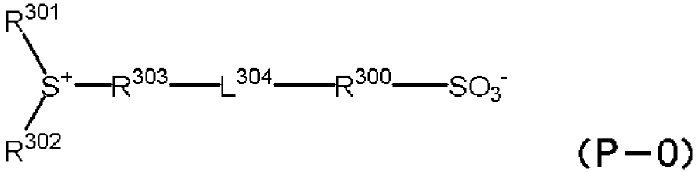

Here, R³⁰⁰ represents a divalent organic group substituted with one or more fluorine atoms; R³⁰¹ and R³⁰² each independently represent a linear, branched, or cyclic monovalent hydrocarbon group having 1 to 20 carbon atoms optionally substituted with a heteroatom or optionally containing an intervening heteroatom. R³⁰³ represents a linear, branched, or cyclic divalent hydrocarbon group having 1 to 20 carbon atoms optionally substituted with a heteroatom or optionally containing an intervening heteroatom. Moreover, R³⁰¹ and R³⁰², or R³⁰¹ and R³⁰³, are optionally bonded to each other to form a ring with a sulfur atom in the formula. L³⁰⁴ represents a single bond or a linear, branched, or cyclic divalent hydrocarbon group having 1 to 20 carbon atoms optionally substituted with a heteroatom or optionally containing an intervening heteroatom.

When such a compound (photo-acid generator) is combined with the thermosetting silicon-containing material of the present invention, it is possible to obtain a resist underlayer film that can contribute to the formation of an upper layer resist having a rectangular cross section while maintaining the LWR of the upper layer resist.

In the general formula (P-0), R³⁰⁰ is a divalent organic group having one or more fluorine atoms as a result of substitution. The divalent organic group represents, for example, a linear, branched, or cyclic divalent hydrocarbon group, such as an alkylene group, an alkenylene group, and an arylene group having 1 to 20 carbon atoms. Specific examples of R³⁰⁰ include ones having the following structures.

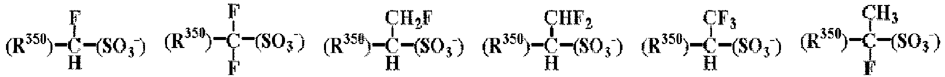

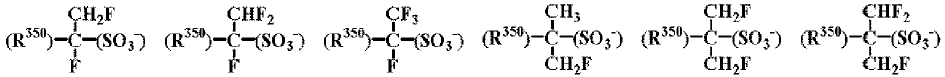

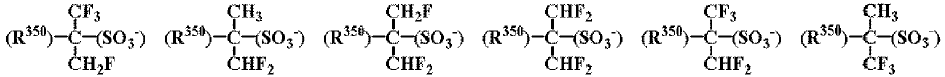

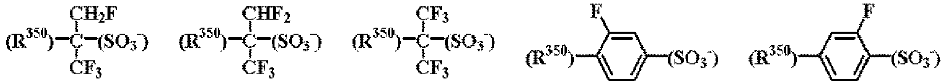

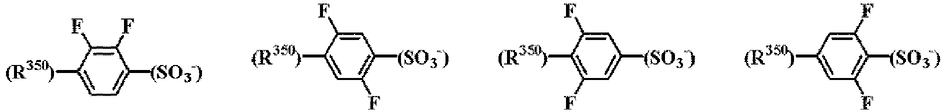

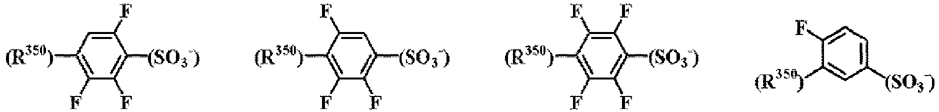

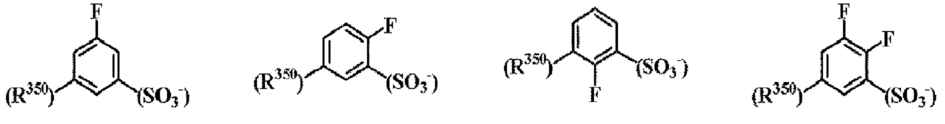

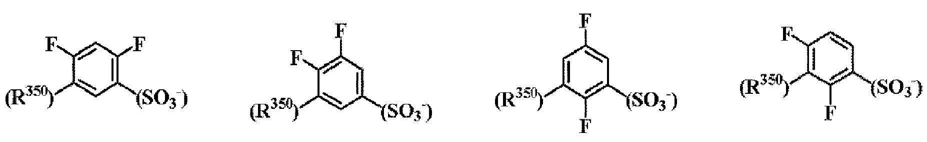

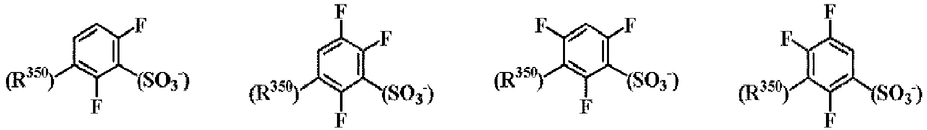

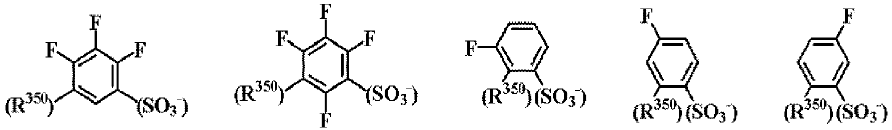

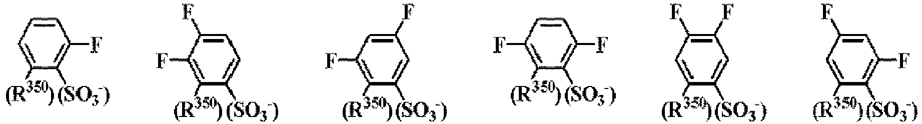

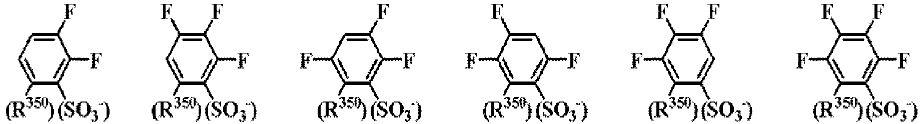

Note that, in the above formulae, (SO₃⁻) is depicted to show a bonding site to the SO₃⁻ group in the general formula (P-0). Moreover, (R³⁵⁰) is depicted to show a bonding site to a portion where the cation moiety in the general formula (P-0) bonds to R³⁰⁰ via L³⁰⁴.

R³⁰¹ and R³⁰² each independently represent a linear, branched, or cyclic monovalent hydrocarbon group, such as an alkyl group, an alkenyl group, an aryl group, or an aralkyl group having 1 to 20 carbon atoms optionally substituted with a heteroatom or optionally containing an intervening heteroatom. Examples of the alkyl group include a methyl group, an ethyl group, a propyl group, an isopropyl group, an n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methylcyclohexyl group, a cyclohexylmethyl group, a norbornyl group, an adamantyl group, and the like. Examples of the alkenyl group include a vinyl group, an allyl group, a propenyl group, a butenyl group, a hexenyl group, a cyclohexenyl group, and the like. Examples of the oxoalkyl group include a 2-oxocyclopentyl group, a 2-oxocyclohexyl group, a 2-oxopropyl group, a 2-oxoethyl group, a 2-cyclopentyl-2-oxoethyl group, a 2-cyclohexyl-2-oxoethyl group, a 2-(4-methylcyclohexyl)-2-oxoethyl group, and the like. Examples of the aryl group include a phenyl group, a naphthyl group, a thienyl group, and the like; a 4-hydroxyphenyl group; alkoxyphenyl groups, such as a 4-methoxyphenyl group, a 3-methoxyphenyl group, a 2-methoxyphenyl group, a 4-ethoxyphenyl group, a 4-tert-butoxyphenyl group, and a 3-tert-butoxyphenyl group; alkylphenyl groups, such as a 2-methylphenyl group, a 3-methylphenyl group, a 4-methylphenyl group, a 4-ethylphenyl group, a 4-tert-butylphenyl group, a 4-n-butylphenyl group, and a 2,4-dimethylphenyl group; alkylnaphthyl groups, such as a methylnaphthyl group and an ethylnaphthyl group; alkoxynaphthyl groups, such as a methoxynaphthyl group, an ethoxynaphthyl group, an n-propoxynaphthyl group, and an n-butoxynaphthyl group; dialkylnaphthyl groups, such as a dimethylnaphthyl group and a diethylnaphthyl group; dialkoxynaphthyl groups, such as a dimethoxynaphthyl group and a diethoxynaphthyl group; and the like. Examples of the aralkyl group include a benzyl group, a 1-phenylethyl group, a 2-phenylethyl group, and the like. Examples of the aryloxoalkyl group include 2-aryl-2-oxoethyl groups such as a 2-phenyl-2-oxoethyl group, a 2-(1-naphthyl)-2-oxoethyl group, and a 2-(2-naphthyl)-2-oxoethyl group; and the like. Additionally, R³⁰¹ and R³⁰² may be bonded to each other to form a ring together with the sulfur atom in the formula; in this case, examples of the ring include groups shown by the following formulae.

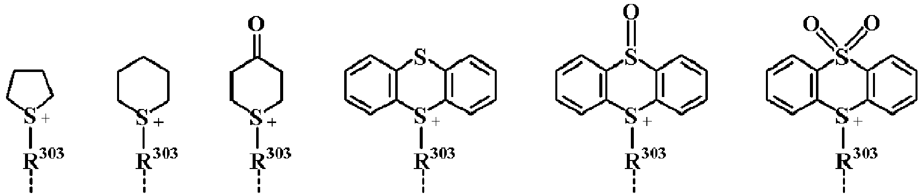

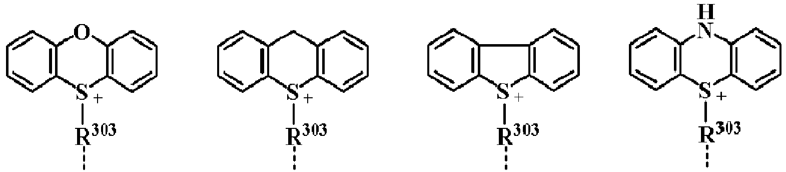

A broken line represents a bond.

In the general formula (P-0), R³⁰³ represents a linear, branched, or cyclic divalent hydrocarbon group having 1 to 20 carbon atoms optionally substituted with a heteroatom or optionally containing an intervening heteroatom. Specific examples of R³⁰³ include linear alkanediyl groups, such as a methylene group, an ethylene group, a propane-1,3-diyl group, a butane-1,4-diyl group, a pentane-1,5-diyl group, a hexane-1,6-diyl group, a heptane-1,7-diyl group, an octane-1,8-diyl group, a nonane-1,9-diyl group, a decane-1,10-diyl group, an undecane-1,11-diyl group, a dodecane-1,12-diyl group, a tridecane-1,13-diyl group, a tetradecane-1,14-diyl group, a pentadecane-1,15-diyl group, a hexadecane-1,16-diyl group, and a heptadecane-1,17-diyl group; saturated cyclic hydrocarbon groups, such as a cyclopentanediyl group, a cyclohexanediyl group, a norbornanediyl group, and an adamantanediyl group; and unsaturated cyclic hydrocarbon groups such as a phenylene group and a naphthylene group. Additionally, some of the hydrogen atoms of these groups may be substituted with an alkyl group such as a methyl group, an ethyl group, a propyl group, an n-butyl group, and a tert-butyl group. Alternatively, such hydrogen atoms may be substituted with a heteroatom such as an oxygen atom, a sulfur atom, a nitrogen atom, and a halogen atom. As a result, a hydroxy group, a cyano group, a carbonyl group, an ether bond, an ester bond, a sulfonic acid ester bond, a carbonate bond, a lactone ring, a sultone ring, carboxylic anhydride, a haloalkyl group, or the like may be formed. Further, R³⁰¹ and R³⁰³ may be bonded to each other to form a ring together with the sulfur atom in the formula; in this case, examples of the ring include groups shown by the following formulae.

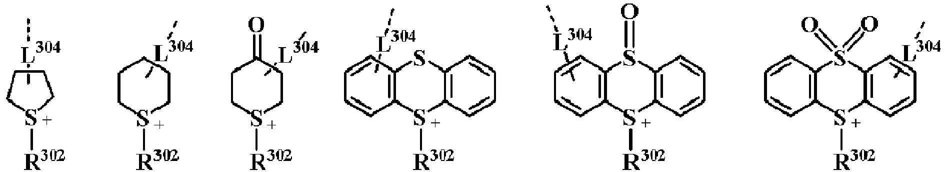

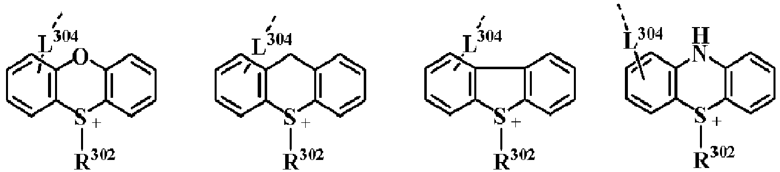

A broken line represents a bond.

In the general formula (P-0), L³⁰⁴ represents a single bond or a linear, branched, or cyclic divalent hydrocarbon group having 1 to 20 carbon atoms optionally substituted with a heteroatom or optionally containing an intervening heteroatom. Specific examples of L³⁰⁴ include linear alkanediyl groups, such as a methylene group, an ethylene group, a propane-1,3-diyl group, a butane-1,4-diyl group, a pentane-1,5-diyl group, a hexane-1,6-diyl group, a heptane-1,7-diyl group, an octane-1,8-diyl group, a nonane-1,9-diyl group, a decane-1,10-diyl group, an undecane-1,11-diyl group, a dodecane-1,12-diyl group, a tridecane-1,13-diyl group, a tetradecane-1,14-diyl group, a pentadecane-1,15-diyl group, a hexadecane-1,16-diyl group, and a heptadecane-1,17-diyl group; saturated cyclic hydrocarbon groups, such as a cyclopentanediyl group, a cyclohexanediyl group, a norbornanediyl group, and an adamantanediyl group; and unsaturated cyclic hydrocarbon groups such as a phenylene group and a naphthylene group. Additionally, some of the hydrogen atoms of these groups may be substituted with an alkyl group such as a methyl group, an ethyl group, a propyl group, an n-butyl group, and a tert-butyl group. Alternatively, such hydrogen atoms may be substituted with a heteroatom such as an oxygen atom, a sulfur atom, a nitrogen atom, and a halogen atom. As a result, a hydroxy group, a cyano group, a carbonyl group, an ether bond, an ester bond, a sulfonic acid ester bond, a carbonate bond, a lactone ring, a sultone ring, carboxylic anhydride, a haloalkyl group, or the like may be formed.

The compound (photo-acid generator) shown by the general formula (P-0) is preferably shown by the following general formula (P-1):

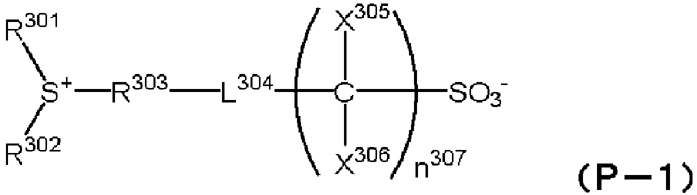

In the general formula (P-1), X³⁰⁵ and X³⁰⁶ each independently represent a hydrogen atom, a fluorine atom, or a trifluoromethyl group, but not all of X³⁰⁵'s and X³⁰⁶'s are hydrogen atoms simultaneously; n³⁰⁷ represents an integer of 1 to 4; and R³⁰¹, R³⁰², R³⁰³, and L³⁰⁴ are as defined above.

The photo-acid generator shown by the general formula (P-0) is more preferably shown by the following general formula (P-1-1).

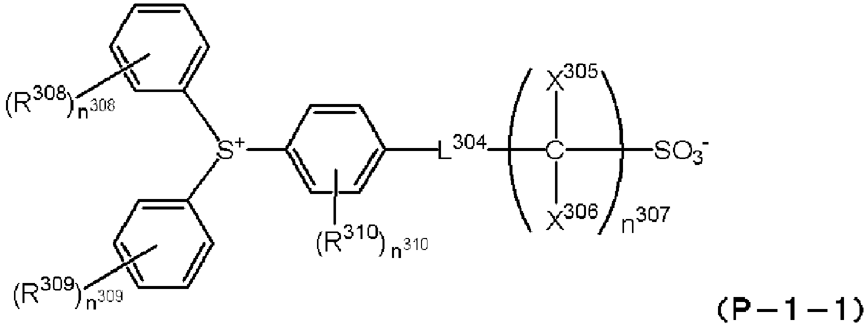

In the general formula (P-1-1), R³⁰⁸, R³⁰⁹, and R³¹⁰ each independently represent a hydrogen atom or a linear, branched, or cyclic monovalent hydrocarbon group having 1 to 20 carbon atoms optionally containing an intervening heteroatom. Specific examples of the monovalent hydrocarbon group include a methyl group, an ethyl group, a propyl group, an isopropyl group, an n-butyl group, a sec-butyl group, a tert-butyl group, a tert-amyl group, an n-pentyl group, an n-hexyl group, an n-octyl group, an n-nonyl group, an n-decyl group, a cyclopentyl group, a cyclohexyl group, a 2-ethylhexyl group, a cyclopentylmethyl group, a cyclopentylethyl group, a cyclopentylbutyl group, a cyclohexylmethyl group, a cyclohexylethyl group, a cyclohexylbutyl group, a norbornyl group, an oxanorbornyl group, a tricyclo[5.2.1.0^{2,6}]decanyl group, an adamantyl group, and the like. Additionally, some of the hydrogen atoms of these groups may be substituted with a heteroatom such as an oxygen atom, a sulfur atom, a nitrogen atom, and a halogen atom. The monovalent hydrocarbon group may contain a heteroatom such as an oxygen atom, a sulfur atom, and a nitrogen atom. As a result, a hydroxy group, a cyano group, a carbonyl group, an ether bond, an ester bond, a sulfonic acid ester bond, a carbonate bond, a lactone ring, a sultone ring, carboxylic anhydride, a haloalkyl group, or the like may be formed or contained. The monovalent hydrocarbon group is preferably a methyl group, a methoxy group, a tert-butyl group, or a tert-butoxy group.

In the general formula (P-1-1), n³⁰⁸ and n³⁰⁹ each represent an integer of 0 to 5, preferably 0 or 1. n³¹⁰ represents an integer of 0 to 4, preferably 0 or 2. L³⁰⁴, X³⁰⁵, X³⁰⁶, and n³⁰⁷ are as defined above.

The compound (photo-acid generator) shown by the general formula (P-0) is further preferably shown by the following general formula (P-1-2).

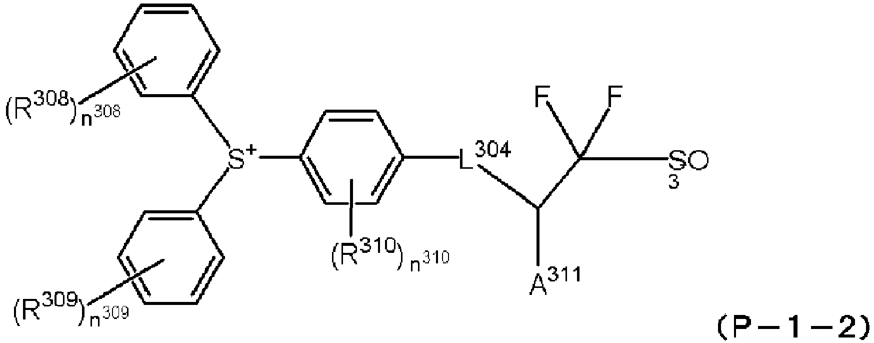

In the general formula (P-1-2), A³¹¹ represents a hydrogen atom or a trifluoromethyl group. R³⁰⁸, R³⁰⁹, R³¹⁰, n³⁰⁸, n³⁰⁹, n³¹⁰, and L³⁰⁴ are as defined above.

More specific examples of the photo-acid generators shown by the general formulae (P-0), (P-1), (P-1-1), and (P-1-2) include ones with structures shown below. Nevertheless, the photo-acid generator is not limited thereto.

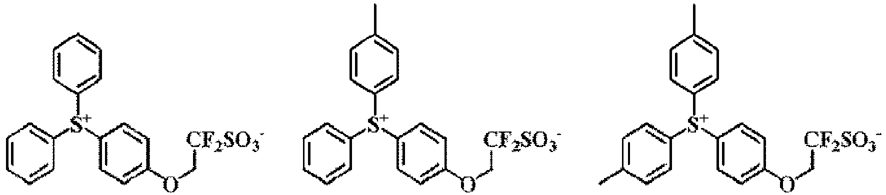

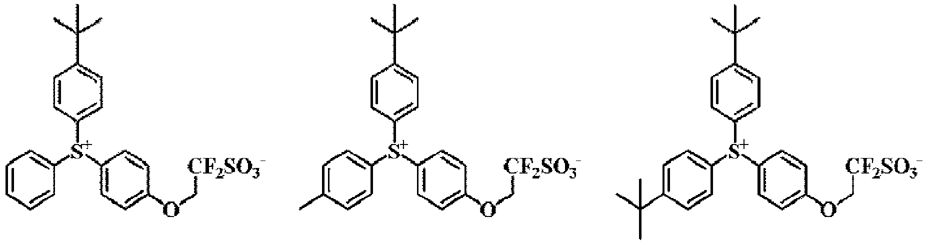

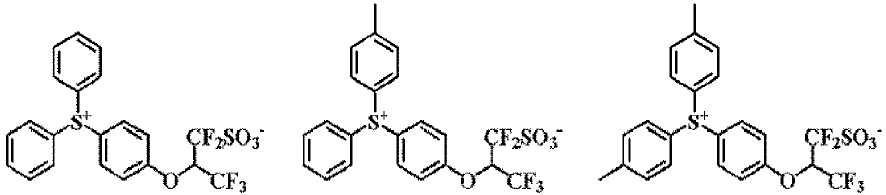

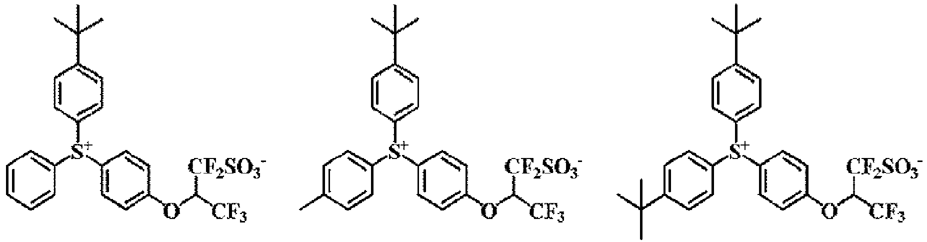

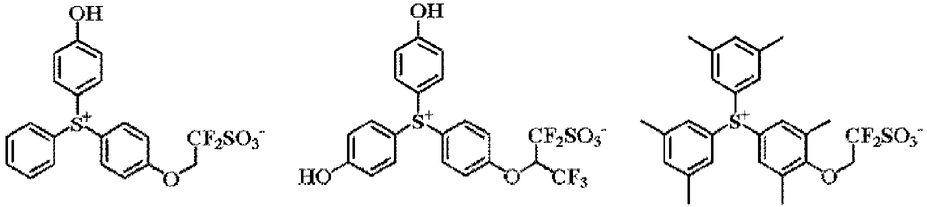

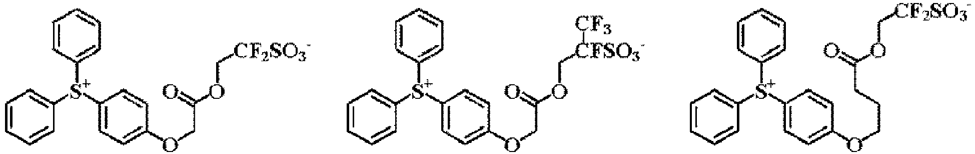

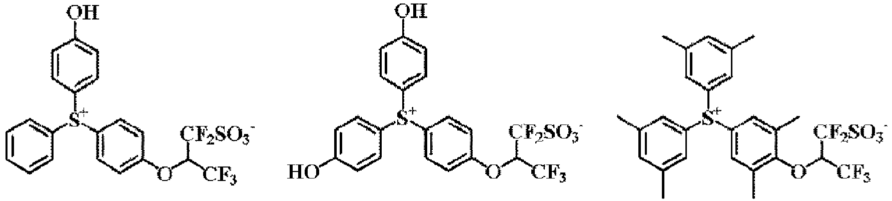

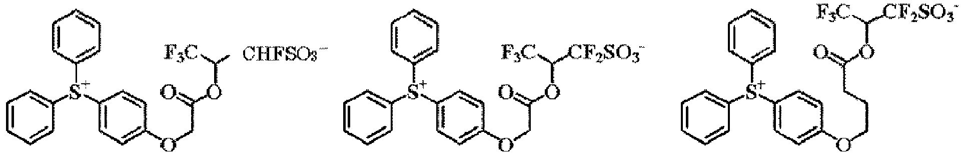

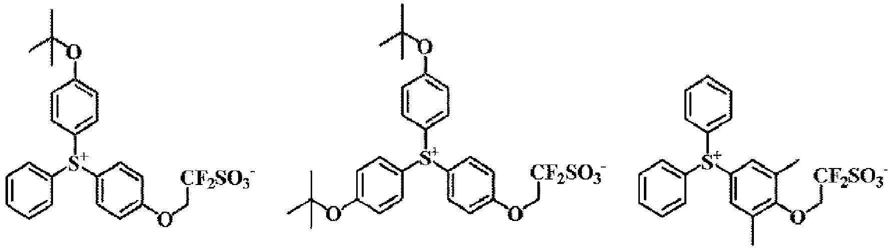

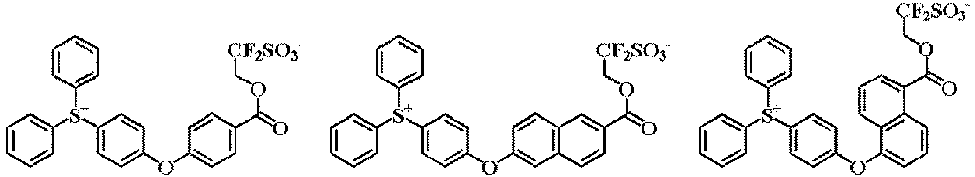

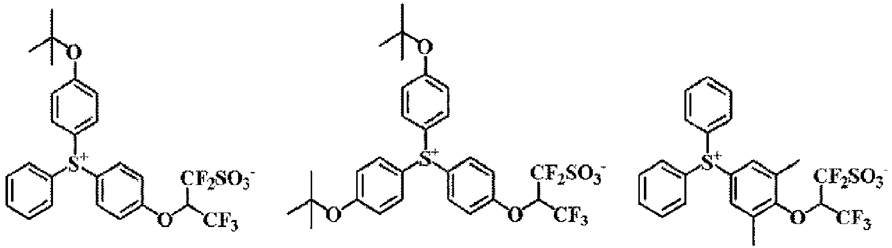

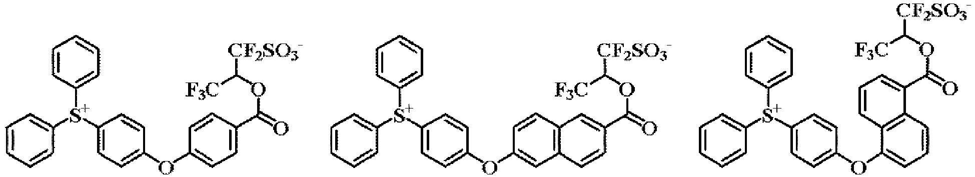

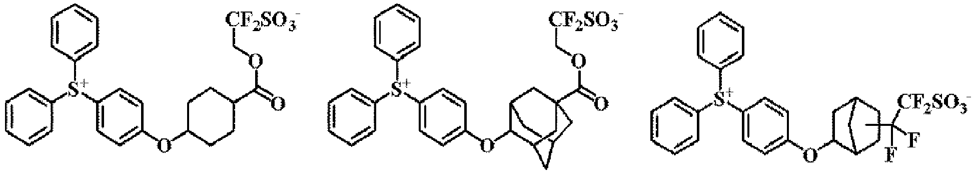

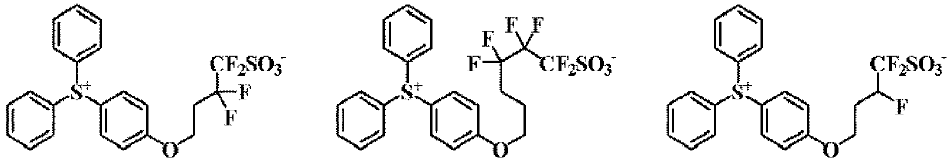

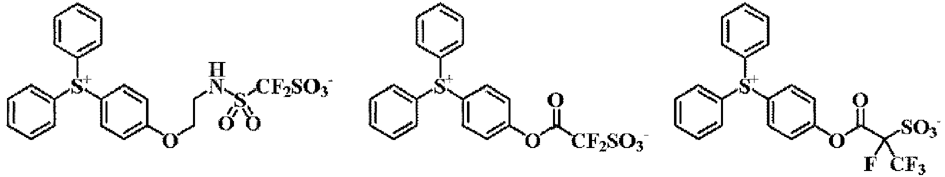

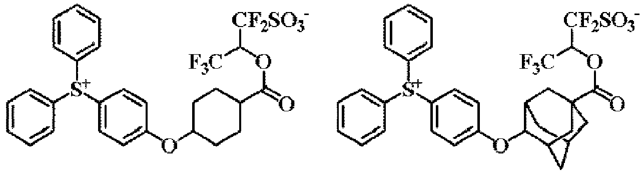

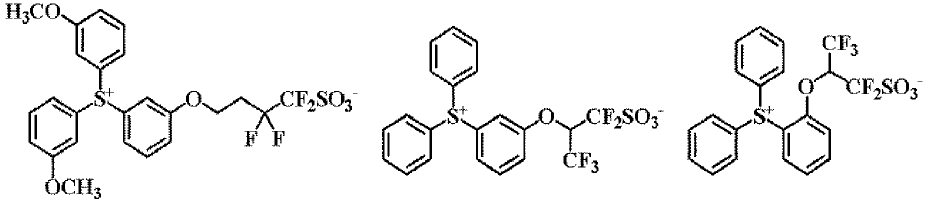

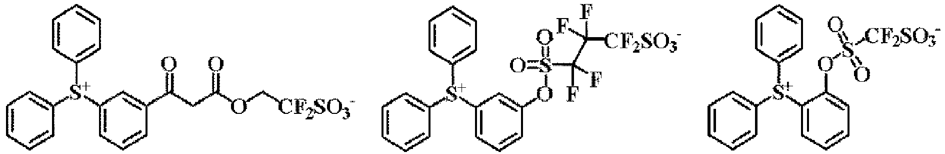

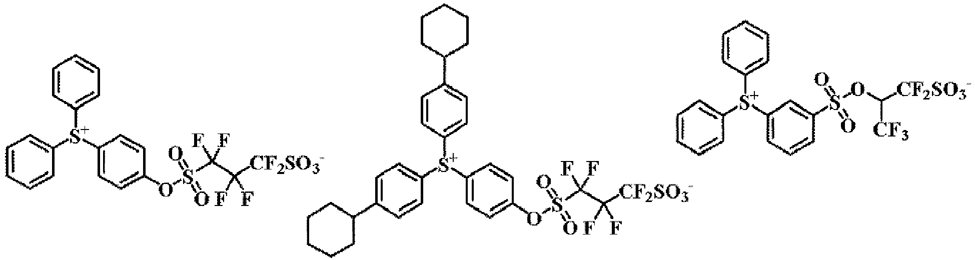

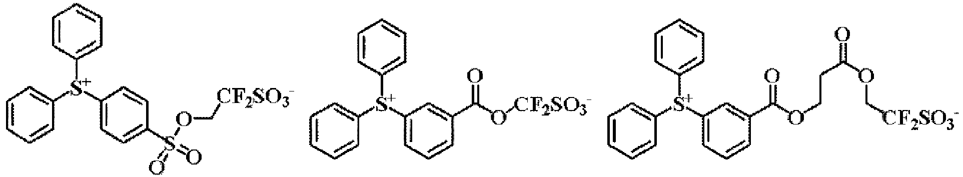

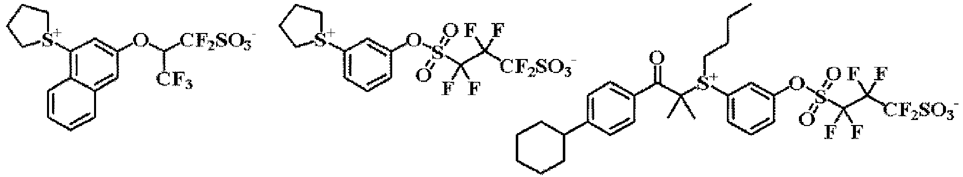

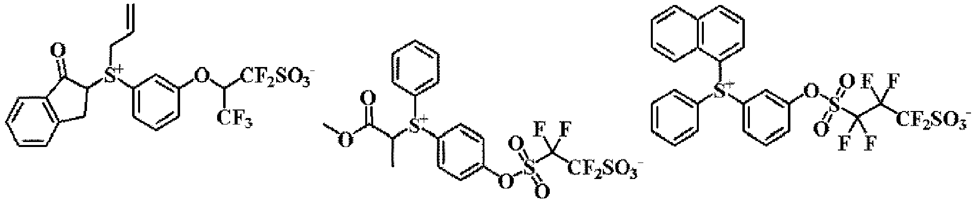

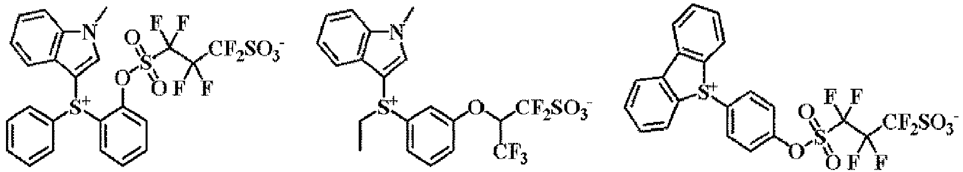

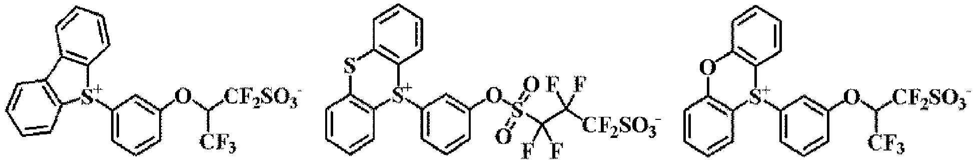

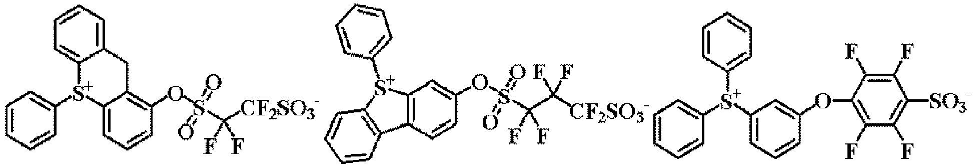

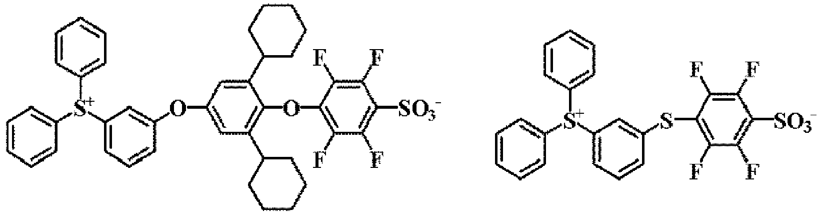

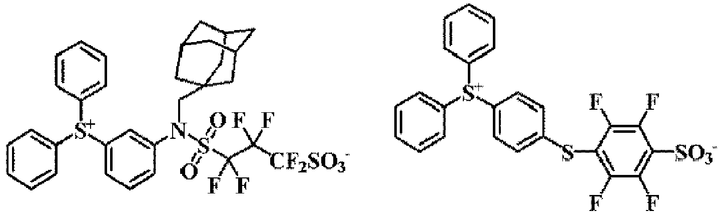

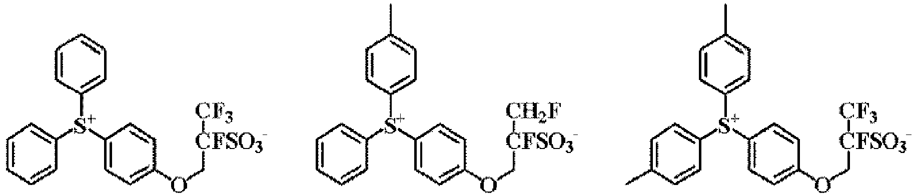

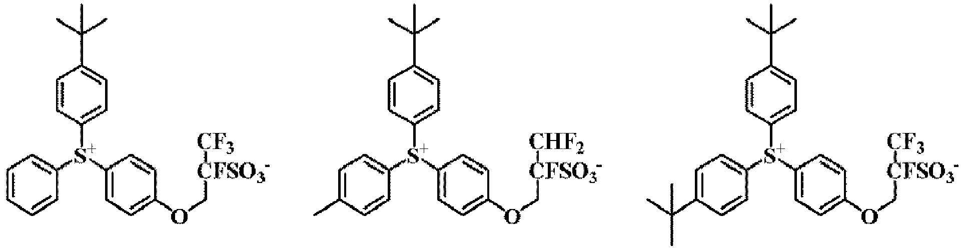

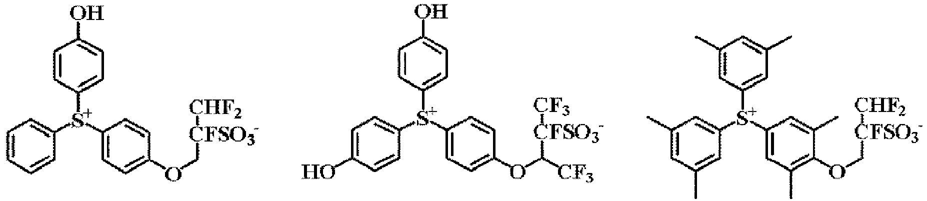

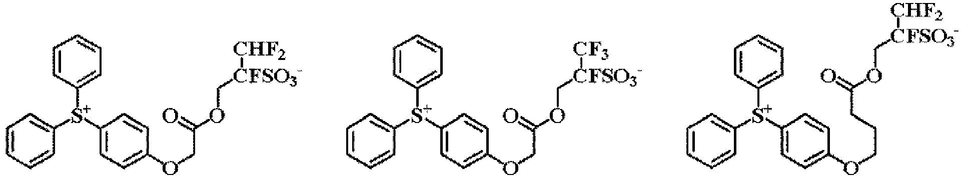

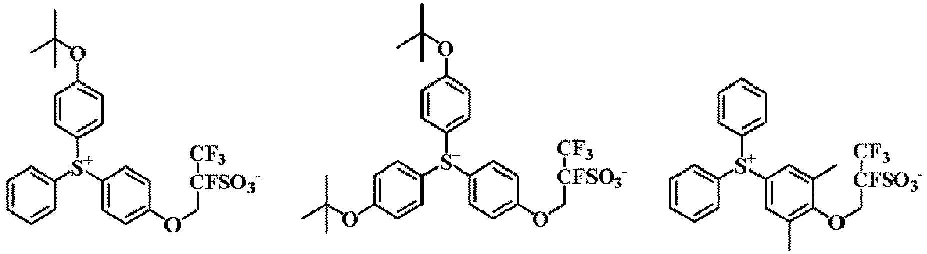

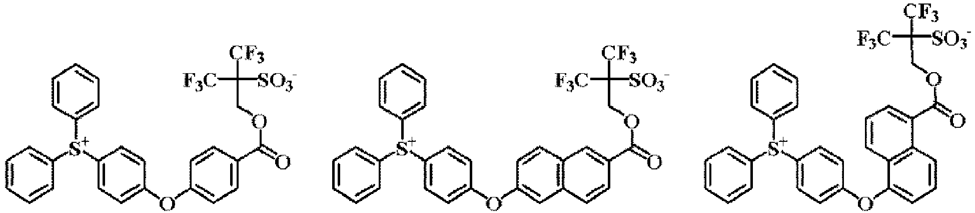

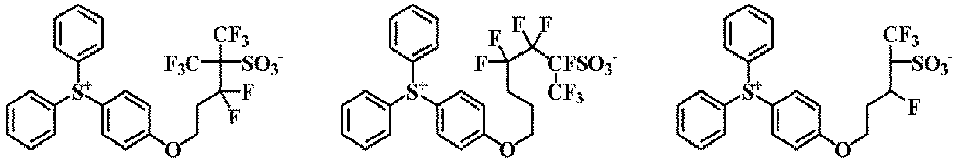

The compound shown by the general formula (P-0) can be added in an amount of 0.001 to 40 parts by mass, preferably 0.1 to 40 parts by mass, further preferably 0.1 to 20 parts by mass, based on 100 parts by mass of the thermally crosslinkable polysiloxane. By adding photo-acid generators as described above, the residue of an exposed part of an upper layer resist is reduced, so that a pattern with small LWR can be formed.

### (Stabilizer)

Further, in the present invention, a stabilizer can be contained in the composition. As the stabilizer, a monohydric, dihydric, or polyhydric alcohol having a cyclic ether substituent can be contained. Particularly, adding stabilizers shown in paragraphs (0181) and (0182) of JP 2009-126940 A enables stability improvement of the composition for forming a silicon-containing resist underlayer film. The amount of the stabilizer to be contained is preferably 0.001 to 50 parts by mass, more preferably 0.01 to 40 parts by mass based on 100 parts by mass of the thermally crosslinkable polysiloxane.

### (Surfactant)

Furthermore, in the present invention, a surfactant can be blended into the composition as necessary. Specifically, the materials described in paragraph (0185) of JP 2009-126940 A can be contained as the surfactant. The amount of the surfactant to be contained is preferably 0 to 10 parts by mass, particularly preferably 0 to 5 parts by mass based on 100 parts by mass of the thermally crosslinkable polysiloxane.

### [Patterning Process]

The present invention provides patterning processes using the above-described composition for forming a silicon-containing resist underlayer film. Embodiments of the patterning processes are given below.
(I) A patterning process including the steps of:
   forming a resist underlayer film on a body to be processed or on a film formed on a body to be processed by using the inventive composition for forming a silicon-containing resist underlayer film;
   forming a resist upper layer film on the resist underlayer film by using a composition for a resist upper layer film, containing a compound having a polymerizable functional group; and
   forming a circuit pattern in the resist upper layer film, wherein
   the resist underlayer film is formed by heat-curing the composition for forming a silicon-containing resist underlayer film and
   the circuit pattern is formed and a crosslink between the resist underlayer film and the resist upper layer film is also formed by irradiation with a high-energy beam.
(II) A patterning process including the steps of:
   forming an organic film on a body to be processed by using a coating-type organic film material;
   forming a resist underlayer film on the organic film by using the inventive composition for forming a silicon-containing resist underlayer film;
   forming a resist upper layer film on the resist underlayer film by using a composition for a resist upper layer film, containing a photoresist composition;
   forming a circuit pattern in the resist upper layer film;
   transferring the pattern to the resist underlayer film by etching while using the resist upper layer film having the formed circuit pattern as a mask;
   transferring the pattern to the organic film by etching while using the resist underlayer film having the transferred pattern as a mask; and
   transferring the pattern to the body to be processed by etching while using the organic film having the transferred pattern as a mask.
(III) A patterning process including the steps of:
   forming an organic hard mask mainly containing carbon on a body to be processed by a CVD method;
   forming a resist underlayer film on the organic hard mask by using the inventive composition for forming a silicon-containing resist underlayer film;
   forming a resist upper layer film on the resist underlayer film by using a composition for a resist upper layer film, containing a photoresist composition;
   forming a circuit pattern in the resist upper layer film;
   transferring the pattern to the resist underlayer film by etching while using the resist upper layer film having the formed circuit pattern as a mask;
   transferring the pattern to the organic hard mask by dry etching while using the resist underlayer film having the transferred pattern as a mask; and
   transferring the pattern to the body to be processed by dry etching while using the organic hard mask having the transferred pattern as a mask.
(IV) A patterning process including the steps of:
   forming an organic film on a body to be processed by using a coating-type organic film material;
   forming an inorganic hard mask middle layer film on the organic film by a CVD method or an ALD method;
   forming a resist underlayer film on the inorganic middle layer film by using the inventive composition for forming a silicon-containing resist underlayer film;
   forming a resist upper layer film on the resist underlayer film by using a composition for a resist upper layer film, containing a photoresist composition;
   forming a circuit pattern in the resist upper layer film;
   transferring the pattern to the resist underlayer film by etching while using the resist upper layer film having the formed circuit pattern as a mask;
   transferring the pattern to the inorganic middle layer film by etching while using the resist underlayer film having the formed circuit pattern as a mask;
   transferring the pattern to the organic film by etching while using the inorganic middle layer film having the transferred pattern as a mask; and
   transferring the pattern to the body to be processed by etching while using the organic film having the transferred pattern as a mask.
(V) A patterning process including the steps of:
   forming an organic hard mask mainly containing carbon on a body to be processed by a CVD method;
   forming an inorganic hard mask middle layer film on the organic hard mask by a CVD method or an ALD method;
   forming a resist underlayer film on the inorganic middle layer film by using the inventive composition for forming a silicon-containing resist underlayer film;
   forming a resist upper layer film on the resist underlayer film by using a composition for a resist upper layer film, containing a photoresist composition;
   forming a circuit pattern in the resist upper layer film;
   transferring the pattern to the resist underlayer film by etching while using the resist upper layer film having the formed circuit pattern as a mask;
   transferring the pattern to the inorganic middle layer film by etching while using the resist underlayer film having the formed circuit pattern as a mask;
   transferring the pattern to the organic hard mask mainly containing carbon by etching while using the inorganic middle layer film having the transferred pattern as a mask; and
   transferring the pattern to the body to be processed by etching while using the organic hard mask having the transferred pattern as a mask.

The organic hard mask and the inorganic hard mask middle layer film (inorganic middle layer film) are not particularly limited, and can be formed by a known technique.

Hereinafter, negative patterning processes will be described with examples, but positive patterning processes can be performed similarly by taking appropriate measures.

### (Negative Patterning Process 1)

The present invention can provide a patterning process including:
forming an organic underlayer film on a body to be processed by using a coating-type organic underlayer film material;
forming a silicon-containing resist underlayer film on the organic underlayer film by using the inventive composition for forming a silicon-containing resist underlayer film;
forming a photoresist film on the silicon-containing resist underlayer film by using a resist composition;
subjecting the photoresist film to exposure with an EUV beam after a heat treatment and dissolving an unexposed portion of the photoresist film by using an alkaline developer to form a negative pattern;
transferring the pattern to the silicon-containing resist underlayer film by dry etching while using the photoresist film having the formed pattern as a mask;
transferring the pattern to the organic underlayer film by dry etching while using the silicon-containing resist underlayer film having the transferred pattern as a mask; and
further transferring the pattern to the body to be processed by dry etching while using the organic underlayer film having the transferred pattern as a mask (a so-called "multilayer resist method"). The resist composition may also be a chemically amplified resist composition.

### (Negative Patterning Process 2)

The present invention can also provide a patterning process including:
forming an organic hard mask mainly containing carbon on a body to be processed by a CVD method;
forming a silicon-containing resist underlayer film on the organic hard mask by using the inventive composition for forming a silicon-containing resist underlayer film;
forming a photoresist film on the silicon-containing resist underlayer film by using a resist composition;
subjecting the photoresist film to exposure with an EUV beam after a heat treatment and dissolving an unexposed portion of the photoresist film by using an alkaline developer to form a negative pattern;
transferring the pattern to the silicon-containing resist underlayer film by dry etching while using the photoresist film having the formed pattern as a mask;
transferring the pattern to the organic hard mask by dry etching while using the silicon-containing resist underlayer film having the transferred pattern as a mask; and
further transferring the pattern to the body to be processed by dry etching while using the organic hard mask having the transferred pattern as a mask (a so-called "multilayer resist method"). The resist composition may also be a chemically amplified resist composition.

When a pattern is formed using the inventive composition for forming a silicon-containing resist underlayer film, a pattern formed with a photoresist can be formed on a substrate without causing a difference in size conversion by optimizing the combination with a CVD film or an organic underlayer film as described above.

In a negative patterning process, a photoresist film is formed, a heat treatment is performed, then exposure is performed, and alkaline development is performed using an alkaline developer. Thus, a negative resist pattern is obtained. In addition, post exposure baking (PEB) is preferably performed after the exposure.

In addition, by exposing the photoresist film, the silicon-containing resist underlayer film and the resist upper layer film, containing a compound having a polymerizable functional group, are crosslinked by the polymerizable functional groups of one another. The photoresist film and the silicon-containing resist underlayer film can adhere to each other firmly by this reaction, and pattern collapse can be suppressed.

As the alkaline developer, tetramethylammonium hydroxide (TMAH) or the like can be used.

### [Inventive Patterning Process According to Three-Layer Resist Method]

A positive patterning process of the present invention according to a three-layer resist method is as follows (see FIG. 1). In this process, first, an organic underlayer film 2 is formed on a body to be processed 1 by spin-coating (FIG. 1 (I-A)). This organic underlayer film 2 functions as a mask when the body to be processed 1 is etched, and therefore, desirably has high etching resistance, and is required not to mix with an upper layer silicon-containing resist underlayer film. Accordingly, it is desirable for the organic underlayer film 2 to be crosslinked by heat or an acid after being formed by spin-coating.

A silicon-containing resist underlayer film 3 is formed on the organic underlayer film 2 by spin-coating by using the inventive composition for forming a silicon-containing resist underlayer film (FIG. 1 (I-B)), and then a photoresist film 4 is formed by spin-coating (FIG. 1 (I-C)).

The photoresist film 4 is subjected to a usual pattern exposure using a light source P appropriate for the photoresist film 4 to form a pattern. The light source includes, for example, KrF excimer laser beam, ArF excimer laser beam, F₂ laser beam, and EUV beam. A pattern can be formed preferably by any of a photolithography with a wavelength of 10 nm or more and 300 nm or less, direct drawing with electron beam, and nanoimprinting, or a combination thereof (a mask 5 is used as necessary). An EUV beam is the most desirable in the present invention (FIG. 1 (I-D)). Thereafter, heat treatment is performed under a condition matching with the photoresist film (FIG. 1 (I-E)). After that, development with an alkaline developer and then, if necessary, rinsing are performed, so that a negative-type resist pattern 4a can be obtained (FIG. 1 (I-F)).

Next, using this resist pattern 4a as an etching mask, dry etching is performed, for example, with fluorine-based gas plasma, under a dry etching condition where the etching speed of the silicon-containing resist underlayer film 3 is significantly high relative to the photoresist film 4. As a result, a negative-type silicon-containing resist underlayer film pattern 3a can be obtained with little influence from pattern change due to the side etching of the resist film (FIG. 1 (I-G)).

Next, the organic underlayer film 2 is dry-etched under a dry etching condition where the etching speed of the organic underlayer film 2 is significantly high relative to the substrate having the negative-type silicon-containing resist underlayer film pattern 3a obtained by transferring the negative-type resist pattern. The dry etching may be, for example, reactive dry etching with gas plasma containing oxygen, or reactive dry etching with gas plasma containing hydrogen and nitrogen. By this etching, a negative-type organic underlayer film pattern 2a is obtained, and the uppermost photoresist film is usually lost at the same time (FIG. 1 (I-H)). Then, using the negative-type organic underlayer film pattern 2a thus obtained as an etching mask, the body to be processed 1 is dry-etched, for example, by employing fluorine-based dry etching or chlorine-based dry etching. In this way, the body to be processed can be etched precisely, thereby transferring a negative-type pattern 1a to the body to be processed 1 (FIG. 1 (I-I)).

Furthermore, in the above-described process according to the three-layer resist method, an organic hard mask formed by a CVD method is also applicable in place of the organic underlayer film 2. In this case also, the body to be processed 1 can be processed by the same procedure as described above.

When, for example, ultraviolet ray, far-ultraviolet ray, EUV, X-ray, soft X-ray, excimer laser beam, γ-ray, synchrotron radiation, etc. is used as the high-energy beam used for the exposure, the irradiation is performed directly or using a mask for forming the target pattern preferably in such a manner that the exposure dose is about 1 to 200 mJ/cm², more preferably about 10 to 100 mJ/cm². When an EB is used as the high-energy beam, the drawing can be performed directly or using a mask for forming the target pattern preferably in such a manner that the exposure dose is about 0.1 to 500 µC/cm², more preferably about 0.5 to 400 µC/cm².

### EXAMPLES

Hereinafter, the present invention will be specifically described with reference to Synthesis Examples, Examples, and Comparative Examples. However, the present invention is not limited by the Examples. Note that, in the following examples, "%" means "mass%", and the weight-average molecular weight (Mw) is indicated in terms of polystyrene and obtained by GPC using RI (differential refractometer) as a detector and tetrahydrofuran as an eluent.

In addition, in the following Examples, it was confirmed that the prepared compositions for forming a silicon-containing resist underlayer film had non-condensation reactive organic groups and that the organic groups remained unreacted even after a heat-curing reaction of a polysiloxane resin by measuring the organic groups by infrared spectroscopy.

### [Synthesis Example 1]

To a mixture containing 0.5 g of 7% nitric acid and 76 g of deionized water, a mixture containing 32.0 g of Monomer 102 and 22.4 g of Monomer 110 was added and hydrolysis condensation was performed for 24 hours at room temperature. After completion of the reaction, 450 g of propylene glycol ethyl ether (PGEE) was added thereto. The water used in the hydrolysis condensation and by-produced alcohol were distilled off under reduced pressure to obtain 350 g of the PGEE solution of the polymerizable group-containing polysiloxane compound 1 (compound concentration 10%). The molecular weight thereof was measured in terms of polystyrene and was Mw=2,500.

[Synthesis Example 2] to [Synthesis Example 18] were carried out under the same conditions as in Synthesis Example 1 by using the monomers shown in Table 1 to obtain the target products.

**[Table 1]**

| Synthesis Example | Reaction Raw Material | Mw |
|---|---|---|
| 1 | Monomer 102: 32.0 g, Monomer 110: 22.4 g | 2500 |
| 2 | Monomer 102: 22.8 g, Monomer 110: 37.3 g | 2400 |
| 3 | Monomer 102: 13.7 g, Monomer 110: 52.2 g | 2500 |
| 4 | Monomer 102: 32.0 g, Monomer 111: 21.1 g | 2100 |
| 5 | Monomer 102: 22.8 g, Monomer 111: 35.1 g | 2700 |
| 6 | Monomer 102: 13.7 g, Monomer 111: 49.2 g | 2500 |
| 7 | Monomer 110: 74.5 g | 2300 |
| 8 | Monomer 111: 70.3 g | 2400 |
| 9 | Monomer 101: 11.4 g, Monomer 102: 30.6 g, Monomer 110: 3.7 g | 2500 |
| 10 | Monomer 101: 9.4 g, Monomer 102: 30.6 g, Monomer 110: 7.5 g | 2600 |
| 11 | Monomer 101: 11.4 g, Monomer 102: 30.6 g, Monomer 111: 3.5 g | 2500 |
| 12 | Monomer 101: 9.4 g, Monomer 102: 30.6 g, Monomer 111: 7.0 g | 2500 |
| 13 | Monomer 101: 11.4 g, Monomer 102: 30.6 g, Monomer 112: 4.2 g | 2800 |
| 14 | Monomer 101: 9.4 g, Monomer 102: 30.6 g, Monomer 113: 7.1 g | 2700 |
| 15 | Monomer 101: 9.4 g, Monomer 102: 30.6 g, Monomer 114: 7.1 g | 2700 |
| 16 | Monomer 101: 9.4 g, Monomer 102: 30.6 g, Monomer 115: 7.4 g | 2800 |
| 17 | Monomer 100: 29.7 g, Monomer 110: 37.3 g | 2500 |
| 18 | Monomer 100: 29.7 g, Monomer 111: 35.1 g | 2300 |

Monomer 100: PhSi(OCH₃)₃
Monomer 101: CH₃Si(OCH₃)₃
Monomer 102: Si(OCH₃)₄
Monomer 103: Si(OC₂H₅)₄

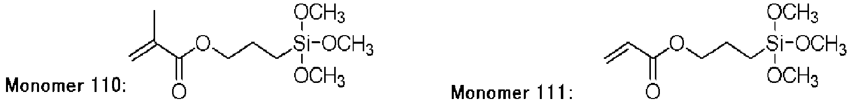

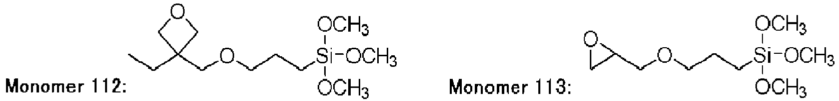

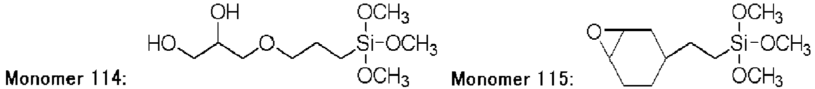

### [Examples and Comparative Examples]

Polysiloxane Compounds 1 to 18 obtained in the Synthesis Examples 1 to 18, a crosslinking catalyst, an acid, a solvent, and water were mixed at proportions shown in Table 2. Each mixture was filtered through a 0.1-pm filter made of fluorinated resin. Thus, composition solutions for forming a polysiloxane underlayer film were prepared and referred to as Sol. 1 to 19.

The Polysiloxane Compounds 1 to 6 obtained in Synthesis Examples 1 to 6 are the condensation reaction-type thermosetting silicon-containing material (Sx) in the present invention.

On the other hand, the Polysiloxane Compounds 7, 8, 17, and 18 do not have the repeating unit represented by the general formula (Sx-4) or the repeating unit represented by the general formula (Sx-5). In particular, Polysiloxane Compounds 17 and 18 contain a repeating unit (T unit) containing a phenyl group. Polysiloxane Compounds 9 to 16 contain in the resin more than 70 mol% of one or more of the repeating unit represented by the general formula (Sx-4) and the repeating unit represented by the general formula (Sx-5). In particular, Polysiloxane Compounds 13 to 16 contains, instead of polymerizable double bonds, a repeating unit (T unit) having a cyclic ether group or a diol group, which are condensation reactive groups. That is, the Polysiloxane Compounds 7 to 18 are not the above-described condensation reaction-type thermosetting silicon-containing material.

**[Table 2]**

| No. | Polysiloxane (parts by mass) | Crosslinking catalyst (parts by mass) | Acid (parts by mass) | Solvent (parts by mass) | Water (parts by mass) |
|---|---|---|---|---|---|
| Sol. 1 | Compound 1 (1) | QBANO₃ (0.03) | Maleic acid (0.01) | PGEE (100) | Water (10) |
| Sol. 2 | Compound 2 (1) | QBANO₃ (0.03) | Maleic acid (0.01) | PGEE (100) | Water (10) |
| Sol.3 | Compound 3 (1) | QBANO₃ (0.03) | Maleic acid (0.01) | PGEE (100) | Water (10) |
| Sol.4 | Compound 4 (1) | QBANO₃ (0.03) | Maleic acid (0.01) | PGEE (100) | Water (10) |
| Sol.5 | Compound 5 (1) | QBANO₃ (0.03) | Maleic acid (0.01) | PGEE (100) | Water (10) |
| Sol.6 | Compound 5 (1) | TPSNO₃ (0.03) | Maleic acid (0.01) | PGEE (100) | Water (10) |
| Sol. 7 | Compound 6 (1) | QBANO₃ (0.03) | Maleic acid (0.01) | PGEE (100) | Water (10) |
| Sol. 8 | Compound 7 (1) | QBANO₃ (0.03) | Maleic acid (0.01) | PGEE (100) | Water (10) |
| Sol. 9 | Compound 8 (1) | QBANO₃ (0.03) | Maleic acid (0.01) | PGEE (100) | Water (10) |
| Sol.10 | Compound 9 (1) | QBANO₃ (0.03) | Maleic acid (0.01) | PGEE (100) | Water (10) |
| Sol.11 | Compound 10 (1) | QBANO₃ (0.03) | Maleic acid (0.01) | PGEE (100) | Water (10) |
| Sol.12 | Compound 11 (1) | QBANO₃ (0.03) | Maleic acid (0.01) | PGEE (100) | Water (10) |
| Sol.13 | Compound 12 (1) | QBANO₃ (0.03) | Maleic acid (0.01) | PGEE (100) | Water (10) |
| Sol.14 | Compound 13 (1) | QBANO₃ (0.03) | Maleic acid (0.01) | PGEE (100) | Water (10) |
| Sol.15 | Compound 14 (1) | TPSNO₃ (0.03) | Maleic acid (0.01) | PGEE (100) | Water (10) |
| Sol.16 | Compound 15 (1) | TPSNO₃ (0.03) | Maleic acid (0.01) | PGEE (100) | Water (10) |
| Sol.17 | Compound 16 (1) | TPSNO₃ (0.03) | Maleic acid (0.01) | PGEE (100) | Water (10) |
| Sol.18 | Compound 17 (1) | QBANO₃ (0.03) | Maleic acid (0.01) | PGEE (100) | Water (10) |
| Sol.19 | Compound 18 (1) | QBANO₃ (0.03) | Maleic acid (0.01) | PGEE (100) | Water (10) |

TPSNO₃ : triphenylsulfonium nitrate
QBANO₃ : tetrabutylammonium nitrate
PGEE : propylene glycol monoethyl ether

### Patterning Test

An organic underlayer film was formed on a silicon wafer by using a coating-type organic underlayer film material to obtain a Si substrate. Next, each of the compositions Sol. 1 to 19 for forming a silicon-containing resist underlayer film was respectively applied onto the Si substrate by spin-coating and heated at 220°C for 60 seconds to prepare 25-nm thick silicon-containing resist underlayer films: Films 1 to 19.

### EB Lithography Evaluation

Subsequently, each of Sol. 1 to 19 was applied by spin-coating on a Si substrate on which an antireflective coating DUV-42, manufactured by Nissan Chemical Corporation, was formed with a film thickness of 60 nm. Furthermore, a resist composition shown in Table 3 was applied to the Films 1 to 19 by spin-coating and pre-baked at 110°C for 60 seconds by using a hot plate to produce resist films having a film thickness of 35 nm. Each of the resist films was exposed using an EB drawing apparatus (ELS-F125, acceleration voltage: 125 kV) manufactured by ELIONIX INC., PEB was performed on a hot plate at 60°C for 60 seconds, and development was performed for 30 seconds by using a 2.38 mass% aqueous TMAH solution. Thus, a line-and-space pattern having a space width of 20 nm and a pitch of 40 nm was obtained.

Using a length-measurement SEM (CG-5000), manufactured by Hitachi High-Tech Corporation, an exposure dose at which the lines were formed with a size of 40 nm was measured and determined as sensitivity. In addition, using a length-measurement SEM (CG-5000), manufactured by Hitachi High-Tech Corporation, sizes at 10 positions in the longitudinal direction of the space width were measured. From the results, a tripled value (3σ) of a standard variation (σ) was determined as LWR. Furthermore, the minimum line width (nm) of the LS pattern at which the lines are separated with the optimum exposure dose Eop was obtained as the limiting resolution. Table 4 shows the results.

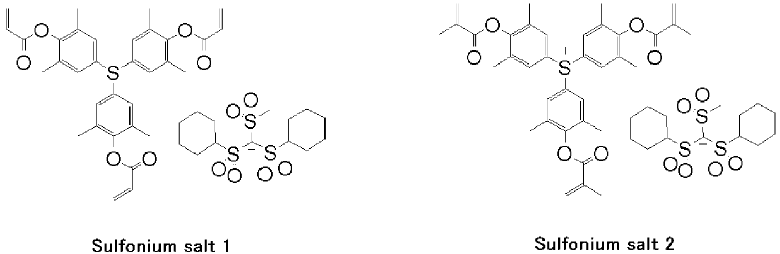

**[Table 3]**

| No. | Sulfonium salt (parts by mass) | Organic solvent |
|---|---|---|
| Resist 1 | Sulfonium salt 1 (100) | PGMEA (3500) |
| | | DAA (1500) |
| Resist 2 | Sulfonium salt 2 (100) | PGMEA (3500) |
| | | DAA (1500) |

| | | |
|---|---|---|
| · Organic solvents: PGMEA (propylene glycol monomethyl ether acetate) DAA (diacetone alcohol) | | |

**[Table 4]**

| Example | Polysiloxane resist underlayer film | Resist material | Sensitivity (□C/cm²) | LWR (nm) | Limiting resolution (nm) |
|---|---|---|---|---|---|
| Example 1 | Film 1 | Resist 1 | 100 | 4.0 | 17 |
| Example 2 | Film 2 | Resist 1 | 190 | 4.4 | 18 |
| Example 3 | Film 3 | Resist 1 | 120 | 4.1 | 17 |
| Example 4 | Film 4 | Resist 1 | 170 | 4.2 | 18 |
| Example 5 | Film 5 | Resist 1 | 150 | 4.0 | 18 |
| Example 6 | Film 6 | Resist 1 | 180 | 4.3 | 18 |
| Example 7 | Film 7 | Resist 1 | 110 | 3.9 | 17 |
| Example 8 | Film 1 | Resist 2 | 140 | 3.9 | 17 |
| Example 9 | Film 2 | Resist 2 | 110 | 4.0 | 17 |
| Example 10 | Film 3 | Resist 2 | 110 | 4.1 | 17 |
| Example 11 | Film 4 | Resist 2 | 180 | 4.3 | 18 |
| Example 12 | Film 5 | Resist 2 | 170 | 4.2 | 18 |
| Example 13 | Film 6 | Resist 2 | 170 | 4.2 | 18 |
| Example 14 | Film 7 | Resist 2 | 170 | 4.1 | 18 |
| Comparative Example 1 | Film 8 | Resist 1 | 140 | 4.5 | 20 |
| Comparative Example 2 | Film 9 | Resist 1 | 140 | 4.3 | 20 |
| Comparative Example 3 | Film 10 | Resist 1 | 200 | 5.0 | 19 |
| Comparative Example 4 | Film 11 | Resist 1 | 170 | 5.2 | 20 |
| Comparative Example 5 | Film 12 | Resist 1 | 130 | 4.8 | 21 |
| Comparative Example 6 | Film 13 | Resist 1 | 180 | 5.0 | 22 |
| Comparative Example 7 | Film 14 | Resist 1 | 200 | 4. 6 | 20 |
| Comparative Example 8 | Film 15 | Resist 1 | 130 | 4.8 | 21 |
| Comparative Example 9 | Film 16 | Resist 1 | 200 | 4.6 | 21 |
| Comparative Example 10 | Film 17 | Resist 1 | 170 | 5.2 | 20 |
| Comparative Example 11 | Film 18 | Resist 1 | 200 | 5.4 | 21 |
| Comparative Example 12 | Film 19 | Resist 1 | 170 | 5.2 | 21 |

### EUV Lithography Evaluation

Each of the Sol. 1 to 19 was applied by spin-coating on a Si substrate and heated at 220°C for 60 seconds to form 25-nm thick silicon-containing resist underlayer films: Films 1 to 19. A resist material dissolved at the proportion in Table 3 was applied onto the Films 1 to 19 by spin-coating and pre-baked at 110°C for 60 seconds by using a hot plate to produce a resist film having a film thickness of 35 nm. This resist film was exposed by using an EUV scanner NXE3300 (NA 0.33, σ 0.9/0.6, 90° dipole illumination), manufactured by ASML Holding N.V., to form a 22-nm LS 1:1 pattern. After that, PEB was performed on a hot plate at 60°C for 60 seconds and development was performed with a 2.38 mass% aqueous TMAH solution for 30 seconds. Thus, a line-and-space pattern having a space width of 14 nm and a pitch of 28 nm was obtained.

The LS pattern was observed with a length-measurement SEM (CG-5000), manufactured by Hitachi High-Tech Corporation, and the optimum exposure dose Eop (mJ/cm²) at which an LS pattern can be obtained with a space width of 22 nm and a pitch of 44 nm was obtained and determined as sensitivity. In addition, using a length-measurement SEM (CG-5000) manufactured by Hitachi High-Tech Corporation, sizes of the LS pattern obtained by irradiation at the optimum exposure dose Eop were measured at 10 positions in the longitudinal direction of the space width. From the results, a tripled value (3σ) of a standard variation (σ) was determined as LWR. Furthermore, the minimum line width (nm) of the LS pattern at which the lines were separated with the optimum exposure dose Eop was obtained as the limiting resolution. Table 5 shows the results.

**[Table 5]**

| Example | Polysiloxane resist underlayer film | Resist material | Sensitivity (mJ/cm²) | LWR (nm) | Limiting resolution (nm) |
|---|---|---|---|---|---|
| Example 15 | Film 1 | Resist 1 | 120 | 3.7 | 12 |
| Example 16 | Film 2 | Resist 1 | 180 | 3.8 | 13 |
| Example 17 | Film 3 | Resist 1 | 130 | 3.6 | 12 |
| Example 18 | Film 4 | Resist 1 | 180 | 3.9 | 13 |
| Example 19 | Film 5 | Resist 1 | 160 | 3.8 | 13 |
| Example 20 | Film 6 | Resist 1 | 150 | 3.7 | 13 |
| Example 21 | Film 7 | Resist 1 | 130 | 3.6 | 13 |
| Example 22 | Film 1 | Resist 2 | 130 | 3.6 | 12 |
| Example 23 | Film 2 | Resist 2 | 110 | 3.5 | 12 |
| Example 24 | Film 3 | Resist 2 | 130 | 3.6 | 12 |
| Example 25 | Film 4 | Resist 2 | 200 | 3.9 | 13 |
| Example 26 | Film 5 | Resist 2 | 150 | 3.8 | 13 |
| Example 27 | Film 6 | Resist 2 | 170 | 4.0 | 12 |
| Example 28 | Film 7 | Resist 2 | 160 | 3.8 | 13 |
| Comparative Example 13 | Film 8 | Resist 1 | 110 | 4.2 | 15 |
| Comparative Example 14 | Film 9 | Resist 1 | 120 | 4.3 | 15 |
| Comparative Example 15 | Film 10 | Resist 1 | 170 | 4.7 | 17 |
| Comparative Example 16 | Film 11 | Resist 1 | 170 | 4.7 | 15 |
| Comparative Example 17 | Film 12 | Resist 1 | 110 | 4.5 | 15 |
| Comparative Example 18 | Film 13 | Resist 1 | 170 | 4.8 | 16 |
| Comparative Example 19 | Film 14 | Resist 1 | 130 | 4.6 | 15 |
| Comparative Example 20 | Film 15 | Resist 1 | 130 | 4.5 | 16 |
| Comparative Example 21 | Film 16 | Resist 1 | 110 | 4.6 | 17 |
| Comparative Example 22 | Film 17 | Resist 1 | 160 | 4.5 | 15 |
| Comparative Example 23 | Film 18 | Resist 1 | 190 | 4.8 | 16 |
| Comparative Example 24 | Film 19 | Resist 1 | 180 | 4.4 | 17 |

From the results shown in Tables 4 and 5, it can be observed that pattern collapse can be suppressed when a polysiloxane film in which crosslinkable organic groups remain, formed using a composition for forming a silicon-containing resist underlayer film containing the thermosetting silicon-containing material of the present invention, is used as a resist underlayer film (Examples 1 to 14 and 15 to 28). It can be seen from this fact that the above-described resist underlayer film can contribute to the prevention of pattern collapse.

On the other hand, poor results were obtained regarding the minimum line width when a polysiloxane film that contained crosslinkable organic groups but was formed using a composition for forming a silicon-containing resist underlayer film containing a thermosetting silicon-containing material in which the proportion of the repeating units was not in the range of the present invention was used as a resist underlayer film (Comparative Examples 1 to 6 and 13 to 18). Meanwhile, the LWR was of the same level as in the Examples but the minimum line width was poor when a resist underlayer film that contained non-radical polymerizable organic groups and was formed using a composition for forming a resist underlayer film containing no radically crosslinkable organic groups was used (Comparative Examples 7 to 10 and 19 to 22). Meanwhile, when a polysiloxane film formed using a composition for forming a silicon-containing resist underlayer film containing a thermosetting silicon-containing material containing aryl substituents like the Monomer 100 was used as a resist underlayer film, lithography performance was degraded and the minimum line width was poor, possibly due to the degradation of thermosetting property (Comparative Examples 11, 12, 23, and 24) .

As described above, it was revealed that the present invention had better LWR and limiting resolution than conventional compositions for forming a resist underlayer film excellent in adhesiveness in EUV lithography as well as EB lithography in negative pattern formation by development with an alkaline solvent.

The present description includes the following embodiments.
[1]: A composition for forming a silicon-containing resist underlayer film, comprising a condensation reaction-type thermosetting silicon-containing material (Sx), being a polysiloxane resin, wherein the material (Sx) has a non-condensation reactive organic group that reacts with a radical chemical species generated by irradiation with a high-energy beam, the resin includes more than 0 and 70 mol% or less of one or more of a repeating unit represented by the following general formula (Sx-4) and a repeating unit represented by the following general formula (Sx-5), and the organic group remains unreacted after a heat-curing reaction of the polysiloxane resin, 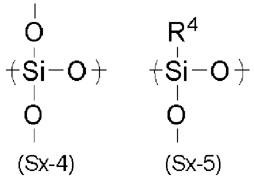 wherein R⁴ represents a hydrogen atom, a hydroxy group, or a nonaromatic substituent having 1 to 30 carbon atoms and optionally containing a monovalent heteroelement.
[2]: The composition for forming a silicon-containing resist underlayer film of the above [1], wherein the polysiloxane resin of the material (Sx) contains one or more moieties of a repeating unit represented by the following general formula (Sx-1), a repeating unit represented by the following general formula (Sx-2), and a partial structure represented by the following general formula (Sx-3), the resin contains 30 to 99 mol% of the moiety, the resin contains 1 to 70 mol% of one or more of the repeating unit represented by the general formula (Sx-4) and the repeating unit represented by the general formula (Sx-5), and the composition further comprises a crosslinking catalyst (Xc) for siloxane polymerization, an alcohol-based organic solvent, and water, 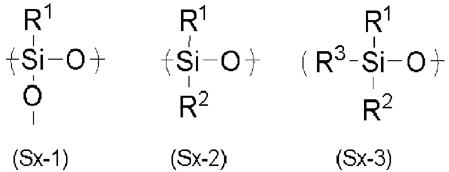 wherein R¹ represents a non-condensation reactive organic group having one or more polymerizable double bonds or a non-condensation reactive organic group that reacts with a radical chemical species generated by irradiation with a high-energy beam; R² and R³ are each independently identical to R¹ or each independently represent a hydrogen atom, a hydroxy group, or a nonaromatic substituent having 1 to 30 carbon atoms and optionally containing a monovalent heteroelement; and R⁴ is as defined above.
[3]: The composition for forming a silicon-containing resist underlayer film of the above [2], wherein the organic groups R¹, R², and R³ are each an organic group represented by the following general formula R⁵ or R⁶, 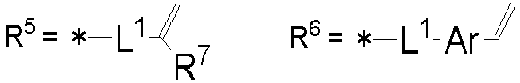 wherein L¹ represents a divalent organic group having 1 to 15 carbon atoms and optionally containing an oxygen atom; Ar represents an aromatic ring having 6 to 14 carbon atoms; "*" represents a linking point to a silicon atom; R⁷ represents a hydrogen atom or a monovalent organic group having 1 to 5 carbon atoms; and R¹, R², and R³ are identical to or different from each other.
[4]: The composition for forming a silicon-containing resist underlayer film of the above [3], wherein the organic group R⁵ is an organic group represented by the following general formula R⁸ and the organic group R⁶ is an organic group represented by the following general formula R⁹, 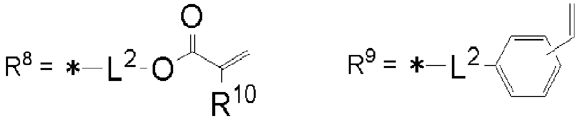 wherein L² represents a divalent organic group having 1 to 10 carbon atoms and optionally containing an oxygen atom; R¹⁰ represents a hydrogen atom or a monovalent organic group having 1 to 5 carbon atoms; and "*" represents a linking point to a silicon atom.
[5]: The composition for forming a silicon-containing resist underlayer film of any one of the above [2] to [4], wherein the crosslinking catalyst for siloxane polymerization is a sulfonium salt, an iodonium salt, a phosphonium salt, an ammonium salt, a polysiloxane having one of these salts as a part of a structure, or an alkaline metal salt.
[6]: The composition for forming a silicon-containing resist underlayer film of any one of the above [1] to [5], wherein the composition for forming a silicon-containing resist underlayer film is to be used in a patterning process including the steps of:
   forming a resist underlayer film by using the composition for forming a silicon-containing resist underlayer film; and
   forming a resist upper layer film on the resist underlayer film by using a composition for a resist upper layer film containing a compound having a polymerizable functional group.
[7]: A patterning process comprising the steps of:
   forming a resist underlayer film on a body to be processed or on a film formed on a body to be processed by using the composition for forming a silicon-containing resist underlayer film of any one of the above [1] to [6];
   forming a resist upper layer film on the resist underlayer film by using a composition for a resist upper layer film, containing a compound having a polymerizable functional group; and
   forming a circuit pattern in the resist upper layer film, wherein
   the resist underlayer film is formed by heat-curing the composition for forming a silicon-containing resist underlayer film and
   the circuit pattern is formed and a crosslink between the resist underlayer film and the resist upper layer film is also formed by irradiation with a high-energy beam.
[8]: A patterning process comprising the steps of:
   forming an organic film on a body to be processed by using a coating-type organic film material;
   forming a resist underlayer film on the organic film by using the composition for forming a silicon-containing resist underlayer film of any one of the above [1] to [6];
   forming a resist upper layer film on the resist underlayer film by using a composition for a resist upper layer film, containing a photoresist composition;
   forming a circuit pattern in the resist upper layer film;
   transferring the pattern to the resist underlayer film by etching while using the resist upper layer film having the formed circuit pattern as a mask;
   transferring the pattern to the organic film by etching while using the resist underlayer film having the transferred pattern as a mask; and
   transferring the pattern to the body to be processed by etching while using the organic film having the transferred pattern as a mask.
[9]: A patterning process comprising the steps of:
   forming an organic hard mask mainly containing carbon on a body to be processed by a CVD method;
   forming a resist underlayer film on the organic hard mask by using the composition for forming a silicon-containing resist underlayer film of any one of the above [1] to [6];
   forming a resist upper layer film on the resist underlayer film by using a composition for a resist upper layer film, containing a photoresist composition;
   forming a circuit pattern in the resist upper layer film;
   transferring the pattern to the resist underlayer film by etching while using the resist upper layer film having the formed circuit pattern as a mask;
   transferring the pattern to the organic hard mask by dry etching while using the resist underlayer film having the transferred pattern as a mask; and
   transferring the pattern to the body to be processed by dry etching while using the organic hard mask having the transferred pattern as a mask.
[10]: A patterning process comprising the steps of:
   forming an organic film on a body to be processed by using a coating-type organic film material;
   forming an inorganic hard mask middle layer film on the organic film by a CVD method or an ALD method;
   forming a resist underlayer film on the inorganic middle layer film by using the composition for forming a silicon-containing resist underlayer film of any one of the above [1] to [6];
   forming a resist upper layer film on the resist underlayer film by using a composition for a resist upper layer film, containing a photoresist composition;
   forming a circuit pattern in the resist upper layer film;
   transferring the pattern to the resist underlayer film by etching while using the resist upper layer film having the formed circuit pattern as a mask;
   transferring the pattern to the inorganic middle layer film by etching while using the resist underlayer film having the formed circuit pattern as a mask;
   transferring the pattern to the organic film by etching while using the inorganic middle layer film having the transferred pattern as a mask; and
   transferring the pattern to the body to be processed by etching while using the organic film having the transferred pattern as a mask.
[11]: A patterning process comprising the steps of:
   forming an organic hard mask mainly containing carbon on a body to be processed by a CVD method;
   forming an inorganic hard mask middle layer film on the organic hard mask by a CVD method or an ALD method;
   forming a resist underlayer film on the inorganic middle layer film by using the composition for forming a silicon-containing resist underlayer film of any one of the above [1] to [6];
   forming a resist upper layer film on the resist underlayer film by using a composition for a resist upper layer film, containing a photoresist composition;
   forming a circuit pattern in the resist upper layer film;
   transferring the pattern to the resist underlayer film by etching while using the resist upper layer film having the formed circuit pattern as a mask;
   transferring the pattern to the inorganic middle layer film by etching while using the resist underlayer film having the formed circuit pattern as a mask;
   transferring the pattern to the organic hard mask mainly containing carbon by etching while using the inorganic middle layer film having the transferred pattern as a mask; and
   transferring the pattern to the body to be processed by etching while using the organic hard mask having the transferred pattern as a mask.
[12]: The patterning process of any one of the above [7] to [11], wherein the pattern in the resist upper layer film is formed by a photolithography with a wavelength of 10 nm or more and 300 nm or less, a direct drawing by electron beam, a nanoimprinting, or a combination thereof.
[13]: The patterning process of any one of the above [7] to [12], wherein the body to be processed is a semiconductor device substrate, a metal film, a metal carbide film, a metal oxide film, a metal nitride film, a metal oxycarbide film, or a metal oxynitride film.
[14]: The patterning process of any one of the above [7] to [13], wherein the metal of the body to be processed is silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming a silicon-containing resist underlayer film, comprising a condensation reaction-type thermosetting silicon-containing material (Sx), being a polysiloxane resin, wherein the material (Sx) has a non-condensation reactive organic group that reacts with a radical chemical species generated by irradiation with a high-energy beam, the resin includes more than 0 and 70 mol% or less of one or more of a repeating unit represented by the following general formula (Sx-4) and a repeating unit represented by the following general formula (Sx-5), and the organic group remains unreacted after a heat-curing reaction of the polysiloxane resin, 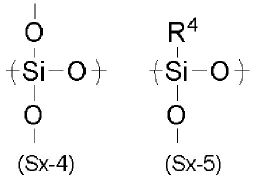 wherein R⁴ represents a hydrogen atom, a hydroxy group, or a nonaromatic substituent having 1 to 30 carbon atoms and optionally containing a monovalent heteroelement.

2. The composition for forming a silicon-containing resist underlayer film according to claim 1, wherein the polysiloxane resin of the material (Sx) contains one or more moieties of a repeating unit represented by the following general formula (Sx-1), a repeating unit represented by the following general formula (Sx-2), and a partial structure represented by the following general formula (Sx-3), the resin contains 30 to 99 mol% of the moiety, the resin contains 1 to 70 mol% of one or more of the repeating unit represented by the general formula (Sx-4) and the repeating unit represented by the general formula (Sx-5), and the composition further comprises a crosslinking catalyst (Xc) for siloxane polymerization, an alcohol-based organic solvent, and water, 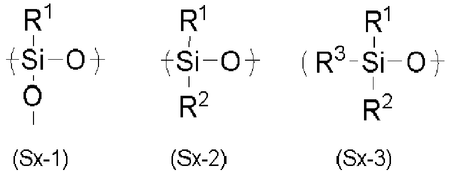 wherein R¹ represents a non-condensation reactive organic group having one or more polymerizable double bonds or a non-condensation reactive organic group that reacts with a radical chemical species generated by irradiation with a high-energy beam; R² and R³ are each independently identical to R¹ or each independently represent a hydrogen atom, a hydroxy group, or a nonaromatic substituent having 1 to 30 carbon atoms and optionally containing a monovalent heteroelement; and R⁴ is as defined above.

3. The composition for forming a silicon-containing resist underlayer film according to claim 2, wherein the organic groups R¹, R², and R³ are each an organic group represented by the following general formula R⁵ or R⁶, 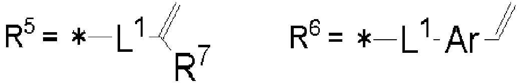 wherein L¹ represents a divalent organic group having 1 to 15 carbon atoms and optionally containing an oxygen atom; Ar represents an aromatic ring having 6 to 14 carbon atoms; "*" represents a linking point to a silicon atom; R⁷ represents a hydrogen atom or a monovalent organic group having 1 to 5 carbon atoms; and R¹, R², and R³ are identical to or different from each other.

4. The composition for forming a silicon-containing resist underlayer film according to claim 3, wherein the organic group R⁵ is an organic group represented by the following general formula R⁸ and the organic group R⁶ is an organic group represented by the following general formula R⁹, 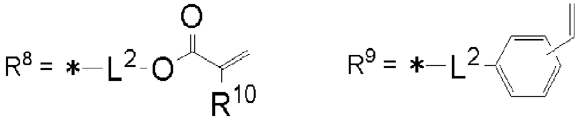 wherein L² represents a divalent organic group having 1 to 10 carbon atoms and optionally containing an oxygen atom; R¹⁰ represents a hydrogen atom or a monovalent organic group having 1 to 5 carbon atoms; and "*" represents a linking point to a silicon atom.

5. The composition for forming a silicon-containing resist underlayer film according to any one of claims 2 to 4, wherein the crosslinking catalyst for siloxane polymerization is a sulfonium salt, an iodonium salt, a phosphonium salt, an ammonium salt, a polysiloxane having one of these salts as a part of a structure, or an alkaline metal salt.

6. The composition for forming a silicon-containing resist underlayer film according to any one of claims 1 to 5, wherein the composition for forming a silicon-containing resist underlayer film is to be used in a patterning process including the steps of:
forming a resist underlayer film by using the composition for forming a silicon-containing resist underlayer film; and
forming a resist upper layer film on the resist underlayer film by using a composition for a resist upper layer film containing a compound having a polymerizable functional group.

7. A patterning process comprising the steps of:
forming a resist underlayer film on a body to be processed or on a film formed on a body to be processed by using the composition for forming a silicon-containing resist underlayer film according to any one of claims 1 to 6;
forming a resist upper layer film on the resist underlayer film by using a composition for a resist upper layer film, containing a compound having a polymerizable functional group; and
forming a circuit pattern in the resist upper layer film, wherein
the resist underlayer film is formed by heat-curing the composition for forming a silicon-containing resist underlayer film and
the circuit pattern is formed and a crosslink between the resist underlayer film and the resist upper layer film is also formed by irradiation with a high-energy beam.

8. A patterning process comprising the steps of:
forming an organic film on a body to be processed by using a coating-type organic film material;
forming a resist underlayer film on the organic film by using the composition for forming a silicon-containing resist underlayer film according to any one of claims 1 to 6;
forming a resist upper layer film on the resist underlayer film by using a composition for a resist upper layer film, containing a photoresist composition;
forming a circuit pattern in the resist upper layer film;
transferring the pattern to the resist underlayer film by etching while using the resist upper layer film having the formed circuit pattern as a mask;
transferring the pattern to the organic film by etching while using the resist underlayer film having the transferred pattern as a mask; and
transferring the pattern to the body to be processed by etching while using the organic film having the transferred pattern as a mask.

9. A patterning process comprising the steps of:
forming an organic hard mask mainly containing carbon on a body to be processed by a CVD method;
forming a resist underlayer film on the organic hard mask by using the composition for forming a silicon-containing resist underlayer film according to any one of claims 1 to 6;
forming a resist upper layer film on the resist underlayer film by using a composition for a resist upper layer film, containing a photoresist composition;
forming a circuit pattern in the resist upper layer film;
transferring the pattern to the resist underlayer film by etching while using the resist upper layer film having the formed circuit pattern as a mask;
transferring the pattern to the organic hard mask by dry etching while using the resist underlayer film having the transferred pattern as a mask; and
transferring the pattern to the body to be processed by dry etching while using the organic hard mask having the transferred pattern as a mask.

10. A patterning process comprising the steps of:
forming an organic film on a body to be processed by using a coating-type organic film material;
forming an inorganic hard mask middle layer film on the organic film by a CVD method or an ALD method;
forming a resist underlayer film on the inorganic middle layer film by using the composition for forming a silicon-containing resist underlayer film according to any one of claims 1 to 6;
forming a resist upper layer film on the resist underlayer film by using a composition for a resist upper layer film, containing a photoresist composition;
forming a circuit pattern in the resist upper layer film;
transferring the pattern to the resist underlayer film by etching while using the resist upper layer film having the formed circuit pattern as a mask;
transferring the pattern to the inorganic middle layer film by etching while using the resist underlayer film having the formed circuit pattern as a mask;
transferring the pattern to the organic film by etching while using the inorganic middle layer film having the transferred pattern as a mask; and
transferring the pattern to the body to be processed by etching while using the organic film having the transferred pattern as a mask.

11. A patterning process comprising the steps of:
forming an organic hard mask mainly containing carbon on a body to be processed by a CVD method;
forming an inorganic hard mask middle layer film on the organic hard mask by a CVD method or an ALD method;
forming a resist underlayer film on the inorganic middle layer film by using the composition for forming a silicon-containing resist underlayer film according to any one of claims 1 to 6;
forming a resist upper layer film on the resist underlayer film by using a composition for a resist upper layer film, containing a photoresist composition;
forming a circuit pattern in the resist upper layer film;
transferring the pattern to the resist underlayer film by etching while using the resist upper layer film having the formed circuit pattern as a mask;
transferring the pattern to the inorganic middle layer film by etching while using the resist underlayer film having the formed circuit pattern as a mask;
transferring the pattern to the organic hard mask mainly containing carbon by etching while using the inorganic middle layer film having the transferred pattern as a mask; and
transferring the pattern to the body to be processed by etching while using the organic hard mask having the transferred pattern as a mask.

12. The patterning process according to any one of claims 7 to 11, wherein the pattern in the resist upper layer film is formed by a photolithography with a wavelength of 10 nm or more and 300 nm or less, a direct drawing by electron beam, a nanoimprinting, or a combination thereof.

13. The patterning process according to any one of claims 7 to 12, wherein the body to be processed is a semiconductor device substrate, a metal film, a metal carbide film, a metal oxide film, a metal nitride film, a metal oxycarbide film, or a metal oxynitride film.

14. The patterning process according to any one of claims 7 to 13, wherein the metal of the body to be processed is silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.
